# EUROPÄISCHE PATENTSCHRIFT

(11) **EP 2 173 757 B1**
(45) Veröffentlichungstag und Bekanntmachung des Hinweises auf die Patenterteilung: **30.04.2014**
(21) Anmeldenummer: 08773837.3
(22) Anmeldetag: 03.07.2008
(51) Int. Cl.: C07F 5/02, C07F 9/6561, C07F 15/00, C09K 11/00, H01L 51/00, H05B 33/00

(54) **LUMINESZIERENDE METALLKOMPLEXE FÜR ORGANISCHE ELEKTRONISCHE VORRICHTUNGEN**
LUMINESCENT METAL COMPLEXES FOR ORGANIC ELECTRONIC DEVICES
COMPLEXES MÉTALLIQUES LUMINESCENTS POUR DISPOSITIFS ÉLECTRONIQUES ORGANIQUES

(30) Priorität: 05.07.2007 DE 102007031261
(43) Veröffentlichungstag der Anmeldung: 14.04.2010
(73) Patentinhaber: Merck Patent GmbH, 64293 Darmstadt (DE)
(72) Erfinder: YERSIN, Hartmut, 93161 Sinzing (DE); CZERWIENIEC, Rafal, 93055 Regensburg (DE); MONKOWIUS, Uwe, A-4020 Linz (AT)
(86) Internationale Anmeldenummer: PCT/EP2008/005426
(87) Internationale Veröffentlichungsnummer: WO 2009/003700

(56) Entgegenhaltungen:
- CRESPO, O. ET AL.: "Luminescent nido-Carborane-Diphosphine Anions" INORGANIC CHEMISTRY, Bd. 42, Nr. 6, 2003, Seiten 2061-2068, XP002501593 in der Anmeldung erwähnt
- CRESPO, O. ET AL.: "Luminescent Dinuclear Gold Derivatives with the bridging Diphosphine" 22TH. INTERNATIONAL CONFERENCE ON ORGANOMETALLIC CHEMISTRY ICOMOC 2006), BOOK OF ABSTRACTS, POSTER PRESENTATIONS, Bd. 2, 23. Juli 2006 (2006-07-23), - 28. Juli 2006 (2006-07-28) Seite P668, XP002501594 Zaragoza, Spain
- DOU, J. ET AL.: "Synthesis and Structure of 3 Carborane Complexes" EUR. J. INORG. CHEM, Nr. 1, Januar 2007 (2007-01), Seiten 53-59, XP002501595 in der Anmeldung erwähnt
- CHEUNG, MAK-SHUEN ET AL: "Highly Electrophilic Half-Sandwich Group 4 Metallacarborane Alkyls. C-H/C-O Activation and Alkyne Insertion Reactions at Neutral Metal Complexes" ORGANOMETALLICS , 24(22), 5217-5220 CODEN: ORGND7; ISSN: 0276-7333, 2005, XP002501596
- TEIXIDOR F ET AL: "The formation of nido [7,8-(PR2)2-7,8-C2B9H10]<-> from closo 1,2-(PR2)2-1,2-C2B10H10 (R = Ph, Et, <i>Pr or OEt): a process enhanced by complexation" JOURNAL OF ORGANOMETALLIC CHEMISTRY, ELSEVIER-SEQUOIA S.A. LAUSANNE, CH, Bd. 509, Nr. 2, 8. März 1996 (1996-03-08), Seiten 139-150, XP004036185 ISSN: 0022-328X in der Anmeldung erwähnt
- VINAS C ET AL: "Reactions of Pd(II) with closo-1,2-dicarbadodecaborane-1,2-diphosph ines" JOURNAL OF ORGANOMETALLIC CHEMISTRY, ELSEVIER-SEQUOIA S.A. LAUSANNE, CH, Bd. 555, Nr. 1, 25. März 1998 (1998-03-25), Seiten 17-23, XP004128611 ISSN: 0022-328X in der Anmeldung erwähnt

## Beschreibung

Die vorliegende Erfindung betrifft die Verwendung von Metallkomplexen mit sperrigen Carboran-haltigen Hilfsliganden in organischen elektronischen Vorrichtungen, insbesondere in lichtemittierenden Vorrichtungen, Metallkomplexe enthaltend diese Liganden und organische elektronische Vorrichtungen, insbesondere organische lichtemittierende Dioden (OLED), umfassend Metallkomplexe, welche den Carboran-haltigen Hilfsliganden aufweisen.

Zurzeit zeichnet sich ein drastischer Wandel im Bereich der Bildschirm- und Beleuchtungstechnik ab. Es ist möglich, flache Displays oder Leuchtflächen mit einer Dicke von unter 0.5 mm zu fertigen. Diese sind durch viele faszinierende Eigenschaften gekennzeichnet. So werden z. B. Leuchtflächen als Tapeten mit sehr geringem Energieverbrauch realisierbar sein. Besonders interessant ist aber, dass Farbbildschirme mit bisher nicht erreichbarer Farbechtheit, Helligkeit und Blickwinkelunabhängigkeit, mit geringem Gewicht sowie sehr niedrigem Stromverbrauch herstellbar sind. Die Bildschirme lassen sich als Mikro-Displays oder Großbildschirme mit mehreren m² Fläche in starrer Form oder flexibel, aber auch als Transmissions- oder Reflexions-Displays gestalten. Ferner ist es möglich, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der OLEDs, den Organic Light Emitting Diodes (organischen Elektrolumineszenzvorrichtungen).

OLEDs bestehen vorwiegend aus organischen Schichten, die auch flexibel und kostengünstig zu fertigen sind. OLED-Bauelemente lassen sich großflächig als Beleuchtungskörper, aber auch klein als Pixels für Displays gestalten. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials", Wiley-VCH, Weinheim, Germany, 2008.

Seit den ersten Berichten über OLEDs (z. B. Tang et al., Appl. Phys. Lett. 51 (1987) 913) sind diese Vorrichtungen insbesondere im Hinblick auf die eingesetzten Emittermaterialien weiterentwickelt worden, wobei insbesondere so genannte Triplett- oder auch andere phosphoreszierende Emitter von Interesse sind.

Entscheidend für den Bau hocheffektiver OLEDs sind die verwendeten Leuchtmaterialien (Emitter-Moleküle). Diese können in verschiedener Weise realisiert werden, und zwar unter Verwendung rein organischer Moleküle oder metallorganischer Komplexverbindungen. Es lässt sich zeigen, dass die Lichtausbeute der OLEDs mit metallorganischen Substanzen, den so genannten Triplett-Emittern, wesentlich größer sein kann als für rein organische Materialien. Aufgrund dieser Eigenschaft kommt der Weiterentwicklung der metallorganischen Materialien ein wesentlicher Stellenwert zu.

Unter Einsatz metallorganischer Komplexe mit hoher Emissionsquantenausbeute (Emission aus den untersten Triplett-Zuständen zu den Singulett-Grundzuständen) lässt sich eine besonders hohe Effizienz des Devices erzielen. Diese Materialien werden häufig als Triplett-Emitter oder phosphoreszierende Emitter bezeichnet.

Gegenüber herkömmlichen Technologien, wie etwa Flüssigkristall-Displays (LCDs), Plasma-Displays oder Kathodenstrahlenröhren (CRTs), weisen OLEDs zahlreiche Vorteile auf, wie zum Beispiel eine geringe Betriebsspannung, eine dünne Struktur, hocheffizient selbstleuchtende Pixel, einen hohen Kontrast und eine gute Auflösung sowie die Möglichkeit, alle Farben darzustellen. Weiterhin emittiert eine OLED Licht beim Anlegen elektrischer Spannung, anstelle es nur zu modulieren. Während der OLED bereits zahlreiche Anwendungen erschlossen sind und auch neue Anwendungsgebiete eröffnet wurden, besteht immer noch ein Bedarf an verbesserten OLEDs und insbesondere an verbesserten Triplett-Emitter-materialien. Bei den bisherigen Emittern treten insbesondere Probleme bei der Langzeitstabilität, der thermischen Stabilität sowie der chemischen Stabilität gegenüber Wasser und Sauerstoff auf. Weiterhin zeigen viele Emitter nur eine geringe Sublimationsfähigkeit. Außerdem sind mit bisher bekannten Emittermaterialien oftmals wichtige Emissionsfarben nicht verfügbar. Oftmals sind auch hohe Effizienzen bei hohen Stromdichten oder hohe Leuchtdichten nicht erreichbar. Schließlich bestehen bei vielen Emittermaterialien Probleme hinsichtlich der fertigungstechnischen Reproduzierbarkeit. Ein weiterhin oft beobachtetes Problem ist das Entstehen von unerwünschten Aggregaten.

Viele Emitterkomplexe enthalten neben der chromophoren Einheit auch noch Hilfsliganden (*auxiliary, ancillary, spectator ligands*). Unter einem Hilfsliganden im Sinne dieser Anmeldung wird ein Ligand verstanden, der selbst nicht direkt an den elektronischen Übergängen beteiligt ist, diese aber in vielfältiger Weise moduliert. Zum Teil haben die Hilfsliganden einen großen Einfluss auf die energetische Lage der an den Übergängen beteiligten Zustände, insbesondere derjenigen, an denen die Metallzentren beteiligt sind. Ihr Einfluss lässt sich häufig gut mit ihren Ligandeneigenschaften, insbesondere ihres Verhältnisses zwischen σ-Donor und π-Akzeptorfähigkeit, aber auch mit sterischen Überlegungen, korrelieren. Systematische Untersuchungen an [Ir(ppy)₂L₂]-Komplexen (ppy = 2-Phenylpyridin, L = Hilfsliganden) bestätigen diese Trends (J. Li, P. I. Djurovich, B. D. Alleyne, M. Yousufuddin, N. N. Ho, J. C. Thomas, J. C. Peters, R. Bau, M. E. Thompson, Inorg. Chem. 2005, 44, 1713; J. Li, P. I. Djurovich, B. D. Alleyne, I. Tsyba, N. N. Ho, R. Bau, M. E. Thompson, Polyhedron 2004, 23, 419).

Beispiele für bisher verwendete Hilfsliganden sind Acetylacetonat **1** und dessen Stickstoffhomologe **2,** Pyrazolylborat **3,** Picolinat **4** und Bis(phosphinomethylen)borate **5,** sowie Verbindungen, die sich ganz allgemein vom Pyrrol ableiten **6.** Letztere sind aber in vielen Emitter-komplexen am niedrigsten elektronischen Übergang beteiligt.

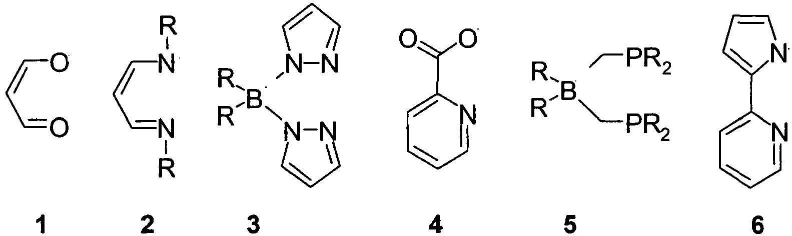

Eine Aufgabe der vorliegenden Erfindung war es daher, neue Emitter-materialien, insbesondere für OLEDs sowie neue lichtemittierende Vorrichtungen bereitzustellen, welche die Nachteile des Standes der Technik zumindest teilweise überwinden und bei welchen insbesondere die Bildung von unerwünschten Aggregaten vermindert ist. Diese Aufgabe wird erfindungsgemäß gelöst durch die Verwendung von Metallkomplexen, welche mindestens einen Carboran-haltigen Liganden aufweisen.

Bisher wurden zahlreiche nicht lumineszierende Übergangsmetall-komplexe mit *nido*-Carboran-Diphosphan-Liganden synthetisiert. Diese Komplexe beinhalteten folgende Zentralionen: Pd²⁺, Ni²⁺, Pt²⁺, Ag⁺, Ru²⁺, Cu⁺, Ru²⁺ und Rh⁺ (F. Teixidor, C. Viñas, M. M. Abad, F. Teixidor, R. Sillanpää, J. Organomet. Chem., 1996, 509, 139, C. Viñas, M. M. Abad, F. Teixidor, R. Sillanpää, R. Kivekäs, J. Organomet. Chem., 1998, 555, 17, D. Zhang, J. Dou, D. Li, D. Wang, Inorg. Chim. Acta, 2006, 359, 4243, O. Crespo, M. C. Gimeno, P. G. Jones, A. Laguna, J. Chem. Soc., Dalton Trans., 1996, 4583) und Nicht-Chromophor-Liganden, z. B. Cl, Triphenylphosphan, Isonitrile, usw. Außerdem wurden auch photolumineszierende Au-Cluster (M. J. Calhorda, O. Crespo, M. C. Gimeno, P. G. Jones, A. Laguna, J.-M. López-de-Luzuriaga, J. L. Perez, M. A. Ramón, L. F. Veiros, Inorg. Chem., 2000, 39, 4280) und Au(I) Komplexe (O. Crespo, M. C. Gimeno, P. G. Jones, A. Laguna, Inorg. Chem., 1996, 35, 1361, O. Crespo, M. C. Gimeno, P. G. Jones, A. Laguna, J.-M. López-de-Luzuriaga, M. Monge, J. L. Perez, M. A. Ramón, Inorg. Chem., 2003, 42, 2061) mit *nido-*Carboran-Diphosphan Liganden synthetisiert. In dem letzten Fall, d.h. für Komplexe von dem Typ Au(I)(*nido*-Carboran-Diphosphan)(PPh₃) wurde aber in dem zitierten Artikel festgestellt, dass die nido-Carboran-Diphosphan-Liganden an den niedrigsten elektronischen Übergängen beteiligt sind (Lumineszenz aus einem intraligand angeregten Zustand). Folglich handelt es sich in diesem Fall um keine Hilfsliganden, sondern die *nido*-Carboran-Diphosphane wirken hier als Chromophor-Liganden. Einen Chromophor-Liganden zusätzlich zu den nido-Carboran-Diphosphan-Liganden enthalten die bei Crespo diskutierten Au-Komplexe nicht. Weiterhin sind die bei Crespo diskutierten Au-Komplexe chemisch nicht sehr stabil, da Au(I) üblicherweise nur zwei Koordinationen aufweist, in diesen Komplexen aber dreifach koordiniert ist. Die von Crespo diskutierten Ag-Komplexe wurden mit Hilfe eines Perkin-Elmer Spektrometers bezüglich deren lumineszierenden Eigenschaften analysiert. Die Eignung der Komplexe zur Verwendung in organischen Elektrolumineszenzvorrichtungen ist nicht offenbart. Von Cu²⁺, Ni²⁺ und Zn²⁺ Komplexen mit dem Liganden 1 c (R = Ph), aber ohne Chromophor-Liganden, wurde kürzlich berichtet (J. Dou, D. Zhang, D. Li, D. Wang, Eur. J. Inorg. Chem., 2007, 53.). Organische elektrolumineszierende Vorrichtungen, die diese Metallkomplexe enthalten, sind nicht bekannt.

Gegenstand der Erfindung ist daher eine organische elektronische Vorrichtung,
enthaltend Anode, Kathode und mindestens eine Schicht, welche mindestens eine organische Verbindung enthält, ausgewählt aus organischen Elektrolumineszenzvorrichtungen (= organischen Leuchtdioden, OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs), organischen Laserdioden (O-Laser) oder OLED-Sensoren (nicht hermetisch nach außen abgeschirmte Gas- und Dampf-Sensoren)
enthaltend mindestens einen Metallkomplex, dadurch gekennzeichnet, dass der Metallkomplex mindestens einen Liganden der Formel (I) umfasst,

**Formel (I):** **[7,8-(ER₂)₂-7,8-C₂B₉(R¹)₁₀]**

worin gilt:
- E: ist gleich oder verschieden bei jedem Auftreten P, As, Sb, N oder eine Gruppe P=O, P=S, As=O oder As=S;
- R: ist gleich oder verschieden bei jedem Auftreten H, Deuterium, F, Cl, Br, I, N(R²)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;
- R¹: ist gleich oder verschieden bei jedem Auftreten H, OH oder eine C₁-C₃₀-Alkoxygruppe;
- R²: ist bei jedem Auftreten gleich oder verschieden H, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R² auch miteinander ein mono- oder poly-cyclisches, aliphatisches, aromatisches und/oder benzoannelliertes Ringsystem bilden.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden. Ein cyclisches Carben im Sinne dieser Erfindung ist eine cyclische Gruppe, welche über ein neutrales C-Atom an das Metall bindet. Dabei kann die cyclische Gruppe gesättigt oder ungesättigt sein. Bevorzugt sind hierbei Arduengo-Carbene, also solche Carben, bei welchen an das Carben-C-Atom zwei Stickstoffatome gebunden sind. Dabei wird ein Fünfring-Arduengo-Carben bzw. ein anderes ungesättigtes Fünfring-Carben ebenfalls eine Arylgruppe im Sinne dieser Erfindung angesehen.

Ein aromatisches Ringsystem im Sinne dieser Erfindung enthält 6 bis 60 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, N-oder O-Atom, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, tert-Penyl, 2-Pentyl, Cyclopentyl, n-Hexyl, s-Hexyl, tert-Hexyl, 2-Hexyl, 3-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer C₁- bis C₄₀-Alkoxygruppe werden bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Der Ligand der Formel (I) wird bevorzugt als Hilfsligand eingesetzt, und der Metallkomplex ist bevorzugt ein Emitterkomplex. Es wurde festgestellt, dass sich Verbindungen der Formel (I) hervorragend als Hilfsliganden in Emitterkomplexen eignen. Verbindungen der Formel (I) sind zweizähnige Liganden, die insbesondere eine hohe Stabilität sowie eine hohe Rigidität aufweisen. Bei den Verbindungen der Formel (I) handelt es sich um einfach negativ geladene Liganden. Weiterhin handelt es sich bei den Verbindungen der Formel (I) um sterisch anspruchsvolle Liganden.

Die Starrheit des Liganden der Formel (I) führt zu einer Verminderung der strahlungslosen Deaktivierung des angeregten Zustandes und wirkt sich daher besonders günstig auf die Emissionsquantenausbeute aus. Die Wahl der Hilfsliganden unterliegt aus photophysikalischer Perspektive der Einschränkung, dass sie selbst keine niedrig liegenden elektronischen Zustände besitzen dürfen, die zu einer direkten Beteiligung an den Übergängen führen. Ein Hilfsligand im Sinne dieser Anmeldung ist daher definiert als ein Ligand, der keine direkte Beteiligung an den elektronischen Übergängen des Komplexes aufweist. Anderenfalls würden diese Liganden nicht mehr die Rolle eines Hilfsliganden spielen. Für eine Anwendung in OLEDs kommen noch weitere Anforderungen an die Liganden hinzu. Die Neutralität der in OLEDs verwendeten Substanzen, darunter auch der Triplett-Emitter, ist während des Betriebs des Devices von Vorteil, da neutrale Moleküle keine Beweglichkeit im externen elektrischen Feld besitzen. Auch weil die derzeit am weitesten entwickelten OLED-Devices durch Vakuumsublimation hergestellt werden, ist eine Neutralität der Komplexe gefordert. Dies ist auch im Falle von nass-chemisch verarbeiteten Devices wichtig, da neutrale Komplexe in der Regel größere Solubilität in den am häufigsten genutzten organischen Lösungsmitteln aufweisen. Die Liganden der Formel (I) sind hervorragend geeignet, da sie einfach geladen, zweizähnig und chemisch und thermisch stabil sind, eine hohe Ligandfeldstärke haben, kein Licht im sichtbaren Bereich absorbieren und keine niedrig liegende Triplett-Zustände besitzen.

Je nach dem Atom bzw. der Atomgruppe E lassen sich die Liganden der Formel (I) in drei besondere Gruppen aufteilen:
Gruppe 1: Liganden, in denen beide Symbole E für P, As, Sb oder N stehen:

   **Formel (Ia):** [7,8-(PR₂)₂-7,8-C₂B₉H₁₀]

   **Formel (Ia')** [7,8-(AsR₂)₂-7,8-C₂B₉H₁₀]

   **Formel (la")** [7,8-(SbR₂)₂-7,8-C₂B₉H₁₀]

   **Formel (Ia'")** [7,8-(NR₂)₂-7,8-C₂B₉H₁₀]

   und entsprechende Liganden, in denen die beiden Symbole E unterschiedlich sind und ausgewählt sind aus P, As, Sb und N.
Gruppe 2: Liganden, in denen ein Symbol E für eine Gruppe P=O, P=S, As=O oder As=S steht und das andere Symbol E ausgewählt ist aus P, As, Sb oder N:

   **Formel (Ib):** [7-(O=PR₂)-8-(ER₂)-7,8-C₂B₉H₁₀]

   **Formel (Ib'):** [7-(S=PR₂)-8-(ER₂)-7,8-C₂B₉H₁₀]

   und

   **Formel (Ib"):** [7-(O=AsR₂)-8-(ER₂)-7,8-C₂B₉H₁₀]

   **Formel (Ib"'):** [7-(S=AsR₂)-8-(ER₂)-7,8-C₂B₉H₁₀]
Gruppe 3: Liganden, in denen beide Symbole E für eine Gruppe P=O, P=S, As=O oder As=S stehen:

   **Formel (Ic):** [7,8-(O=PR₂)₂-7,8-C₂B₉H₁₀]

   **Formel (Ic'):** [7,8-(S=PR₂)₂-7,8-C₂B₉H₁₀]

   **Formel (Ic"):** [7,8-(O=AsR₂)₂-7,8-C₂B₉H₁₀]

   **Formel (Ic"'):** [7,8-(S=AsR₂)₂-7,8-C₂B₉H₁₀]

   und entsprechende Liganden, in denen die beiden Symbole E unterschiedlich sind und ausgewählt sind aus P=O, P=S und As=O.

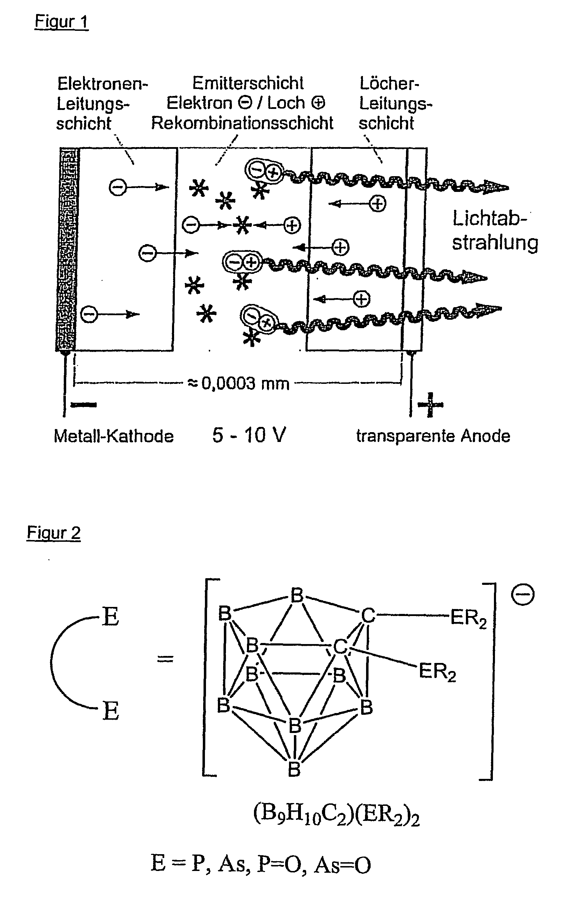

Bei den erfindungsgemäßen sperrigen Hilfsliganden der Formel (I) handelt es sich vorzugsweise um einfach negativ geladene, zweizähnige nido-Carboran-Diamine, *nido*-Carboran-Diphosphane, *nido*-Carboran-Diarsane, *nido*-Carboran-Distibane, bzw. *nido*-Carboran-Oxodiphosphane, *nido-*Carboran-Thiodiphosphane, *nido*-Carboran-Oxodiarsane, nido-Carboran-Dioxodiphosphane, *nido*-Carboran-Dithiodiphosphane, nido-Carboran-Dioxodiarsane (vgl. Figur 2), d. h. die Formel 7,8-C₂B₉H₁₀ steht für ein *nido*-Carboran, welches in den Positionen 7 und 8 Kohlenstoff enthält, wobei die koordinierenden Gruppen E ebenfalls in den Positionen 7 und 8 gebunden sind.

Im Folgenden werden die Metallkomplexe genauer beschrieben, wie sie bevorzugt in der organischen elektronischen Vorrichtung eingesetzt werden können.

Bevorzugt sind Komplexe der Formel (II),

**Formel (II):** **M(E∩E)ₓ(A∩Aⁿ⁻)_{y}(L)_{z}**

worin gilt:
- M: ist ein Metall, bevorzugt ein Übergangsmetall, insbesondere ausgewählt aus W, Re, Os, Ir, Pt, Ru, Rh oder Cu, oder ein Lanthanid,
- (E∩E): ist eine Verbindung der oben genannten Formel (I),
- (A∩Aⁿ⁻): ist ein zwei- oder mehrzähniger Ligand,
- L: ist ein ein- oder mehrzähniger Ligand,
- x: ist 1, 2 oder 3,
- y: ist 0, 1, 2 oder 3, insbesondere 1, 2 oder 3, und besonders bevorzugt 1 oder 2,
- z: ist 0, 1, 2 oder 3,
- n: ist 0, 1 oder 2.

Ein Ligand im Sinne dieser Erfindung ist wie folgt definiert: Die erfindungsgemäßen Komplexe der Formel (II) enthalten für y ungleich 0 zwei funktionale Liganden-Typen. Der sterisch anspruchsvolle, einfach negativ geladene Ligand (E∩E) kann zwei Funktionen übernehmen: Er sorgt für einen Ladungsausgleich und verbessert die photophysikalischen Eigenschaften des Komplexes. Der zweite Ligand (A∩Aⁿ⁻) ist die eigentliche chromophore Einheit und damit letztlich verantwortlich für die Lumineszenz. Unter bestimmten Bedingungen kann es vorteilhaft sein, noch einen weiteren Liganden L einzuführen, um beispielsweise Ladungsneutralität zu erhalten oder das hietailzentrum koordinativ abzusättigen. Diese Liganden L können einen wesentlich geringeren sterischen Anspruch aufweisen als der sperrige Hilfsligand (E∩E), sollten aber bevorzugt wie dieser ebenfalls keine niedrig liegenden elektronischen Zustände aufweisen. Insbesondere sollte sich L nicht am elektronischen Übergang beteiligen. Weiterhin vorteilhaft ist es, wenn L den Metallkomplex stabilisieren kann. L kann neutral oder negativ, insbesondere einfach negativ geladen und ein- oder mehrzähnig, insbesondere ein- oder zweizähnig sein. Beim Liganden L handelt es sich bevorzugt als einen sterisch wenig anspruchsvollen Hilfsliganden, d. h. er ist bevorzugt nicht an den elektronischen Übergängen des Komplexes bei der Emission beteiligt. L kann aus der großen Zahl an Liganden, die die Komplexchemie zur Verfügung stellt, ausgewählt werden. Dabei kann L mono-, bi- oder tridentat oder auch höher dentat sein. Letztlich wird die Wahl eines geeigneten Liganden L vom entsprechenden Zentralmetall abhängen. Bevorzugt liegen die niedrigsten π*-Orbitale des Liganden L höher als die des (A∩Aⁿ⁻)-Chromophor-Liganden. Die Liganden L können auch verknüpft sein, d.h. sie können Bestandteile eines zweizähnigen Liganden (L-L') sein. Die relative Lage der niedrigsten π*-Orbitale kann über UV-vis-Spektroskopie oder über UPS (Ultraviolett-Photoelektronenspektroskopie) bestimmt werden.

Die Liganden L sind bevorzugt neutrale, monoanionische, dianionische oder trianionische Liganden, besonders bevorzugt neutrale oder monoanionische Liganden. Sie sind bevorzugt monodentat, bidentat oder tridentat, weisen also eine, zwei oder drei Koordinationsstellen auf.

Bevorzugte neutrale, monodentate Liganden L sind ausgewählt aus Kohlenmonoxid, Stickstoffmonoxid, Isonitrilen, wie z. B. *tert*-Butyl-isonitril, Cyclohexylisonitril, Adamantylisonitril, Phenylisonitril, Mesitylisonitril, 2,6-Dimethylphenylisonitril, 2,6-Di-iso-propylphenylisonitril, 2,6-Di-tert-butyl-phenylisonitril, Nitrilen, Aminen, wie z. B. Trimethylamin, Triethylamin, Morpholin, Iminen, Phosphinen, wie z. B. Trifluorphosphin, Trimethylphosphin, Tricyclohexylphosphin, Tri-*tert*-butylphosphin, Triphenylphosphin, Tris(pentafluorphenyl)phosphin, Phosphiten, wie z. B. Trimethylphosphit, Triethylphosphit, Arsinen, wie z. B. Trifluorarsin, Trimethylarsin, Tricyclohexylarsin, Tri-*tert*-butylarsin, Triphenylarsinin, Tris(pentafluorphenyl)arsin, Stibinen, wie z. B. Trifluorstibin, Trimethylstibin, Tricyclohexylstibin, Tri-*tert*-butylstibin, Triphenylstibin, Tris(pentafluorphenyl)stibin, Thioethern und stickstoffhaltigen Heterocyclen, wie z. B. Pyridin, 2,4,6-Trimethylpyridin, Pyridazin, Pyrazin, Pyrimidin, Triazin.

Bevorzugte monoanionische, monodentate Liganden L sind ausgewählt aus Hydrid, Deuterid, den Halogeniden F, Cl, Br und I, Alkylacetyliden, wie z. B. Methyl-C≡C⁻, tert-Butyl-C≡C⁻, Arylacetyliden, wie z. B. Phenyl-C≡C⁻, Cyanid, Cyanat, Isocyanat, Thiocyanat, Isothiocyanat, Nitrat, Nitrit, aliphatischen oder aromatischen Alkoholaten, wie z. B. Methanolat, Ethanolat, Propanolat, *iso*-Propanolat, *tert*-Butylat, Phenolat, aliphatischen oder aromatischen Thioalkoholaten, wie z. B. Methanthiolat, Ethanthiolat, Propanthiolat, *iso*-Propanthiolat, *tert*-Thiobutylat, Thiophenolat, Amiden, wie z. B. Dimethylamid, Diethylamid, Di-*iso*-propylamid, Morpholid, Carboxylaten, wie z. B. Acetat, Trifluoracetat, Propionat, Benzoat, und anionischen, stickstoffhaltigen Heterocyclen, wie Pyrrolid, Imidazolid, Pyrazolid, Alkylgruppen, Arylgruppen, wie z. B. Phenyl oder Pentafluorphenyl. Dabei sind die Alkylgruppen in diesen Gruppen bevorzugt C₁-C₂₀-Alkylgruppen, besonders bevorzugt C₁-C₁₀-Alkylgruppen, ganz besonders bevorzugt C₁-C₄-Alkylgruppen. Unter einer Arylgruppe werden auch Heteroarylgruppen verstanden. Diese Gruppen sind wie oben definiert. Bevorzugte di- bzw. trianionische Liganden L sind O²⁻, S²⁻, Nitrene, welche zu einer Koordination der Form R-N=M führen, wobei R allgemein für einen Substituenten steht, oder N³⁻.

Bevorzugte neutrale oder mono- oder dianionische bidentate oder höherdentate Liganden L sind ausgewählt aus Diaminen, wie z. B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen, wie z. B. 2[(1-(Phenylimino)ethyl]pyridin, 2[(1-(2-Methylphenylimino)ethyl]pyridin, 2[(1-(2,6-Di-*iso*-propylphenylimino)ethyl]pyridin, 2[(1-(Methylimino)ethyl]pyridin, 2[(1-(ethylimino)ethyl]pyridin, 2[(1-(*Iso*-Propylimino)ethyl]pyridin, 2[(1-(*Tert-*Butylimino)ethyl]pyridin, Diminen, wie z. B. 1,2-Bis(methylimino)ethan, 1,2-Bis(ethylimino)ethan, 1,2-Bis(*iso*-propylimino)ethan, 1,2-Bis(*tert*-butyl-imino)ethan, 2,3-Bis(methylimino)butan, 2,3-Bis(ethylimino)butan, 2,3-Bis-(*iso*-propylimino)butan, 2,3-Bis(*tert*-butylimino)butan, 1,2-Bis(phenylimino)-ethan, 1,2-Bis(2-methylphenylimino)ethan, 1,2-Bis(2,6-di-*iso*-propylphenyl-imino)ethan, 1,2-Bis(2,6-di-*tert*-butylphenylimino)ethan, 2,3-Bis(phenyl-imino)butan, 2,3-Bis(2-methylphenylimino)butan, 2,3-Bis(2,6-di-*iso*-propyl-phenylimino)butan, 2,3-Bis(2,6-di-*tert-*butylphenylimino)butan, Hetero-cyclen enthaltend zwei Stickstoffatome, wie z. B. 2,2'-Bipyridin, o-Phenanthrolin, Diphosphinen, wie z. B. Bis-diphenylphosphinomethan, Bis-diphenylphosphinoethan, Bis(diphenylphosphino)propan, Bis(dimethyl-phosphino)methan, Bis(dimethylphosphino)ethan, Bis(dimethylphosphino)-propan, Bis(diethylphosphino)methan, Bis(diethylphosphino)ethan, Bis(diethylphosphino)propan, Bis(di-*tert*-butylphosphino)methan, Bis(di-*tert*-butylphosphino)ethan, Bis(*tert*-butylphosphino)propan, 1,3-Diketonaten abgeleitet von 1,3-Diketonen, wie z. B. Acetylaceton, Benzoylaceton, 1,5-Diphenylacetylaceton, Dibenzolymethan, Bis(1,1,1-tri-fluoracetyl)-methan, 3-Ketonaten abgeleitet von 3-Ketoestern, wie z. B. Acetessigsäureethylester, Carboxylate, abgeleitet von Aminocarbonsäuren, wie z. B. Pyridin-2-carbonsäure, Chinolin-2-carbonsäure, Glycin, N,N-Dimethyl-glycin, Alanin, N,N-Dimethylaminoalanin, Salicyliminaten abgeleitet von Salicyliminen, wie z. B. Methylsalicylimin, Ethylsalicylimin, Phenylsalicylimin, Dialkoholaten abgeleitet von Dialkoholen, wie z. B. Ethylenglykol, 1,3-Propylenglykol und Dithiolaten abgeleitet von Dithiolen, wie z. B. 1,2-Ethylendithiol, 1,3-Propylendithiol.

Bevorzugte tridentate Liganden L sind Borate stickstoffhaltiger Heterocyclen, wie z. B. Tetrakis(1-imidazolyl)borat und Tetrakis(1-pyrazolyl)borat.

Bevorzugt werden die Anzahl und die Ladungen der Liganden im Komplex der Formel (II) so gewählt, dass diese die Ladung des Metalls kompensieren, so dass der Komplex der Formel (II) insgesamt ungeladen, also elektrisch neutral ist.

Dabei werden die Indizes x, y und z so gewählt, dass die Koordinationszahl am Metall M insgesamt, je nach Metall, der für dieses Metall üblichen Koordinationszahl entspricht. Dies ist für Hauptgruppen- und Übergangsmetaiie je nach Metall üblicherweise die Koordinationszahl 4, 5 oder 6. Für Lanthanide sind auch Koordinationszahlen bis zu 12 bekannt. Es ist generell bekannt, dass Metallkoordinationsverbindungen abhängig vom Metall und von der Oxidationsstufe des Metalls unterschiedliche Koordinationszahlen aufweisen, also eine unterschiedliche Anzahl von Liganden binden. Da die bevorzugten Koordinationszahlen von Metallen bzw. Metallionen in verschiedenen Oxidationsstufen zum allgemeinen Fachwissen des Fachmanns auf dem Gebiet der metallorganischen Chemie bzw. der Koordinationschemie gehören, ist es für den Fachmann ein Leichtes, je nach Metall und dessen Oxidationsstufe und je nach genauer Struktur der Liganden die Anzahl der Liganden geeignet zu wählen.

(A∩Aⁿ⁻) stellt erfindungsgemäß einen zweizähnigen oder mehrzähnigen Liganden dar. Durch die Bildung eines Chelatkomplexes mit diesem Liagnden erhöht sich die Stabilität des Komplexes gegenüber einem nur einfach gebundenen Liganden. Bevorzugt ist (A∩Aⁿ⁻) ein Chromophorligand, also ein Ligand, der selber an den elektronischen Übergängen des Komplexes bei der Emission (Fluoreszenz oder Phosphoreszenz) beteiligt ist. Bevorzugt ist (A∩Aⁿ⁻) ein zweizähniger Ligand. Dieser Ligand ist neutral oder negativ geladen, insbesondere einfach negativ geladen. Die Bindung von (A∩Aⁿ⁻) an das Metall im erfindungsgemäßen Komplex erfolgt bevorzugt durch ein Kohlenstoffatom und/oder durch ein Stickstoffatom. Das Kohlenstoffatom kann auch ein Carben sein. Der Ligand (A∩Aⁿ⁻) umfasst vorzugsweise aromatische bzw. heteroaromatische Gruppierungen und insbesondere zwei aromatische bzw. heteroaromatische Gruppierungen (Ar-Ar). Weiterhin bevorzugt weist der Ligand (A∩Aⁿ⁻) im Komplex eine mindestens direkte Metall-Kohlenstoff-Bindung auf.

Bevorzugte Liganden (A∩Aⁿ⁻) sind bidentate monoanionische Liganden, welche mit dem Metall einen cyclometallierten Fünfring mit mindestens einer Metall-Kohlenstoff-Bindung aufweisen. Dies sind insbesondere Liganden, wie sie allgemein im Gebiet der phosphoreszierenden Metall-komplexe für organische Elektrolumineszenzvorrichtungen verwendet werden, also Liganden vom Typ Phenylpyridin, Naphthylpyridin, Phenylchinolin, Phenylisochinolin, etc., welche jeweils durch einen oder mehrere Reste R substituiert sein können. Dem Fachmann auf dem Gebiet der phosphoreszierenden Elektrolumineszenzvorrichtungen ist eine Vielzahl derartiger Liganden bekannt, und er kann ohne erfinderisches Zutun weitere derartige Liganden als Ligand (A∩Aⁿ⁻) für Verbindungen gemäß Formel (II) auswählen.

In einer bevorzugten Ausführungsform der Erfindung ist die Gruppe (A∩Aⁿ⁻) zusammengesetzt aus zwei Aryl- oder Heteroarylgruppen mit 5 bis 40 aromatischen Ringatomen, welche gleich oder verschieden bei jedem Auftreten sein können welche durch einen oder mehrere Reste R substituiert sein können und/oder welche auch ein exocyclisches Donoratom aufweisen können. Dabei sind die Gruppen R definiert wie oben. Bevorzugte Aryl- bzw. Heteroarylgruppen sind Benzol, 2-Phenol, 2-Thiophenol, Napthalin, Anthracen, Phenanthren, Pyridin, Chinolin, Isochinolin, Pyrazin, Chinoxalin, Pyrimidin, Pyridazin, Triazin, Pyrrol, Indol, Imidazol, Furan, Benzofuran, Benzimidazol, Pyrazol, Triazol, Oxazol, Thiazol, Thiophen, Benzothiophen, Benzoxazol oder Benzthiazol, welche jeweils durch einen oder mehrere Reste R substituiert sein kann. Je nach Gruppe sind die oben genannten Gruppen neutral koordinierende Gruppen, beispielsweise Pyridin, welches über neutrales N-Atom bindet, oder es sind anionisch koordinerende Gruppen, beispielsweise Benzol, Thiophen und Phenol, welche über ein negativ geladenes C-Atom bzw. O-Atom binden. Weitere bevorzugte koordinierende Gruppen sind ungesättigte oder gesättigte cyclische Arduengo-Carbene, insbesondere ungesättigte cyclische Arduengo-Carbene, welche jeweils mit einem oder mehreren Resten R substituiert sein können, und Alkene oder Imine, welche jeweils mit einem oder mehreren Resten R substituiert sein können.

Generell eignet sich als Ligand (A∩Aⁿ⁻) besonders die Kombination aus zwei Gruppen, wie sie durch die folgenden Formeln dargestellt sind, wobei eine Gruppe über ein neutrales Stickstoffatom oder ein Carbenatom bindet und die andere Gruppe über ein negativ geladenes Kohlenstoffatom oder ein negativ geladenes Stickstoffatom bindet. Der Ligand (A∩Aⁿ⁻) kann dann aus den Gruppen der abgebildeten Formeln gebildet werden, indem zwei dieser Gruppen jeweils an der durch # gekennzeichneten Position aneinander binden. In diesen Formeln ist jeweils durch * die Position angedeutet, in der der Ligand an das Metall bindet. Dabei binden bevorzugt eine neutral koordinierende Gruppe und eine anionische Gruppe aneinander.

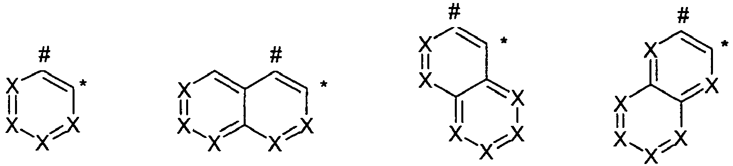

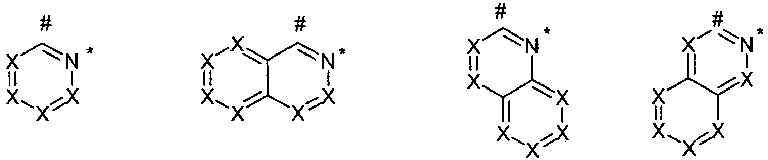

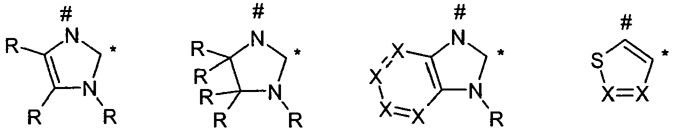

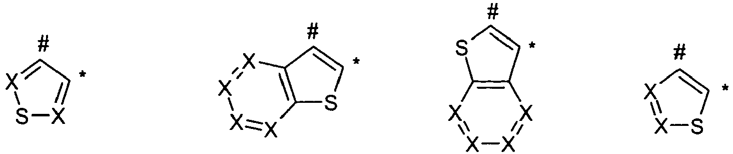

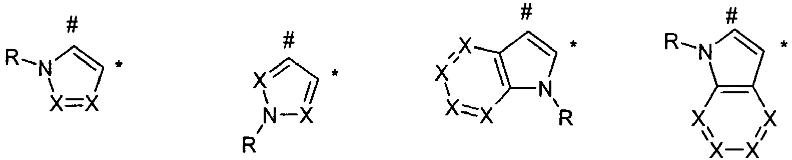

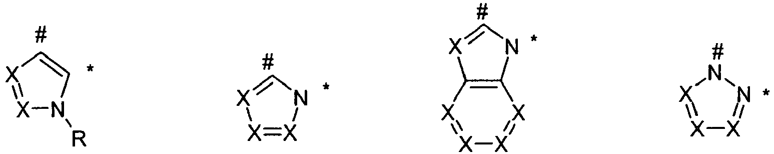

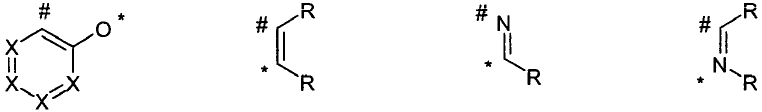

Dabei steht X gleich oder verschieden bei jedem Auftreten für CR, wobei R die oben genannte Bedeutung hat, oder für N mit der Maßgabe, dass maximal drei Symbole X in jeder Gruppe für N stehen. Bevorzugt stehen maximal zwei Symbole X in jeder Gruppe für N, besonders bevorzugt steht maximal ein Symbol X in jeder Gruppe für N, ganz besonders bevorzugt stehen alle Symbole X für CR.

So eignen sich als Ligand (A∩A⁻) beispielsweise Liganden der folgenden Struktur: 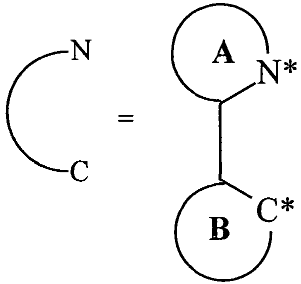 wobei die Einheiten A und B aus fünf- oder sechsgliedrigen Ringen bestehen können oder offenkettig sind. Die Einheiten A und B in dieser Struktur stehen dabei beispielsweise für 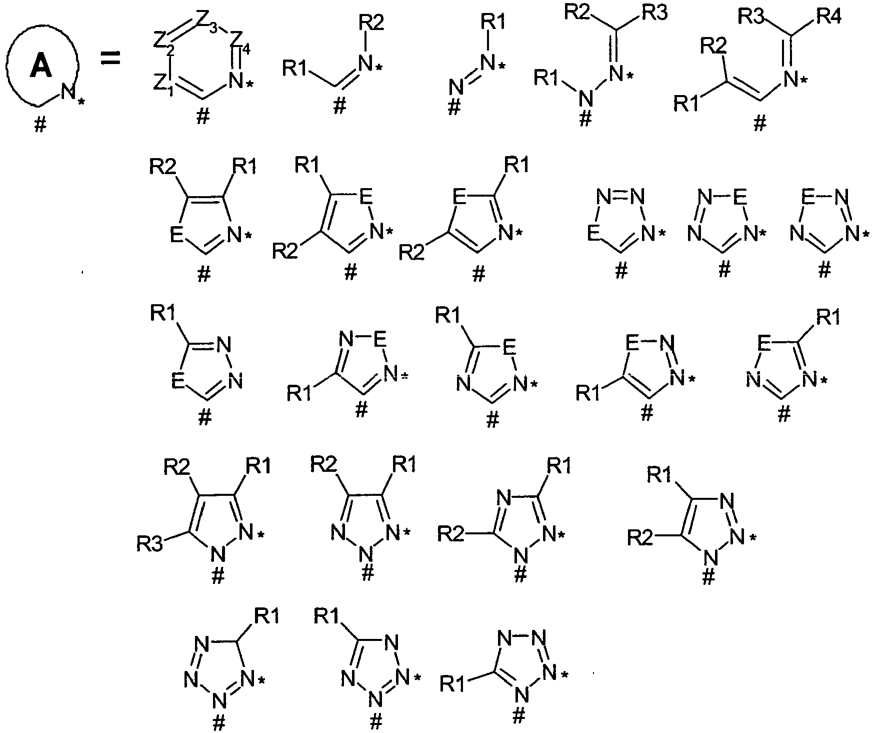 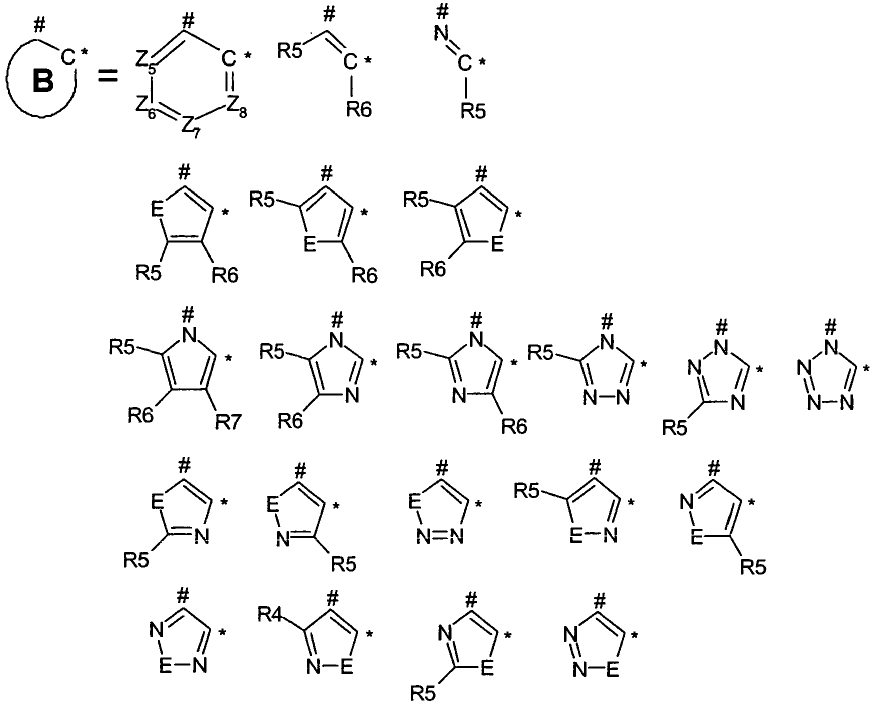 worin R dieselbe Bedeutung hat, wie oben beschrieben, und weiterhin gilt:
- E: ist O, S oder NR,
- R1 bis R7: hat dieselbe Bedeutung wie R,
- Z1 bis Z8: ist gleich oder verschieden bei jedem Auftreten C-R oder N,
- *: bezeichnet das Atom, das die Komplexbindung eingeht, und
- #: stellt das Atom dar, das mit der zweiten Einheit verbunden ist.

Beispiele für bevorzugte Liganden (A∩A⁻) sind im Folgenden abgebildet: 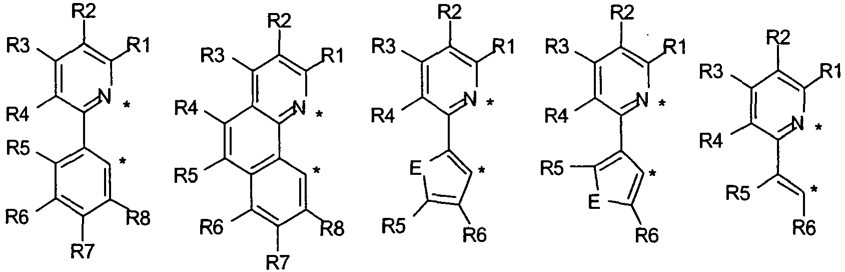 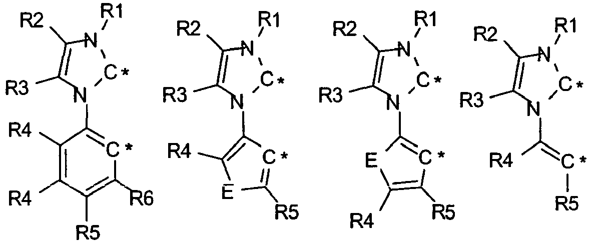 wobei die verwendeten Symbole und Indizes dieselbe Bedeutung haben, wie oben beschrieben.

Bevorzugt sind weiterhin Komplexe der Formel (II), worin (A∩A⁻) dargestellt ist durch die folgende Formel: 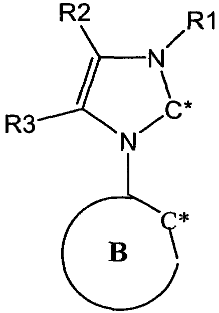 wobei B aus einem 5- oder 6-gliedrigen Ring bestehen oder offenkettig sein kann und R1, R2 und R3 jeweils unabhängig dieselbe Bedeutung haben wie R, wie oben für Formel (I) beschrieben. Dabei ist die Einheit B bevorzugt ausgewählt aus den folgenden Formeln: 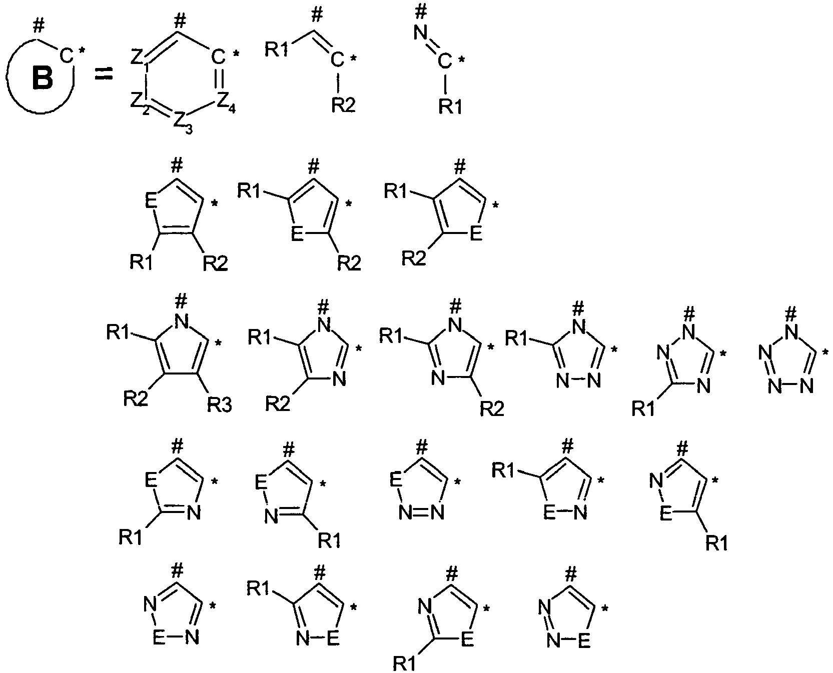 worin R dieselbe Bedeutung hat, wie oben beschrieben, und weiterhin gilt:
- E: ist O, S oder NR,
- R1 bis R3: hat dieselbe Bedeutung wie R,
- Z1 bis Z4: ist gleich oder verschieden bei jedem Auftreten C-R oder N,
- *: bezeichnet das Atom, das die Komplexbindung eingeht, und
- #: stellt das Atom dar, das mit der zweiten Einheit verbunden ist.

Beispielsweise steht (A∩A⁻) für 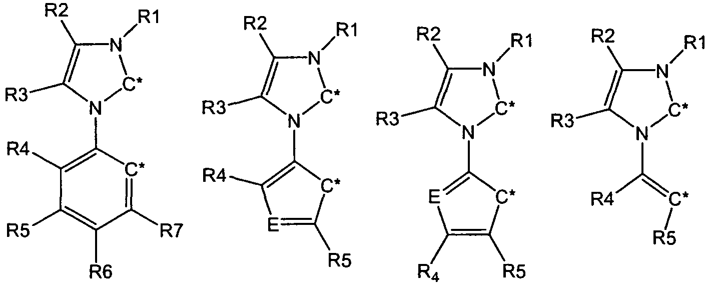 worin R, R1, R2, R3 und E dieselbe Bedeutung haben, wie oben beschrieben, und weiterhin R4, R5 und R6 dieselbe Bedeutung haben, wie oben für R definiert. * bezeichnet das Atom, das die Komplexbindung eingeht.

Bevorzugt sind Komplexe der Formel (II) ausgewählt aus M(E∩E)(A∩Aⁿ⁻)₂, M(E∩E)₂(A∩Aⁿ⁻) oder M(E∩E)(A∩Aⁿ⁻)(L)₂, wobei M vorzugsweise Os(II), Ir(III), Ru(II), Re(I), Pt(IV) oder W(0) ist, insbesondere Ir(III). Besonders bevorzugt sind Komplexe der Formel (II) ausgewählt aus Pt^{II}(E∩E)(A∩A⁻), Ir^{III}(E∩E)₂(A∩A⁻), Ir^{III}(E∩E)(A∩A⁻)₂, Rh^{III}(E∩E)ₙ(A∩A⁻), Rh^{III}(E∩E)(A∩A⁻)₂, Os^{II}(E∩E)(A∩A⁻)L₂ und Ru^{II}(E∩E)(A∩A⁻)L₂, wobei (A∩A⁻) jeweils für einen der oben aufgeführten bevorzugten Liganden steht.

Weitere bevorzugte neutrale Liganden (A∩A) sind die unten aufgeführten Liganden (N∩N).

Eine weitere bevorzugte Ausführungsform der Erfindung sind die Komplexe der folgenden Formeln (III), (IV), (V) und (VI),

**Formel (III):** **M(III)(E**∩**E)₃**

**Formel (IV):** **M(III)(E**∩**E)₃(L)_{z}**

**Formel (V):** **M(II)(E**∩**E)₂(L)_{z}**

**Formel (VI):** **M(III)(E**∩**E)₃(N**∩**N)(L)_{z}**

worin gilt:
- (N∩N): ist ein bidentater Ligand, der über zwei Stickstoffatome an das Metall koordiniert;
- M(III): ist ein dreiwertiges Lanthanoid-Kation, z. B. Ce(III), Pr(III), Nd(III), Pm(III), Sm(III), Eu(III), Gd(III), Tb(III), Dy(III), Ho(III), Er(III), Tm(III), Yb(III), Lu(III),
- M(II): ist ein zweiwertiges Lanthanoid-Kation, z. B. Sm(II), Eu(II), Tm(II) oder Yb(II),
- (E∩E): ist ein Ligand der Formel (I),insbesondere der Formel (Ic), und
- L: ist ein ein- oder mehrzähniger Ligand.

Dabei ist L bevorzugt ausgewählt aus den Liganden L, wie oben für die Komplexe der Formel (II) ausgeführt.

Es ist bekannt, dass sich Phosphanoxide hevorragend als Liganden für Lanthanoid-Kationen eignen. Durch die Kombination der Phosphanoxid-Gruppe mit der *nido*-Carboran-Einheit entsteht der sterisch sehr anspruchsvolle, einfach negativ geladene Ligand der Formel (Ic), der die Koordinationssphäre des Zentralatoms hervorragend abzuschirmen vermag und so zu ausgesprochen stabilen und gleichzeitig neutralen Komplexen führt. Diese gute Abschirmung vermeidet die Störung der metallzentrierten, elektronischen Übergänge und reduziert daher die strahlungslose Desaktivierung, was wiederum zu hohen Emissionsquantenausbeuten führt.

Gerade die Kombination aus den vielseitig einsetzbaren Phosphan- und Phosphanoxid-Gruppen und einem sehr starren, einfach negativ geladenen *nido*-Carboran-Gerüst machen diese Liganden zu idealen Hilfsliganden für einen Einsatz in neutralen Emitter-Komplexen. Insbesondere die hohe Rigidität und Sperrigkeit dieser Liganden ermöglichen stabile neutrale Metall-Komplexe mit hohen Emissionsquantenausbeuten (auch in Schichten, die zu 100% aus dem Komplex-Material bestehen).

Bevorzugt sollte der Ligand (N∩N) nicht zu hoch liegende Triplett-Zustände besitzen. Ebenfalls bevorzugt steht (N∩N) für einen α-Diiminliganden. In einer bevorzugten Ausführungsform der Erfindung weist der Ligand (N∩N) die folgende Struktur auf: 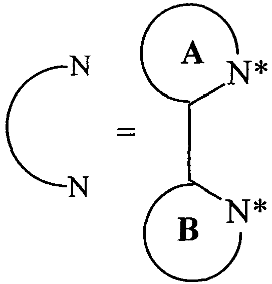 worin die Gruppierungen A und B fünf- oder sechsatomige Ringe darstellen oder offenkettig sind. Dabei sind die Gruppen A und B bevorzugt gewählt aus den im Folgenden abgebildeten Gruppen: 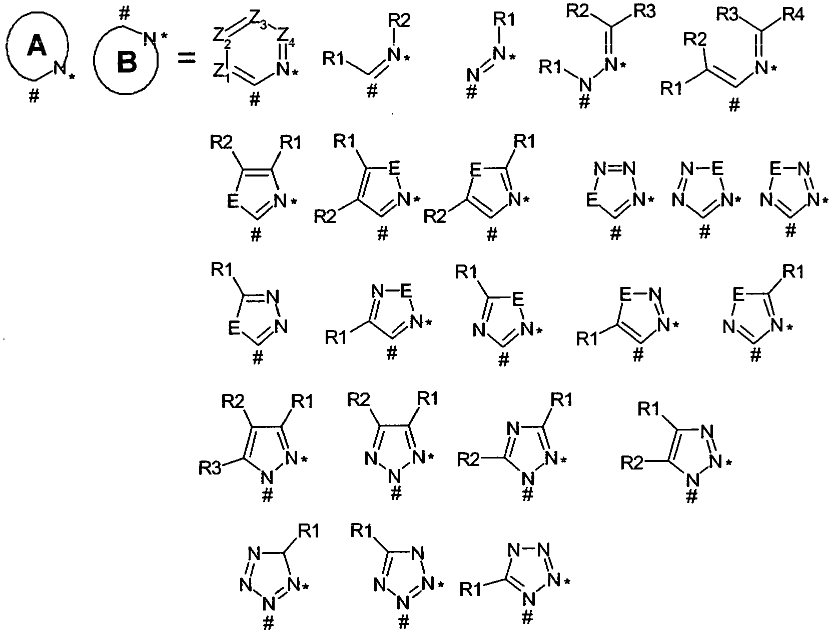 worin die Symbole E, R, R¹ bis R4 und Z1 bis Z4 dieselbe Bedeutung haben, wie oben beschrieben, * das Atom bezeichnet, das die Komplexbindung eingeht, und # das Atom darstellt, das mit der zweiten Einheit verbunden ist.

Liganden (N∩N) sind beispielsweise gewählt aus den folgenden Formeln: 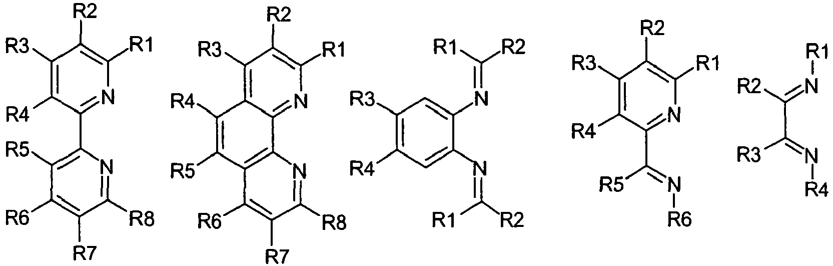 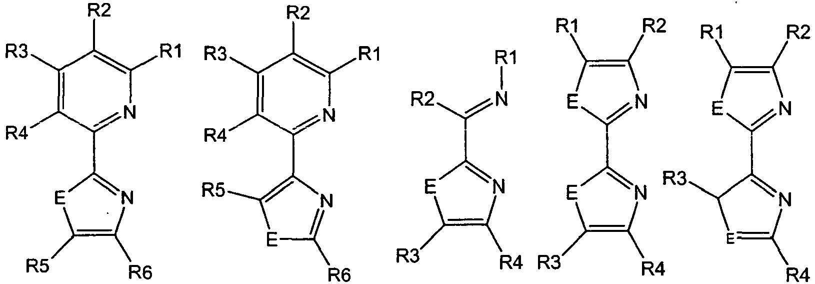 wobei die Symbole dieselbe Bedeutung haben, wie oben beschrieben.

Beispiele für bevorzugte Liganden (N∩N) sind die im Folgenden abgebildeten Liganden:

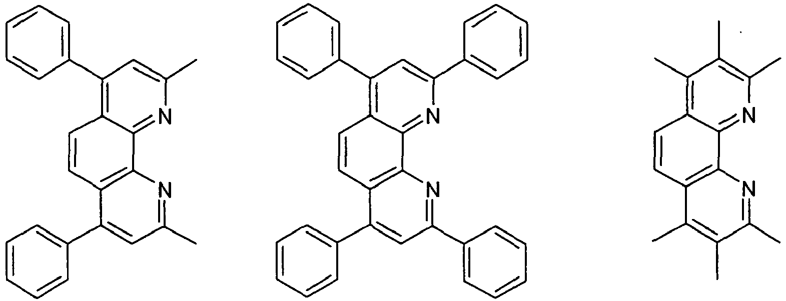

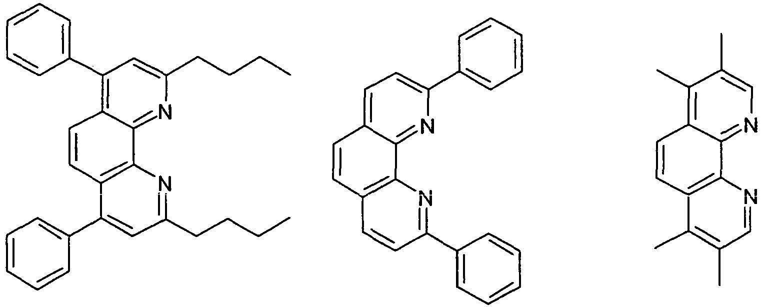

Diese eignen sich insbesondere auch zur Verwendung in Cu(I)-Komplexen.

Beispiele für erfindungsgemäße Komplexe der Formel (II) sind Komplexe vom Typ Re^{I}(CO)₂(E∩E)(N∩N), Ru^{II}(E∩E)₂(N∩N), Cu^{I}(E∩E)(N∩N), Rh^{I}(E∩E)(N∩N), Os^{II}(E∩E)₂(N∩N), Os^{II}(CO)Cl(E∩E)(N∩N), Os^{II}(CO)Br(E∩E)(N∩N), Os^{II}(CO)(CN)(E∩E)(N∩N), Os^{II}(CO)(SCN)(E∩E)(N∩N), Ru^{II}(CO)(Cl)(E∩E)(N∩N), Ru^{II}(CO)(Br)(E∩E)(N∩N), Ru^{II}(CO)(CN)(E∩E)(N∩N), Ru^{II}(CO)(SCN)(E∩E)(N∩N), Ru^{II}(L¹)(L²)(E∩E)(N∩N), Os^{II}(L¹)(L²)(E∩E)(N∩N) und Ir^{I}(E∩E⁻)(N∩N), worin L¹ und L² jeweils unabhängig CO, CN⁻, SCN⁻, Halogen, Pyridin, Nitril oder Isonitril darstellt.

In einer bevorzugten Ausführungsform der Erfindung ist der Substituent R im Liganden gemäß Formel (I) gleich oder verschieden bei jedem Auftreten H, Deuterium, N(R²)₂, eine geradkettige Alkyl-, Alkoxy- oder Thioalkoxygruppe mit 1 bis 20 C-Atomen oder eine verzweigte oder cyclische Alkyl-, Alkoxy- oder Thioalkoxygruppe mit 3 bis 20 C-Atomen, die jeweils mit einem oder mehreren Resten R² substituiert sein kann, wobei eine oder mehrere nicht benachbarte CH₂-Gruppen durch R²C=CR² oder C≡C ersetzt sein können und wobei ein oder mehrere H-Atome durch F ersetzt sein können, oder ein aromatisches oder heteroaromatisches Ringsystem mit 5 bis 30 aromatischen Ringatomen, das jeweils durch einen oder mehrere Reste R² substituiert sein kann, oder eine Aryloxy- oder Heteroaryloxygruppe mit 5 bis 30 aromatischen Ringatomen, die durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden. In einer besonders bevorzugten Ausführungsform der Erfindung ist der Substituent R im Liganden gemäß Formel (I) gleich oder verschieden bei jedem Auftreten H, eine geradkettige Alkyl- oder Alkoxygruppe mit 1 bis 10 C-Atomen, insbesondere mit 1 bis 6 C-Atomen, oder eine verzweigte oder cyclische Alkyl- oder Alkoxygruppe mit 3 bis 10 C-Atomen, insbesondere mit 3 bis 6 C-Atomen, oder ein aromatisches oder heteroaromatisches Ringsystem mit 5 bis 14 aromatischen Ringatomen, das jeweils durch einen oder mehrere Reste R² substituiert sein kann, oder eine Aryloxy- oder Heteroaryloxygruppe mit 5 bis 14 aromatischen Ringatomen, die durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden.

In einer weiteren bevorzugten Ausführungsform der Erfindung ist der Substituent R¹ in Liganden der Formel (I) gleich H.

In einer weiteren bevorzugten Ausführungsform der Erfindung ist der Substituent R am Liganden (A∩Aⁿ⁻) gleich oder verschieden bei jedem Auftreten ausgewählt aus H, Deuterium, F, Cl, Br, I, N(R²)₂, eine geradkettige Alkyl- oder Alkoxygruppe mit 1 bis 10 C-Atomen oder eine verzweigte oder cyclische Alkyl- oder Alkoxygruppe mit 3 bis 10 C-Atomen, die jeweils mit einem oder mehreren Resten R² substituiert sein kann, wobei eine oder mehrere nicht benachbarte CH₂-Gruppen durch R²C=CR², C=C ersetzt sein können und wobei ein oder mehrere H-Atome durch F ersetzt sein können, oder ein aromatisches oder heteroaromatisches Ringsystem mit 5 bis 20 aromatischen Ringatomen, das jeweils durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden. Dabei sind die mit Cl, Br oder I substituierten Systeme insbesondere geeignet als Zwischenstufen zur Synthese von Derivaten dieser Verbindungen.

Die Komplexe der Formel (II) weisen ein Zentralatom auf, bei welchem es sich um ein Metall handelt. Vorzugsweise ist M ein einzelnes Metallion oder Metallatom.

In einer ersten Ausführungsform der Komplexe ist M insbesondere ein Übergangsmetall und wird bevorzugt ausgewählt aus Pt, Rh, Ir, Re, Ru, Cu, Os oder W. Das Zentralatom liegt bevorzugt als Pt(II), Pt(IV), Rh(III), Rh(I), Ir(I), Ir(III), Re(I), Ru(II), Cu(I), Rh(I), Os(II), W(0), W(II), W(III) oder W(VI) vor, also als Atom oder als einfach oder zweifach oder dreifach positiv geladenes Ion. Besonders bevorzugt sind die Zentralatome Pt(II), Ir(III) oder Cu(I).

M ist vorzugsweise nicht Ag oder Au und insbesondere nicht Au.

Insbesondere für solche Komplexe ist y vorzugsweise 1, 2 oder 3, besonders bevorzugt 1 oder 2, d. h. die Komplexe umfassen mindestens einen Chromophor-Liganden (A∩Aⁿ⁻). Bevorzugt weist der Komplex dann mindestens eine direkte Metall-Kohlenstoffbindung zum Liganden (A∩Aⁿ⁻) auf.

In einer weiteren bevorzugten Ausführungsform stellt M ein Lanthanoid-Kation dar, insbesondere in den bevorzugten Komplexen der Formeln (III), (IV), (V) und (VI).

Für Komplexe der Formeln (III), (IV) und (VI) ist M vorzugsweise ein dreiwertiges Lanthanoid-Kation und wird bevorzugt ausgewählt aus Ce(III), Pr(III), Nd(III), Pm(III), Sm(III), Eu(III), Gd(III), Tb(III), Dy(III), Ho(III), Er(III), Tm(III), Yb(III), Lu(III). Besonders bevorzugt sind die Zentralatome Ce(III), Nd(III), Eu(III) oder Tb(III). Für Komplexe der Formel (V) stellt M(II) vorzugsweise ein zweiwertiges Lanthanoid-Kation dar, z. B. Sm(II), Eu(II), Tm(II) oder Yb(II) usw. In den Komplexen der Formeln (III) bis (VI) ist M vorzugsweise 6- bis 9-fach koordiniert.

In einer bevorzugten Ausführungsform der Erfindung umfassen die Komplexe der Formel (II) ein vierfach koordiniertes Metallion. Solche Komplexe weisen insbesondere die Formel M(E∩E)(A∩Aⁿ⁻) auf. In solchen Komplexen ist das Metallion bevorzugt Pt(II), Ir(I), Cu(I) oder Rh(I).

In einer weiteren Ausführungsform der Erfindung umfassen die Komplexe der Formel (II) ein sechsfach koordiniertes Metallion oder Metallatom. Solche Komplexe weisen insbesondere die Formel M(E∩E)(A∩Aⁿ⁻)₂, M(E∩E)₂(A∩Aⁿ⁻) oder M(E∩E)(A∩Aⁿ⁻)(L)₂ auf. In solchen Komplexen ist das Metallion oder Metallatom bevorzugt Os(II), Ir(III), Ru(II), Re(I), Pt(IV) W(0), W(II), W(III), W(IV), W(V) oder W(VI).

Neben der hohen chemischen Stabilität sowie den günstigen elektronischen Eigenschaften (hohe energetische Lagen der angeregten Singulett- und Triplett-Zustände) ist auch die Sperrigkeit des Liganden der Formel (I) für die technische Anwendung, z. B. als Emitter in OLEDs, von Bedeutung. Das gilt insbesondere für den Fall der quadratisch-planaren Komplexe von Pt(II), Pd(II), Ir(I) oder Rh(I), denn derartige neutrale Komplexe aus dem Stand der Technik, wie Pt(ppy)(CO)Cl, Pt(ppy)₂, Pt(ppy)(**1**) oder Pt(ppy)(**4**) (mit ppy = 2-Phenylpyridin), weisen eine starke Tendenz zur Aggregation auf. Als Folge davon ergeben sich ausgeprägte Metall-Metall-Wechselwirkungen, die die Emissionseigenschaften häufig negativ verändern und die OLED-Eignung der Komplexe ausschließen können. Außerdem kann sich die Aggregation auch sehr ungünstig auf die Verarbeitbarkeit sowohl beim Vakuumverdampfen als auch bei nasschemischen Verfahren auswirken.

Sterisch anspruchsvolle Liganden, die eine Bildung von stapelartigen oligo- und polymolekularen Aggregaten verhindern, können die oben genannten Probleme vermeiden und ermöglichen die Verwendung neuer Klassen von monomeren Triplett-Emitter-Materialien. Beispielswiese sind einige quadratisch-planare Komplexe von Pt(II) in ihrer nicht aggregierten, monomeren Form sehr effiziente Emitter, können aber aus den oben genannten Gründen kaum in OLEDs eingesetzt werden. Die Bisphosphane und Bisarsane vom Typ **7** (vgl. Figur 2) bzw. die anderen Liganden der Formel (I), die ein *nido*-Carboran-Gerüst beinhalten, vereinen die vorteilhaften Eigenschaften in einem Liganden:
(i) Negative Ladung des Liganden. Das ermöglicht, beziehungsweise vereinfacht die Synthese neutraler Emitter.
(ii) Zweizähnige Bindung an das Zentralion. Damit wird die Stabilität des resultierenden Komplexes erhöht.
(iii) Rigidität des Hilfsliganden. Hierdurch wird die strahlungslose Deaktivierung des angeregten Zustandes reduziert.
(iv) Sperrigikeit des Liganden. Damit wird eine gute Isolierung von einzelnen Emitter-Molekülen erreicht und die Entstehung von unerwünschten Aggregaten verhindert.

Die im Folgenden gezeigten Beispiele [Pt(ppy)(**7a**)], [Pt(ppy)(**7b**)], [Pt(dfppy)(**7a**)] und [Pt(thpy)(**7a**)] (ppy = 2-Phenylpyridin, dfppy = 2-(4,6-Difluorophenyl)-pyridin, thpy = 2-(2-Thienyl)-pyridin) belegen, dass die Liganden **7** (Fig. 2) die Aggregation der quadratisch-planaren Komplexe blockieren und die emittierenden Chromophorzentren sterisch isolieren. Dadurch ist es auch möglich, im Festkörper (100% Emitterschicht) hohe Lumineszenzquantenausbeuten der Monomere zu erreichen.

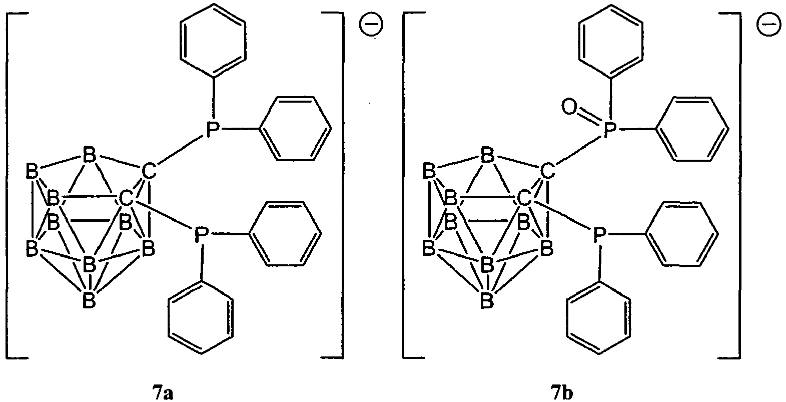

Beispiele für bevorzugte Verbindungen sind zusammengesetzt aus je einem der im Folgenden abgebildeten monoanionischen, zweizähnigen Phosphinliganden aus Tabelle 1 in Komination mit einem monokationischen Pt(II)-Komplexfragment aus Tabelle 2 bzw. einem monokationischen Ir(III)-Komplexfragment aus Tabelle 3. Diese Komplexe lassen sich unter anderem mit den unten erläuterten Synthesemethoden herstellen.

**Tabelle 1: Monoanionische zweizähnige Phosphinliganden**

| | |
|---|---|
| 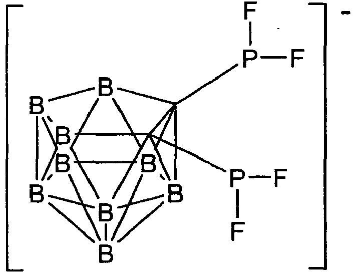 | 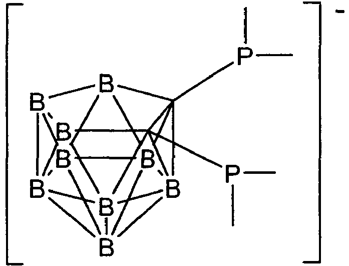 |
| (1) | (2) |
| 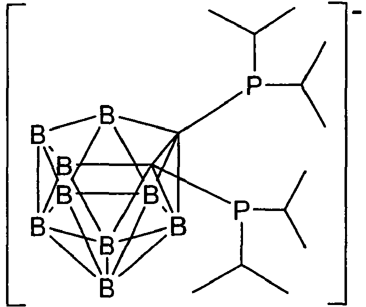 | 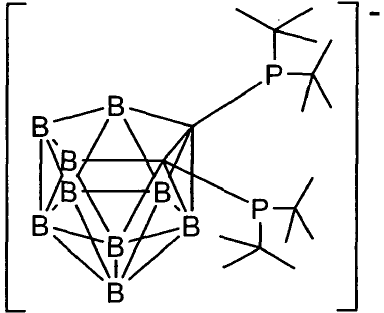 |
| (3) | (4) |
| 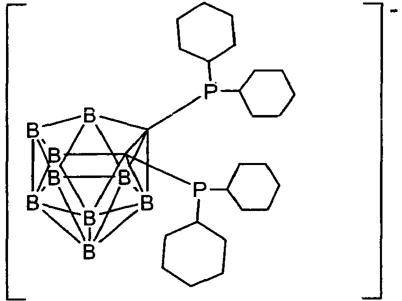 | 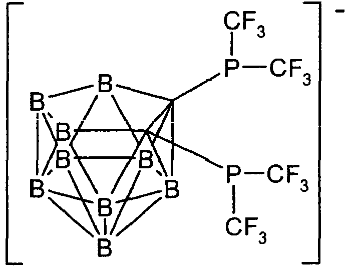 |
| (5) | (6) |
| 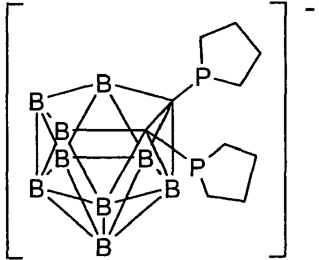 | 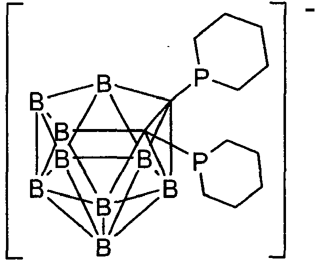 |
| (7) | (8) |
| 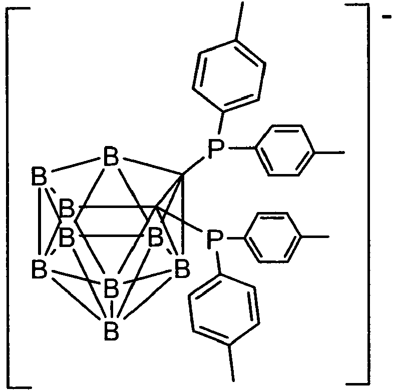 | 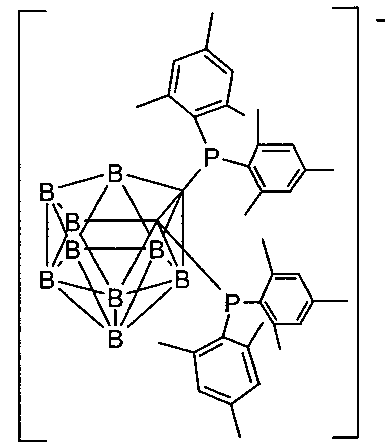 |
| (9) | (10) |
| 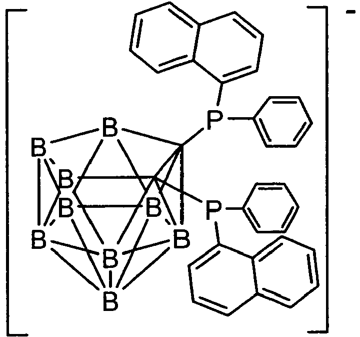 | 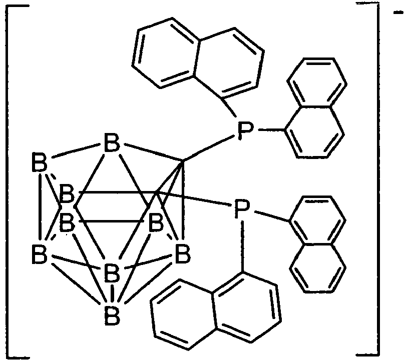 |
| (11) | (12) |
| 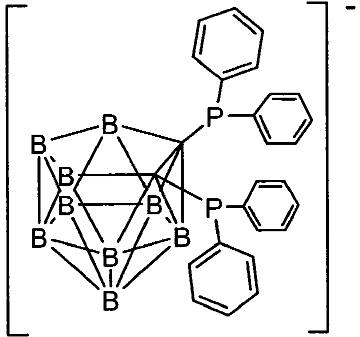 | 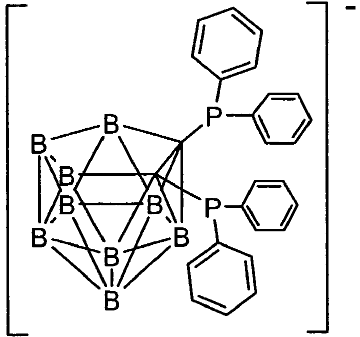 |
| (13) | (14) |
| 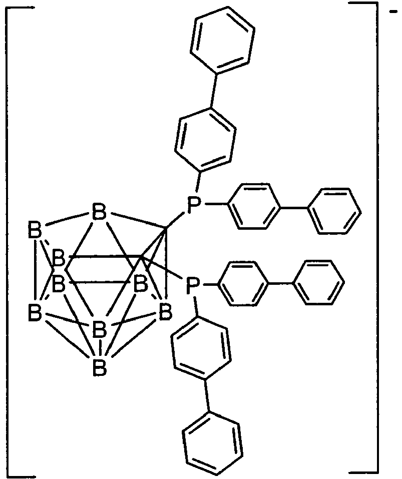 | 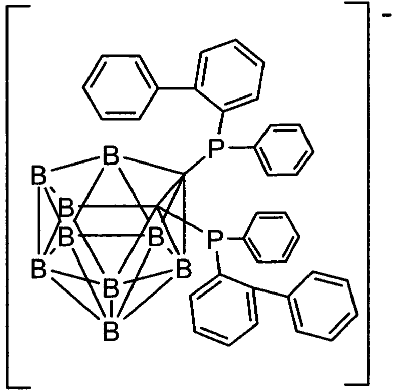 |
| (15) | (16) |
| 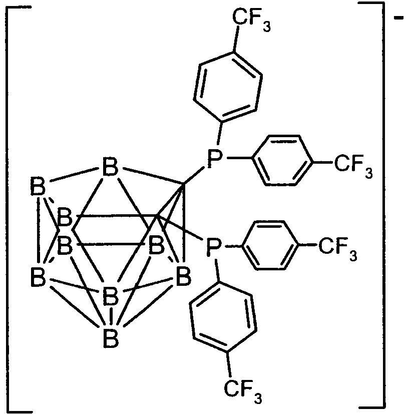 | 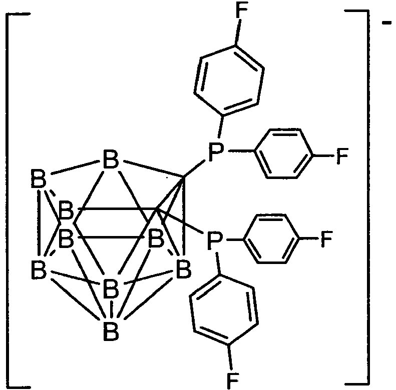 |
| (17) | (18) |
| 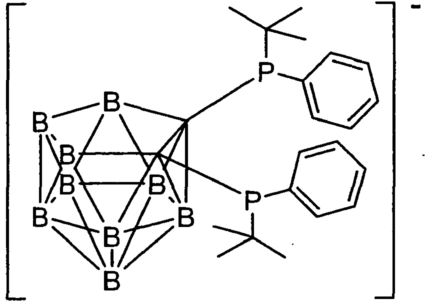 | 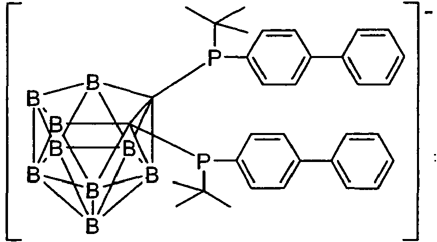 |
| (19) | (20) |
| 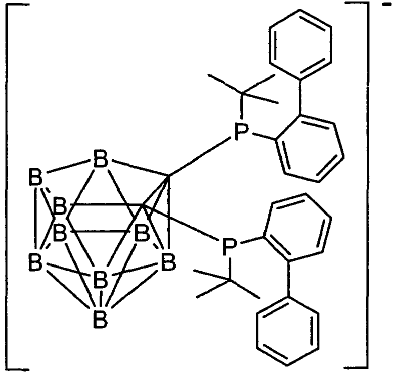 | 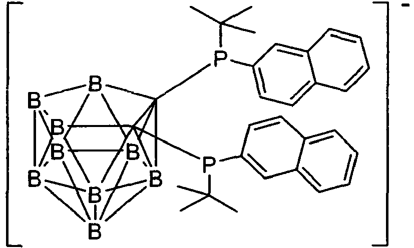 |
| (20) | (21) |

**Tabelle 2: Monokationische Pt(II)-Komplexfragmente**

| | |
|---|---|
| 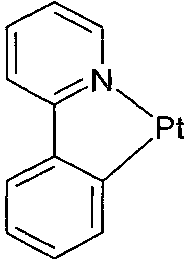 | 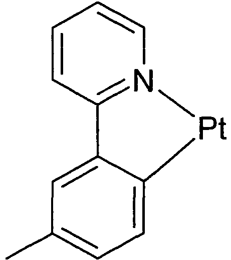 |
| (1) | (2) |
| 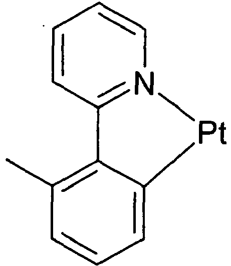 | 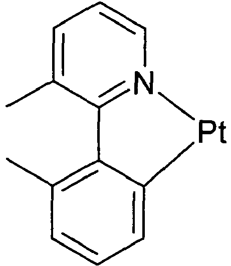 |
| (3) | (4) |
| 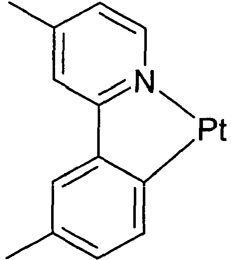 | 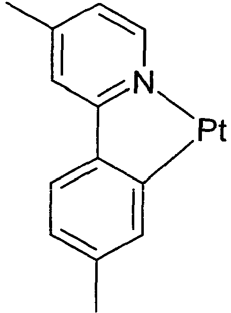 |
| (5) | (6) |
| 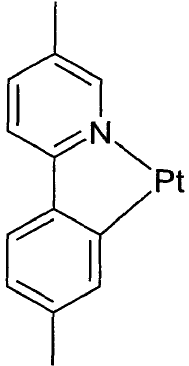 | 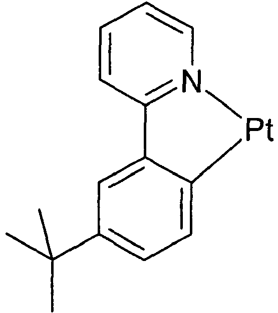 |
| (7) | (8) |
| 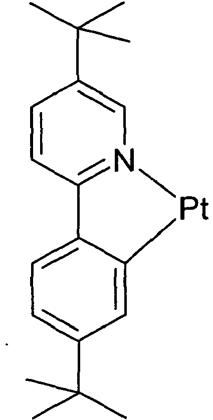 | 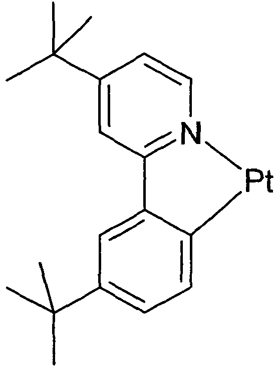 |
| (9) | (10) |
| 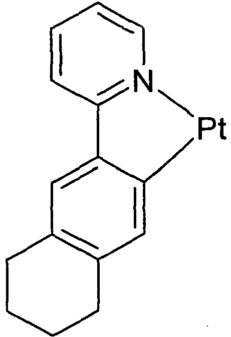 | 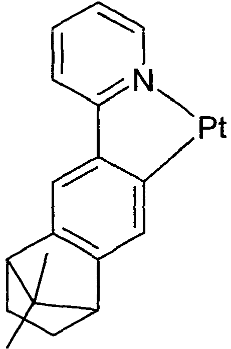 |
| (11) | (12) |
| 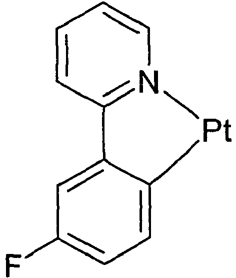 | 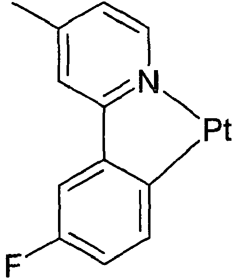 |
| (13) | (14) |
| 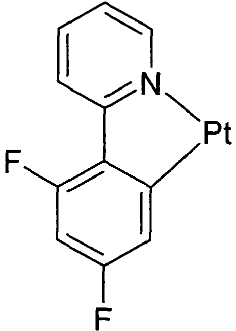 | 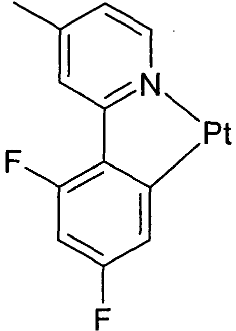 |
| (15) | (16) |
| 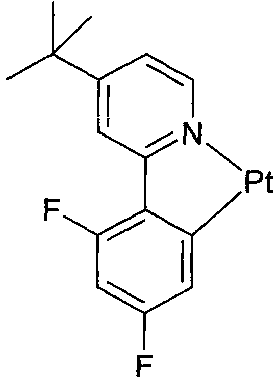 | 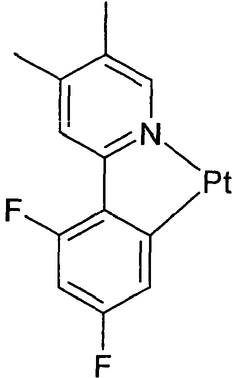 |
| (17) | (18) |
| 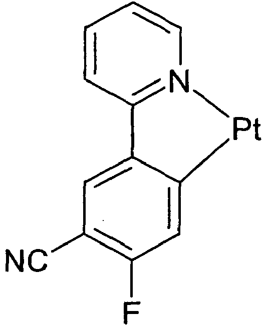 | 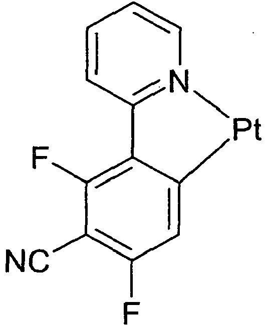 |
| (19) | (20) |
| 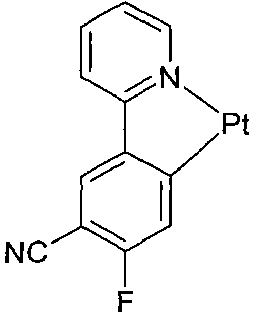 | 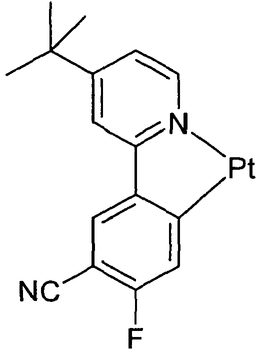 |
| (21) | (22) |
| 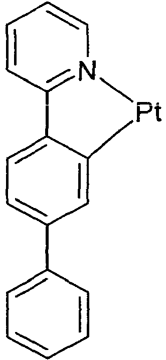 | 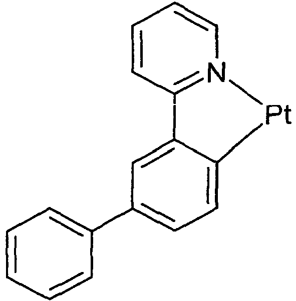 |
| (23) | (24) |
| 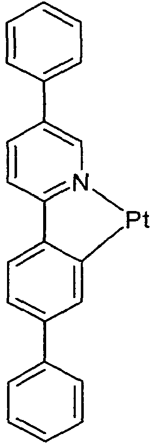 | 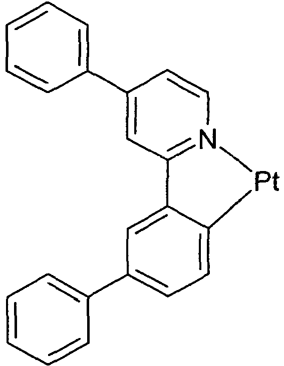 |
| (25) | (26) |
| 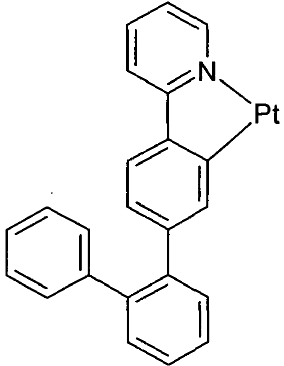 | 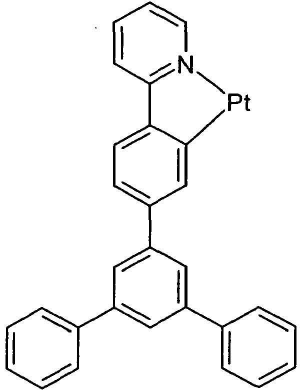 |
| (27) | (28) |
| 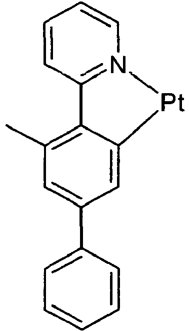 | 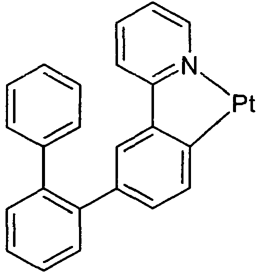 |
| (29) | (30) |
| 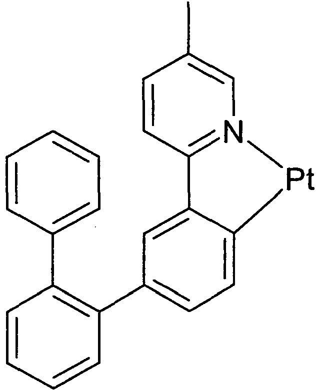 | 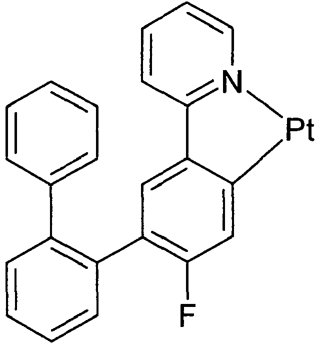 |
| (31) | (32) |
| 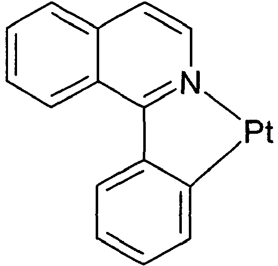 | 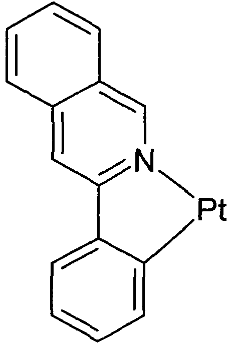 |
| (33) | (34) |
| 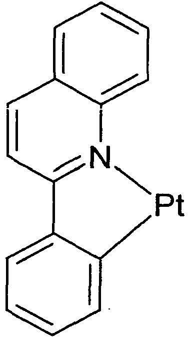 | 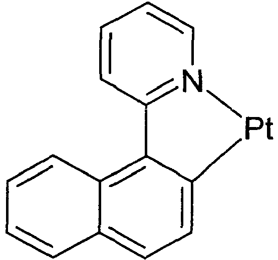 |
| (35) | (36) |
| 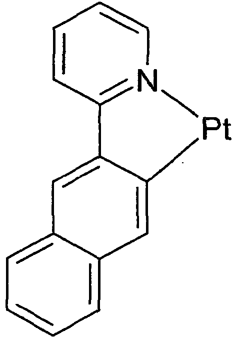 | 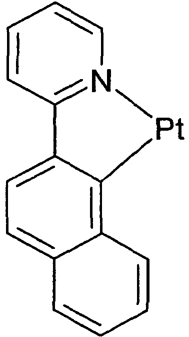 |
| (37) | (38) |
| 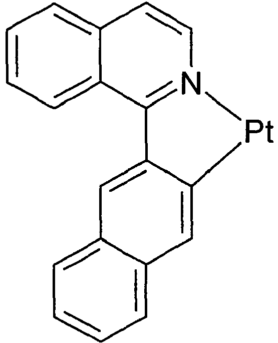 | 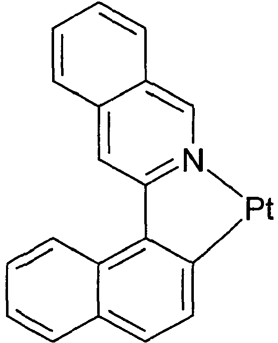 |
| (39) | (40) |
| 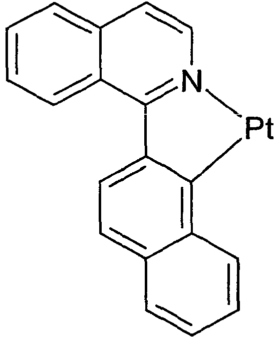 | 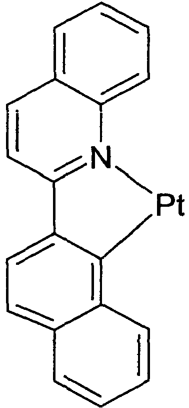 |
| (41) | (42) |
| 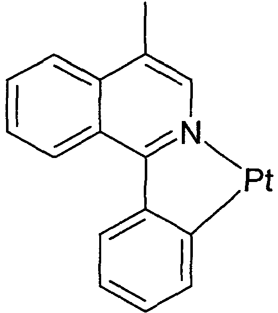 | 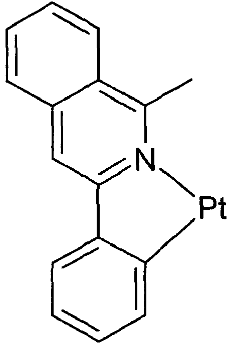 |
| (43) | (44) |
| 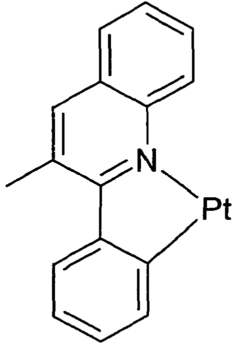 | 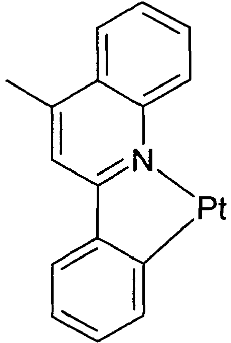 |
| (45) | (46) |
| 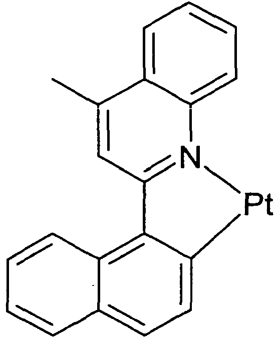 | 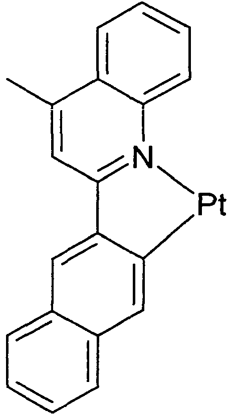 |
| (47) | (48) |
| 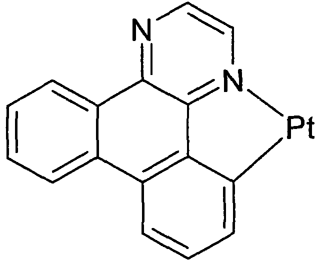 | 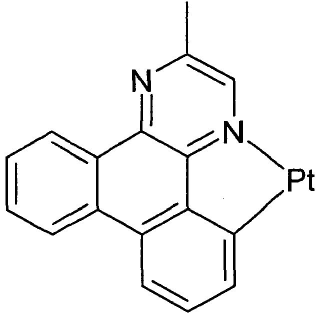 |
| (49) | (50) |
| 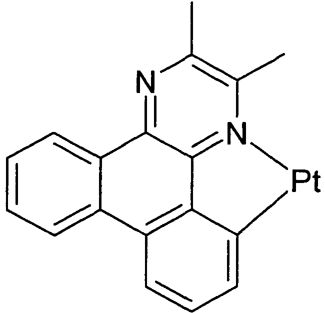 | 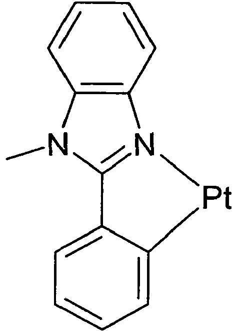 |
| (51) | (52) |
| 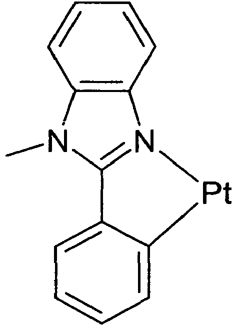 | 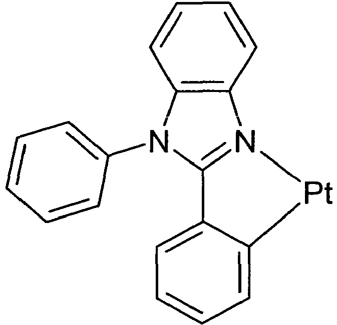 |
| (53) | (54) |
| 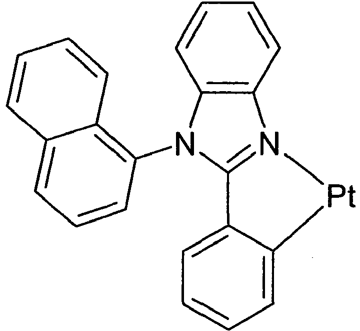 | 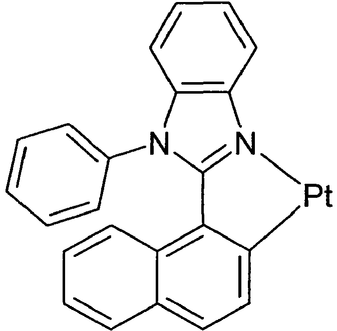 |
| (55) | (56) |
| 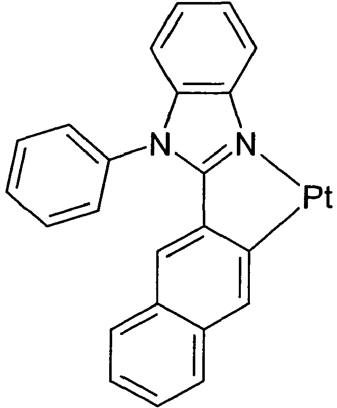 | 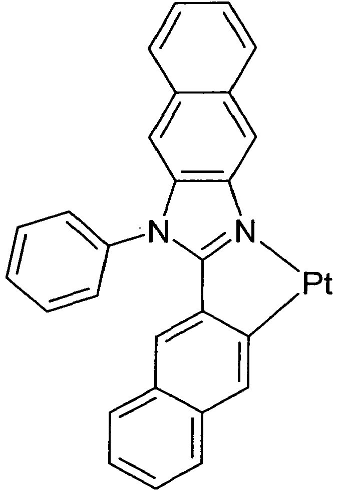 |
| (57) | (58) |
| 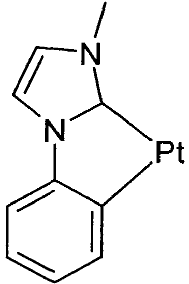 | 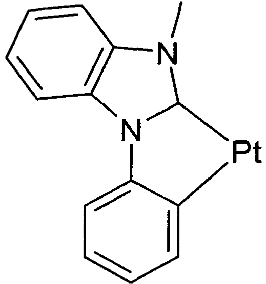 |
| (59) | (60) |
| 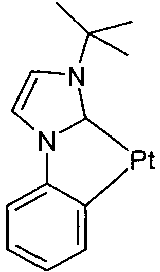 | 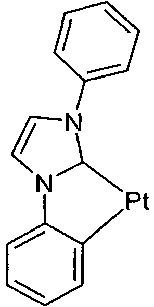 |
| (61) | (62) |
| 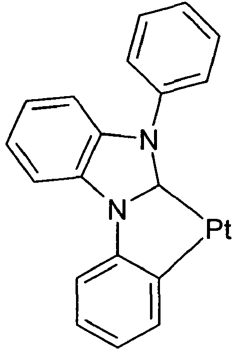 | 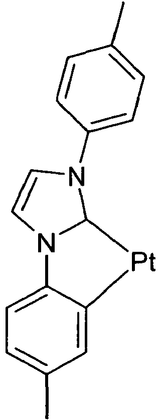 |
| (63) | (64) |
| 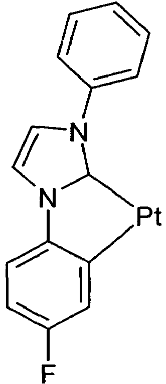 | 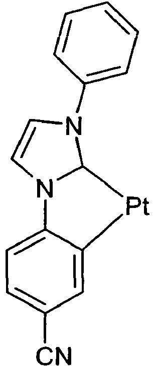 |
| (65) | (66) |
| 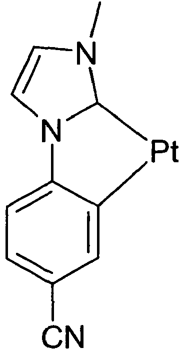 | 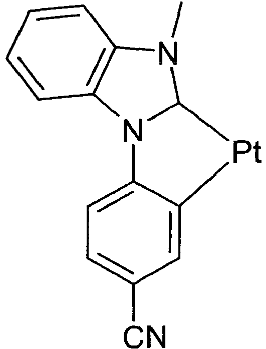 |
| (67) | (68) |
| 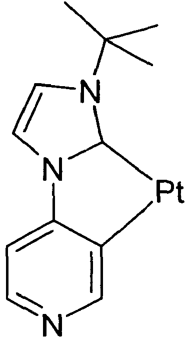 | 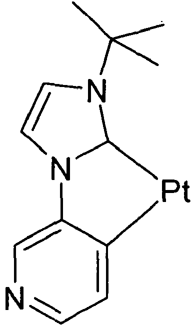 |
| (69) | (70) |
| 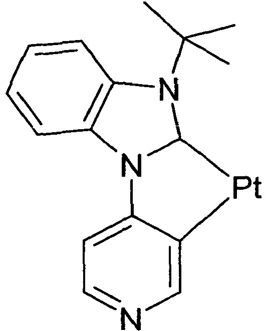 | 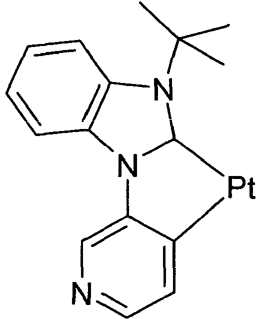 |
| (71) | (72) |
| 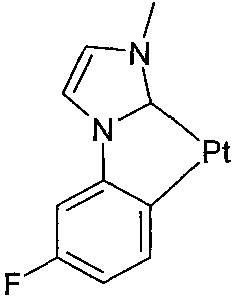 | 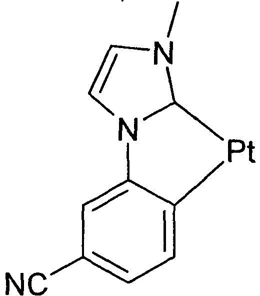 |
| (73) | (74) |
| 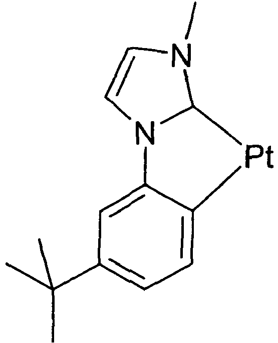 | 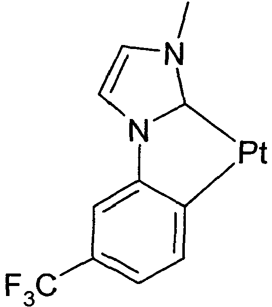 |
| (75) | (76) |

**Tabelle 3 Monokationische Ir(III)-Komplexfragmente**

| | |
|---|---|
| 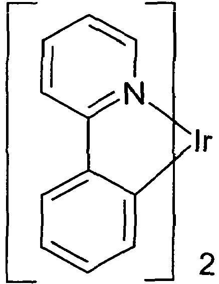 | 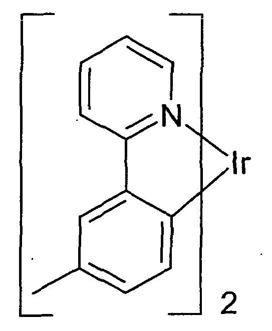 |
| (1) | (2) |
| 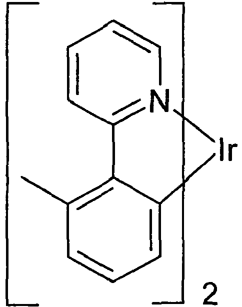 | 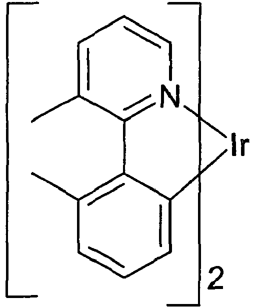 |
| (3) | (4) |
| 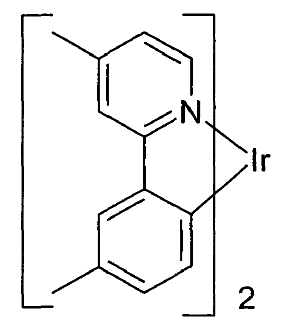 | 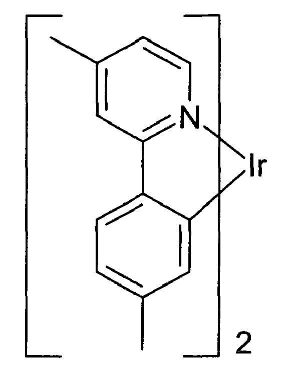 |
| (5) | (6) |
| 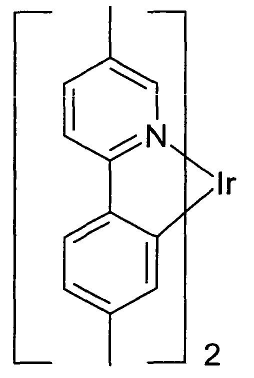 | 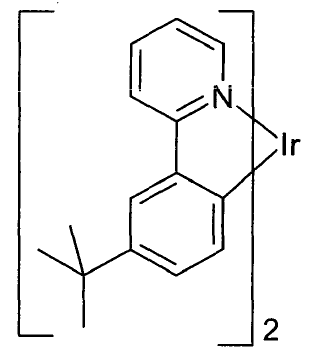 |
| (7) | (8) |
| 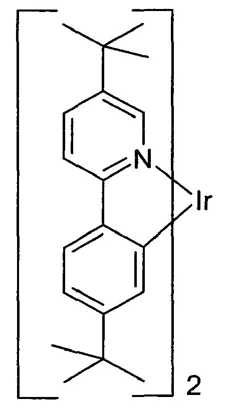 | 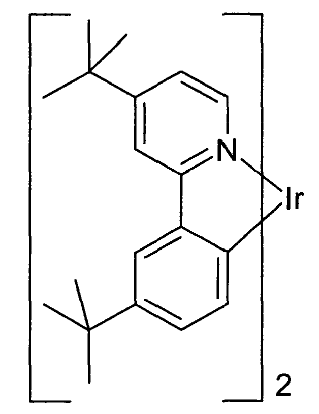 |
| (9) | (10) |
| 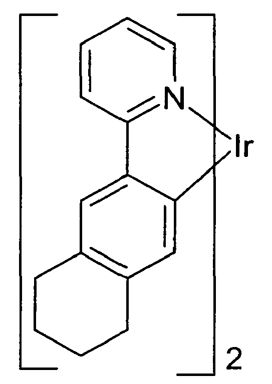 | 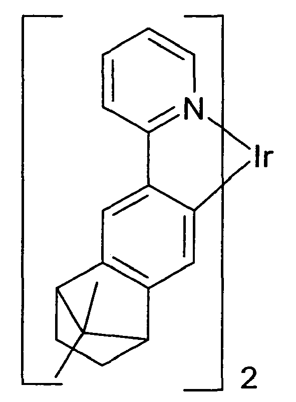 |
| (11) | (12) |
| 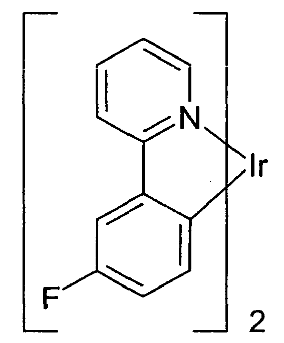 | 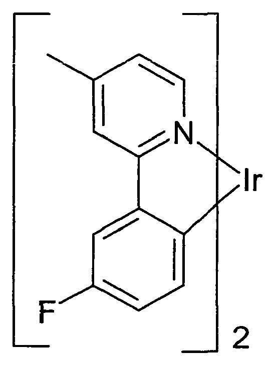 |
| (13) | (14) |
| 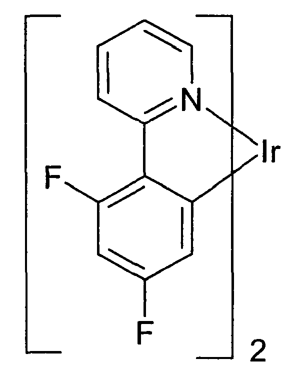 | 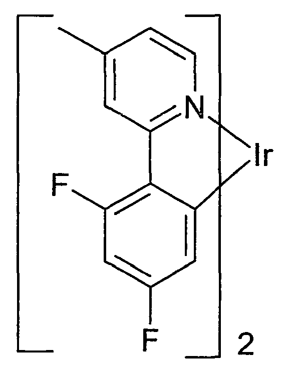 |
| (15) | (16) |
| 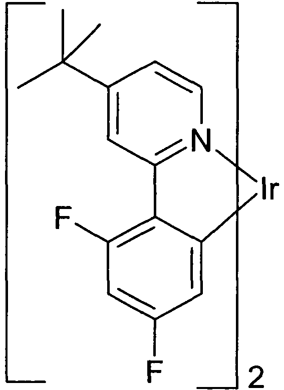 | 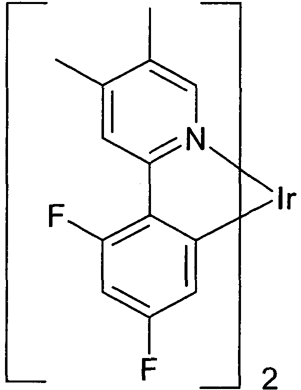 |
| (17) | (18) |
| 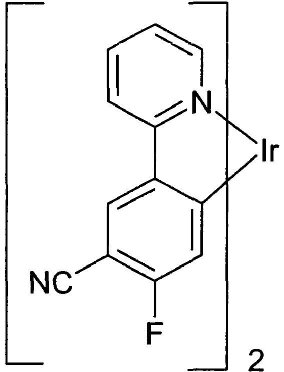 | 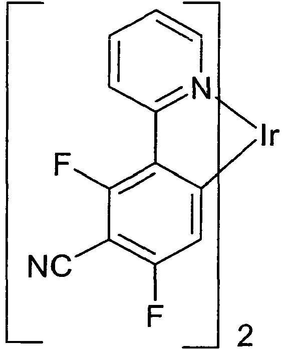 |
| (19) | (20) |
| 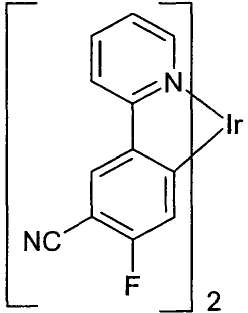 | 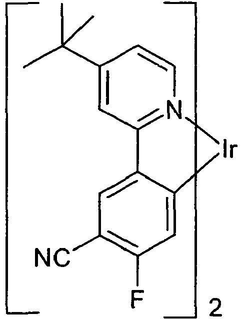 |
| (21) | (22) |
| 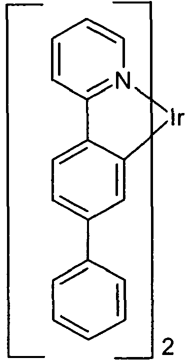 | 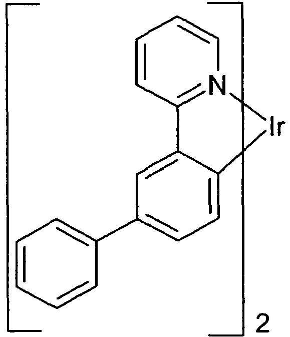 |
| (23) | (24) |
| 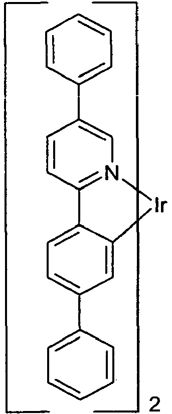 | 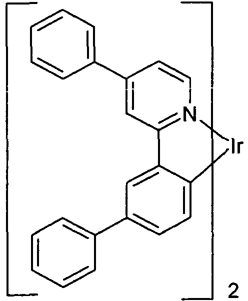 |
| (25) | (26) |
| 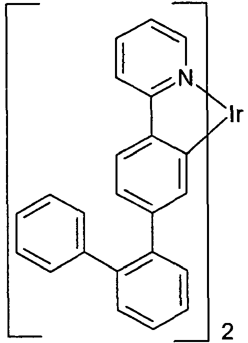 | 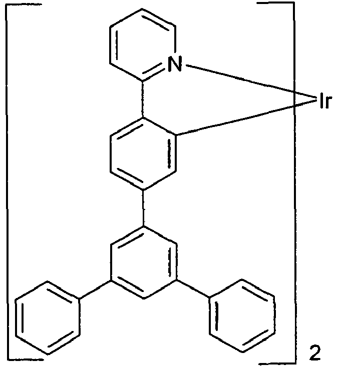 |
| (27) | (28) |
| 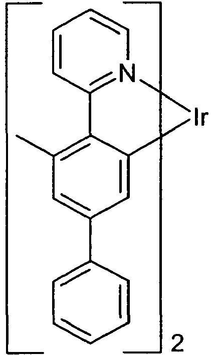 | 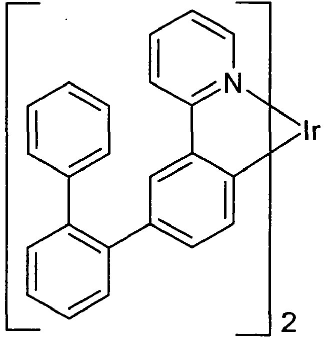 |
| (29) | (30) |
| 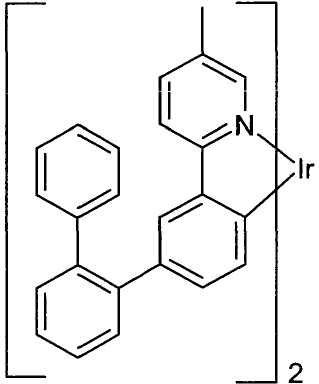 | 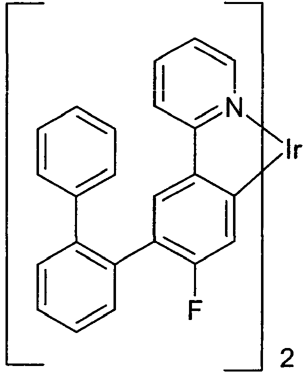 |
| (31) | (32) |
| 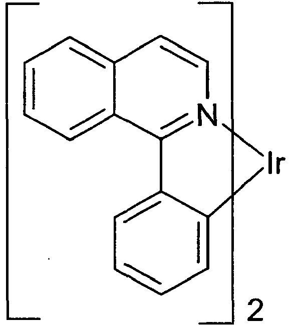 | 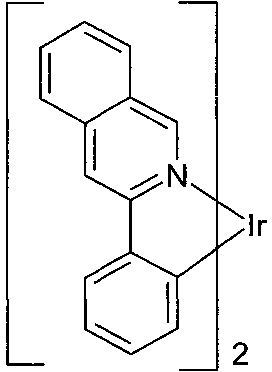 |
| (33) | (34) |
| 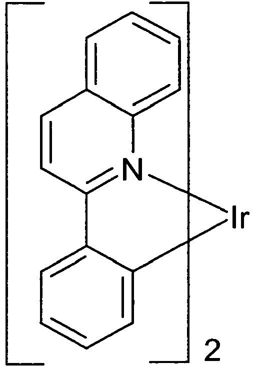 | 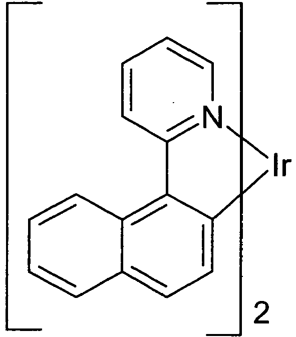 |
| (35) | (36) |
| 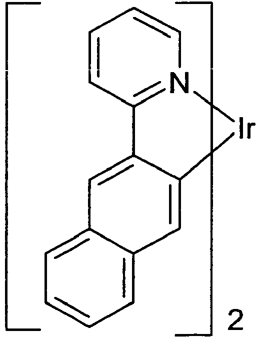 | 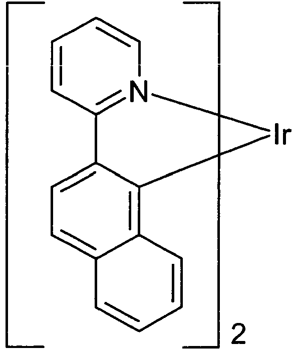 |
| (37) | (38) |
| 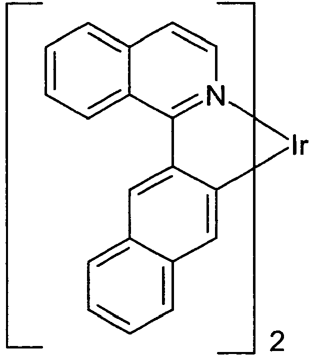 | 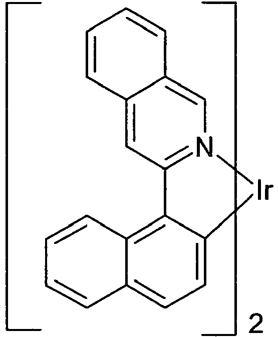 |
| (39) | (40) |
| 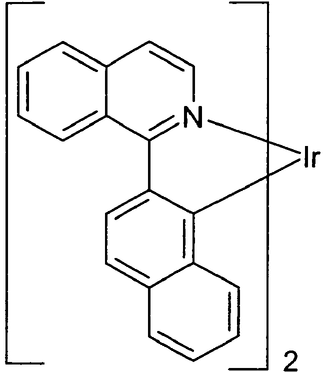 | 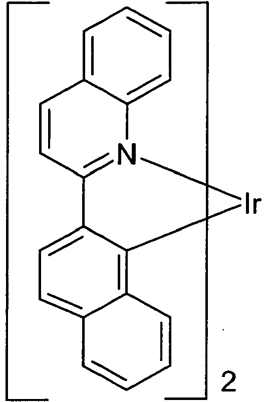 |
| (41) | (42) |
| 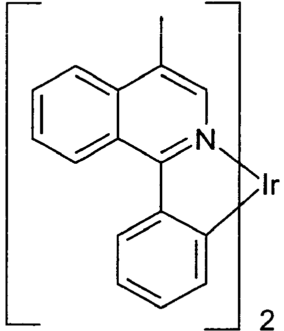 | 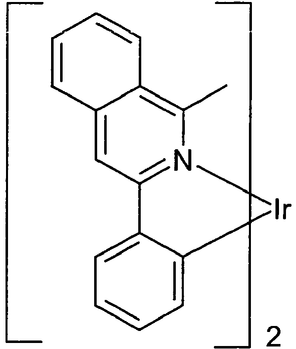 |
| (43) | (44) |
| 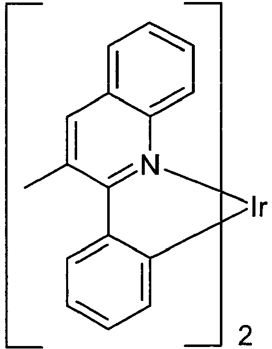 | 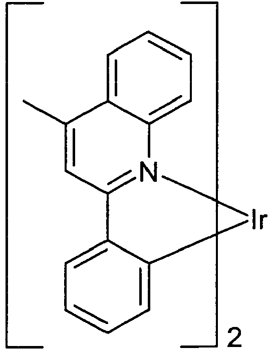 |
| (45) | (46) |
| 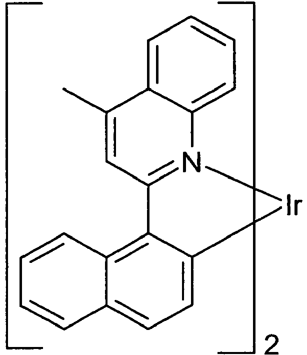 | 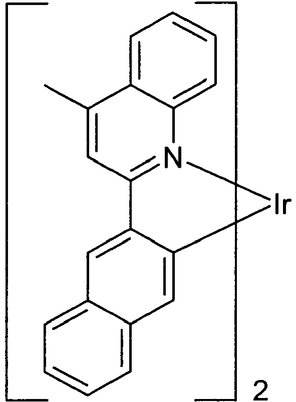 |
| (47) | (48) |
| 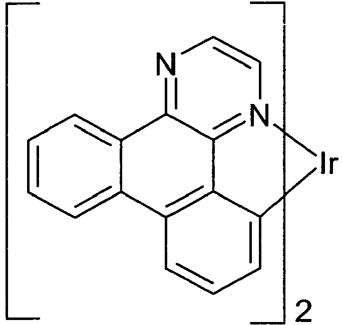 | 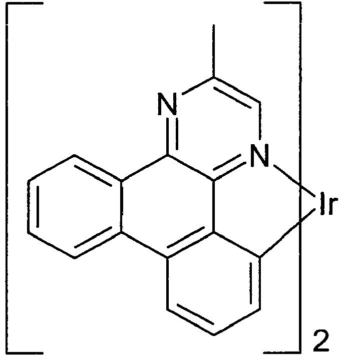 |
| (49) | (50) |
| 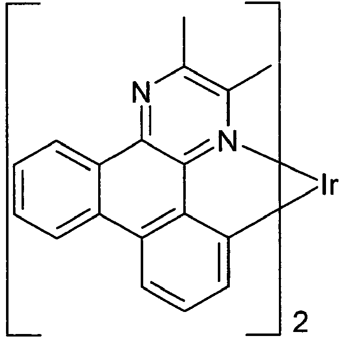 | 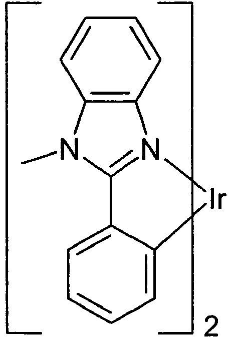 |
| (51) | (52) |
| 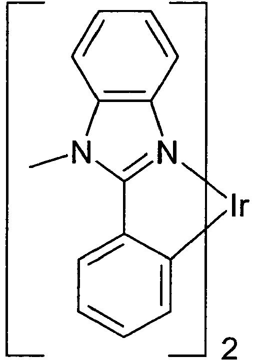 | 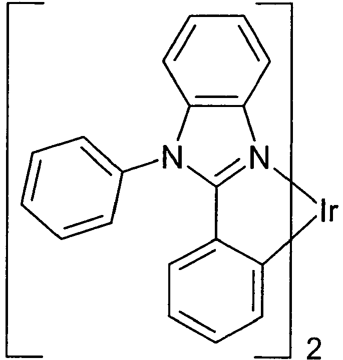 |
| (53) | (54) |
| 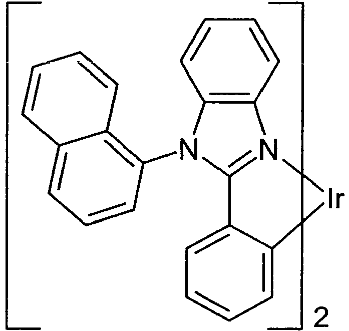 | 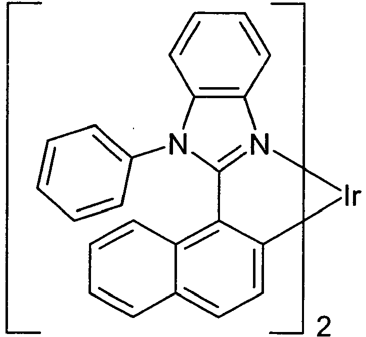 |
| (55) | (56) |
| 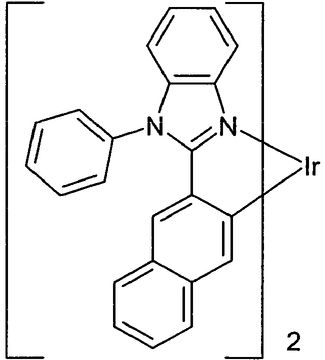 | 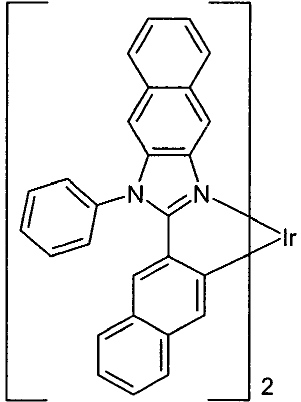 |
| (57) | (58) |
| 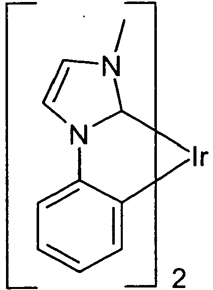 | 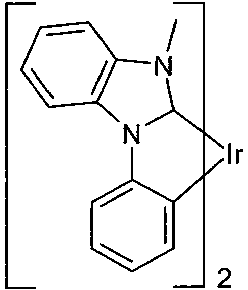 |
| (59) | (60) |
| 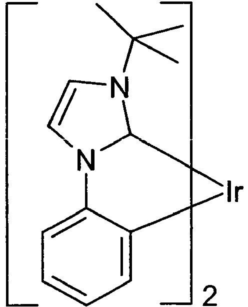 | 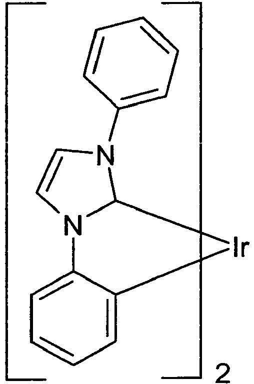 |
| (61) | (62) |
| 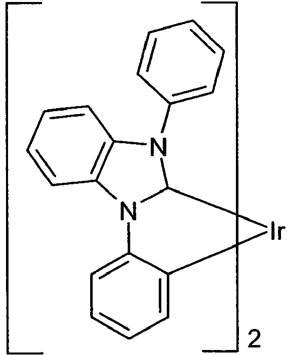 | 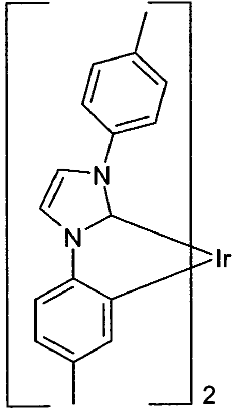 |
| (63) | (64) |
| 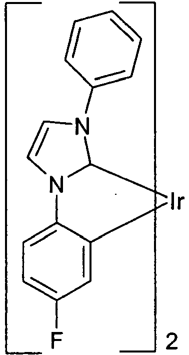 | 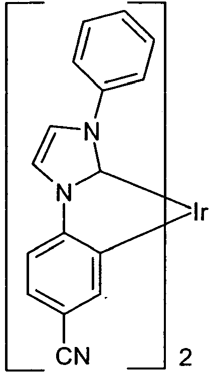 |
| (65) | (66) |
| 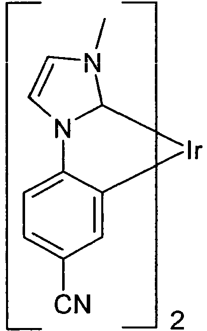 | 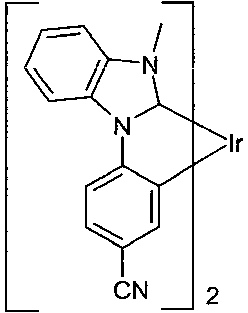 |
| (67) | (68) |
| 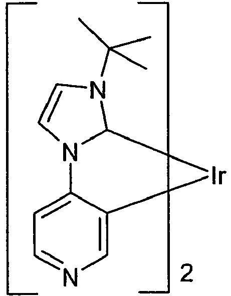 | 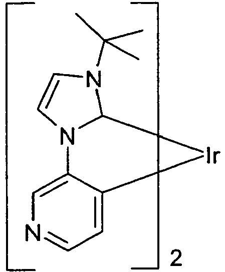 |
| (69) | (70) |
| 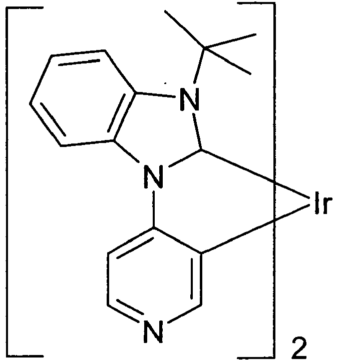 | 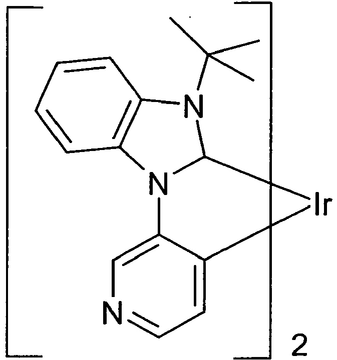 |
| (71) | (72) |
| 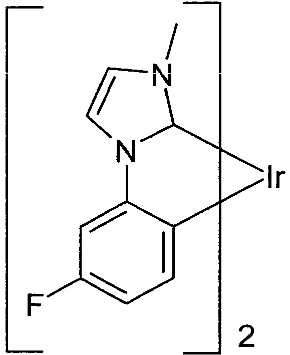 | 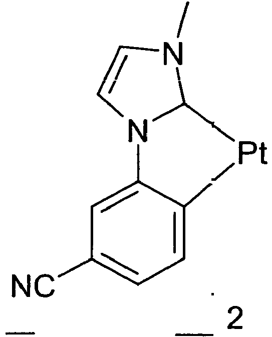 |
| (73) | (74) |
| 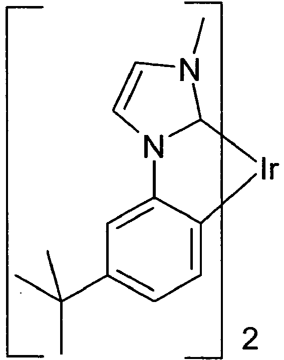 | 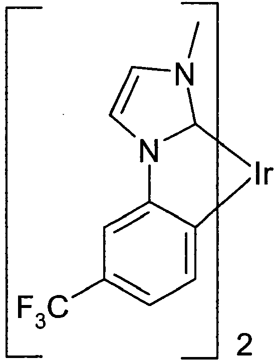 |
| (75) | (76) |

Für die Synthese von Metall-Komplexen mit Liganden der Formel (I), beispielsweise mit dem Liganden **7** (Figur 2), kann man diese Liganden in Form eines löslichen Salzes (z. B. mit N(C₄H₉)₄⁺ als Gegenion) verwenden (siehe Beispiel 3). Alternativ kann man von einem neutralen *closo-*Carboran-Diphosphan oder Diarsan B₁₀H₁₀C₂(ER₂)₂ 8 ausgehen (siehe Beispiele 1 und 2). **8a** (E = P, R = Ph) wurde bereits 1963 gemäß Gl. 1 aus dem 1,2-Carboran durch Umsetzung mit nBuLi und Ph₂PCl erhalten (R. P. Alexander, H. Schroeder, Inorg. Chem. 1963, 2, 1107).

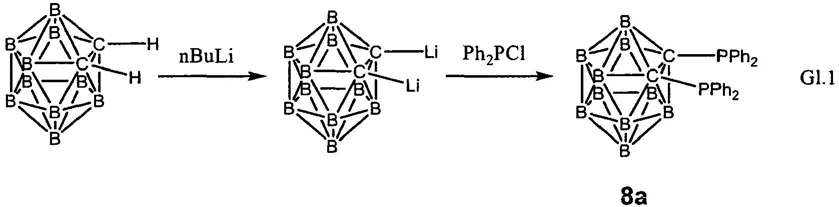

Die *closo*-Carboran-Einheit des *in situ* gebildeten Komplexes wird in alkoholischer Lösung zum *nido*-Carboran deboroniert. Dieser Syntheseweg ist besonders wichtig für Komplexe mit denjenigen Liganden **7** B₉H₁₀C₂(ER₂)₂, die als freie Liganden nicht bzw. nur schwer synthetisiert werden können (z. B. Liganden mit R = CₙH₂ₙ₊₁) (F. Teixidor, C. Vinas, M. M. Abad, R. Nunez, R. Kivekas, R. Sillanpäa, J. Organomet. Chem., 1995, 503, 193). Neben den symmetrisch substituierten Biphosphan- und Biarsan-Carboranen sind auch unsymmetrisch substituierte Derivative, z. B. (B₁₀H₁₀C₂)(PR₂)(AsR₂) zugänglich. Bei der Synthese solcher Verbindungen ist die Verwendung von Schutzgruppen notwendig. Für den Schutz der C-H Funktion in Carboranen können z. B. Halogenalkylsilane verwendet werden (F. A. Gomez, S. E. Johnson, M. F. Hawthorne, J. Am. Chem. Soc., 1991, 113, 5915.).

Diese Liganden lassen sich nach Standardverfahren in die Metallkomplexe einführen, wie sie dem Fachmann in metallorganischer Chemie geläufig sind. So lassen sich diese Liganden beispielsweise in Iridiumkomplexe einführen, indem das Chloro-verbrückte Dimer, z. B. [(ppy)₂IrCl]₂ (mit ppy = 2-Phenylpyridin) mit dem Liganden der Formel (I) umgesetzt wird.

Die oben beschriebenen Komplexe enthaltend einen Liganden der Formel (I), insbesondere Komplexe gemäß Formel (II) bzw. Formel (III) bis (VI) bzw. die oben aufgeführten bevorzugten Ausführungsformen werden in der organischen elektronischen Vorrichtung als aktive Komponente verwendet. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien. Für diese Funktionen zeigen die erfindungsgemäßen Verbindungen besonders gute Eigenschaften, insbesondere als Emissionsmaterial in organischen Elektrolumineszenzvorrichtungen, wie im Folgenden noch näher ausgeführt wird. Eine bevorzugte Ausführungsform der Erfindung sind daher organische Elektrolumineszenzvorrichtungen.

Die Funktionsweise einer Ausführungsform des erfindungsgemäßen Einsatzes der Metallkomplexe in einer Licht emittierenden Vorrichtung ist schematisch in Figur 1 gezeigt. Die Vorrichtung umfasst mindestens eine Anode, eine Kathode und eine Emitterschicht. Vorteilhafterweise wird eine oder beide der als Kathode oder Anode verwendeten Elektroden transparent ausgestaltet, sodass das Licht durch diese Elektrode emittiert werden kann. Bevorzugt wird als transparentes Elektrodenmaterial Indium-Zinn-Oxid (ITO) verwendet. Besonders bevorzugt wird eine transparente Anode eingesetzt. Die andere Elektrode kann ebenfalls aus einem transparenten Material ausgebildet sein, kann aber auch aus einem anderen Material mit geeigneter Elektronenaustrittsarbeit gebildet sein, falls Licht nur durch eine der beiden Elektroden emittiert werden soll. Vorzugsweise besteht die zweite Elektrode, insbesondere die Kathode, aus einem Metall mit hoher elektrischer Leitfähigkeit, beispielsweise aus Aluminium, oder Silber, oder einer Mg/Ag-oder einer Ca/Ag-Legierung. Zwischen den beiden Elektroden ist eine Emitterschicht angeordnet. Diese kann in direktem Kontakt mit der Anode und der Kathode sein, oder in indirektem Kontakt, wobei indirekter Kontakt bedeutet, dass zwischen der Kathode oder Anode und der Emitterschicht weitere Schichten enthalten sind, sodass die Emitterschicht und die Anode oder/und Kathode sich nicht berühren, sondern über weitere Zwischenschichten elektrisch miteinander in Kontakt stehen. Bei Anlegen einer Spannung, beispielsweise einer Spannung von 2 - 20 V, insbesondere von 3 - 10 V, treten aus der Kathode, beispielsweise einer leitenden Metallschicht, besonders bevorzugt aus einer Aluminium-Kathode negativ geladene Elektronen aus in eine dünne Elektronen-Leitungsschicht und wandern in Richtung der positiven Anode. Von dieser Anode ihrerseits aus wandern positive Ladungsträger, sogenannte Löcher, in eine organische Lochtransportschicht in Richtung der Kathode. Diese Löcher bewegen sich im Vergleich zu den Elektronen in entgegengesetzter Richtung, und zwar auf die negative Kathode zu. In einer zwischen der Kathode und Anode angeordneten Emitterschicht, die vorzugsweise ebenfalls aus einem organischen Material besteht, befinden sich erfindungsgemäß metallorganische Komplexe mit Hilfsliganden der Formel (I) als Emitter-Moleküle. An den Emitter-Molekülen oder in deren Nähe rekombinieren die wandernden Ladungsträger, also ein negativ geladenes Elektron und ein positiv geladenes Loch, und führen dabei zu neutralen, aber energetisch angeregten Zuständen der Emitter-Moleküle. Die angeregten Zustände der Emitter-Moleküle geben dann die Energie als Lichtemission ab. Die Emitterschicht kann auch identisch mit der Loch- oder/und Elektronentransportschicht sein, wenn sich die Emittermoleküle in diesen Schichten befinden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Excitonenblockierschichten, Ladungserzeugungsschichten und/oder organische oder anorganische p/n-Übergänge. Ebenso können zwischen zwei emittierende Schichten Interlayers eingebracht sein, welche beispielsweise eine Excitonen-blockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten, wobei mindestens eine emittierende Schicht mindestens einen Metallkomplex mit einem Liganden der Formel (I) enthält. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013).

In einer bevorzugten Ausführungsform der Erfindung enthält die organische elektronische Vorrichtung den Metallkomplex mit dem Liganden der Formel (I) bzw. die oben aufgeführten bevorzugten Ausführungsformen als emittierende Verbindung in einer emittierenden Schicht. Dies ist insbesondere dann der Fall, wenn das Metall M ein Übergangsmetall ist, insbesondere Iridium oder Platin, oder Lanthanide.

Wenn der Metallkomplex mit einem Liganden der Formel (I) bzw. der Komplex der Formel (II) als emittierende Verbindung in einer emittierenden Schicht eingesetzt wird, wird er bevorzugt in Kombination mit einem oder mehreren Matrixmaterialien eingesetzt. Der Metallkomplex kann aber auch als Reinschicht eingesetzt werden. Die Mischung aus dem Metallkomplex und dem Matrixmaterial enthält zwischen 0,1 und 99 Gew.-%, vorzugsweise zwischen 2 und 90 Gew.-%, besonders bevorzugt zwischen 3 und 40 Gew.-%, insbesondere zwischen 5 und 15 Gew.-% des Metallkomplexes bezogen auf die Gesamtmischung aus Emitter und Matrix-material. Entsprechend enthält die Mischung zwischen 99 und 1 Gew.-%, vorzugsweise zwischen 98 und 10 Gew.-%, besonders bevorzugt zwischen 97 und 60 Gew.-%, insbesondere zwischen 95 und 85 Gew.-% des Matrixmaterials bezogen auf die Gesamtmischung aus Emitter und Matrix-material.

Bevorzugte Matrixmaterialien sind CBP (N,N-Biscarbazolylbiphenyl), Carbazolderivate (z. B. gemäß WO 05/039246, US 2005/0069729, JP 2004/288381, EP 1205527 oder der nicht offen gelegten Anmeldung DE 102007002714.3), PVK (Polyvinylcarbazol), Azacarbazole (z. B. gemäß EP 1617710, EP 1617711, EP 1731584, JP 2005/347160), Ketone (z. B. gemäß WO 04/093207), Phosphinoxide, Sulfoxide und Sulfone (z. B. gemäß WO 05/003253), Oligophenylene, aromatische Amine (z. B. gemäß US 2005/0069729), bipolare Matrixmaterialien (z. B. gemäß WO 07/137725), Silane (z. B. gemäß WO 05/111172), Azaborole oder Boronester (z. B. gemäß WO 06/117052).

Es wurde festgestellt, dass durch den erfindungsgemäßen Einsatz von Metallkomplexen, umfassend einen Hilfsliganden der Formel (I) in der Emitterschicht Licht emittierende Vorrichtungen erhalten werden können, die hervorragende Eigenschaften aufweisen. Insbesondere zeigen die erfindungsgemäß eingesetzten Metallkomplexe hohe Emissions-Quantenausbeuten. Die Komplexe können zudem durch Substitution oder/und Veränderung der Liganden variiert werden, wodurch sich vielfältige Möglichkeiten zur Modifizierung bzw. Steuerung der Emissionseigenschaften ergeben. Durch geeignete Wahl der Liganden können zudem Verbindungen mit hoher Sublimierbarkeit erhalten werden.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Diese Verfahren sind dem Fachmann generell bekannt und können von ihm ohne Probleme auf organische Elektrolumineszenzvorrichtungen enthaltend Metallkomplexe mit Liganden der Formel (I) bzw. die oben aufgeführten bevorzugten Metallkomplexe angewandt werden.

Die erfindungsgemäßen Licht emittierenden Vorrichtungen können beispielsweise mittels der Vakuum-Sublimations-Technik gefertigt werden und mehrere weitere Schichten enthalten, insbesondere eine Elektroneninjektionsschicht und eine Elektronentransportschicht (z. B. Alq₃ = Aluminium-8-hydroxychinolin oder BAlq = Aluminium-bis(2-methyl-8-hydroxychinolato)-4-phenylphenolat) und/oder eine Lochinjektions- (z. B. CuPc = Kupfer-Phthalocyanin) und/oder Lochtransportschicht (z. B. α-NPD = 4,4'-Bis[N-(1-naphthyl)-N-phenylamino)biphenyl]). Es ist aber auch möglich, dass die Emitterschicht Funktionen der Loch- bzw. Elektronentransportschicht übernimmt.

Die Emitterschicht besteht vorzugsweise aus einem organischen Matrix-material mit ausreichend großem Singulett S₀ - Triplett T₁-Energieabstand (Matrix-Material), z. B. aus UGH (ultra high energy gap hosts), CBP (4,4'-Bis(9-carbazolyl)biphenyl) oder anderen Matrixmaterialien. In dieses Matrixmaterial wird der Emitterkomplex eindotiert, z. B. bevorzugt mit 0,1 bis 100, insbesondere mit 1 bis 20 Gewichtsprozent. Die Emitterschicht kann auch ohne Matrix realisiert werden, indem der entsprechende Komplex als 100%-Material aufgebracht wird.

In einer besonders bevorzugten Ausführungsform weist die erfindungsgemäße Licht emittierende Vorrichtung zwischen der Kathode und der Emitterschicht oder einer Elektronentransportschicht noch eine Elektroneninjektionsschicht, z. B. aus CsF oder LiF, als Zwischenschicht auf. Diese Schicht weist insbesondere eine Dicke von 0,5 nm bis 2 nm, bevorzugt von ca. 1 nm auf. Diese Zwischenschicht bewirkt vorwiegend eine Reduzierung der Elektronenaustrittsarbeit.

Weiterhin bevorzugt wird die lichtemittierende Vorrichtung auf einem Substrat aufgebracht, beispielsweise auf einem Glassubstrat.

Zum Beispiel lassen sich in einem typischen OLED-Schichtaufbau, bestehend aus einer ITO-Anode, einem Lochleiter, z. B. aus PEDOT/PSS, der erfindungsgemäßen Emitterschicht, gegebenenfalls einer Lochblockierschicht, einer Elektronentransportschicht, einer dünnen LiF- oder CsF-Zwischenschicht zur Verbesserung der Elektroneninjektion sowie einer Metall-Elektrode (Kathode) gute Leistungseffizienzen erzielen. Diese verschiedenen Schichten mit einer Gesamtdicke von einigen 100 nm lassen sich z. B. auf einem Glassubstrat oder einem sonstigen Trägermaterial aufbringen.

Das OLED-Device kann auch teils nass-chemisch gefertigt werden, und zwar zum Beispiel gemäß folgendem Aufbau: Glassubstrat, durchsichtige ITO-Schicht (aus Indium-Zinn-Oxid), z. B. PEDOT/PSS (Polyethylendioxythiophen/ Polystyrolsulfonsäure, z. B. 40 nm) oder andere, die Lochinjektion verbessernde Schichten, 100 % erfindungsgemäßer Komplex (z. B. 10 bis 80 nm) oder eindotiert (z. B. insbesondere 1 % bis 20 %) in eine geeignete Matrix, bspw. PVK (z. B. 40 nm), eine aufgedampfte Elektronentransportschicht, z. B. aus Alq₃ (z. B. 40 nm), aufgedampftes LiF oder CsF als Schutzschicht (z. B. 0,8 nm), aufgedampfte Metallkathode Al oder Ag oder Mg/Ag (z. B. 200 nm).

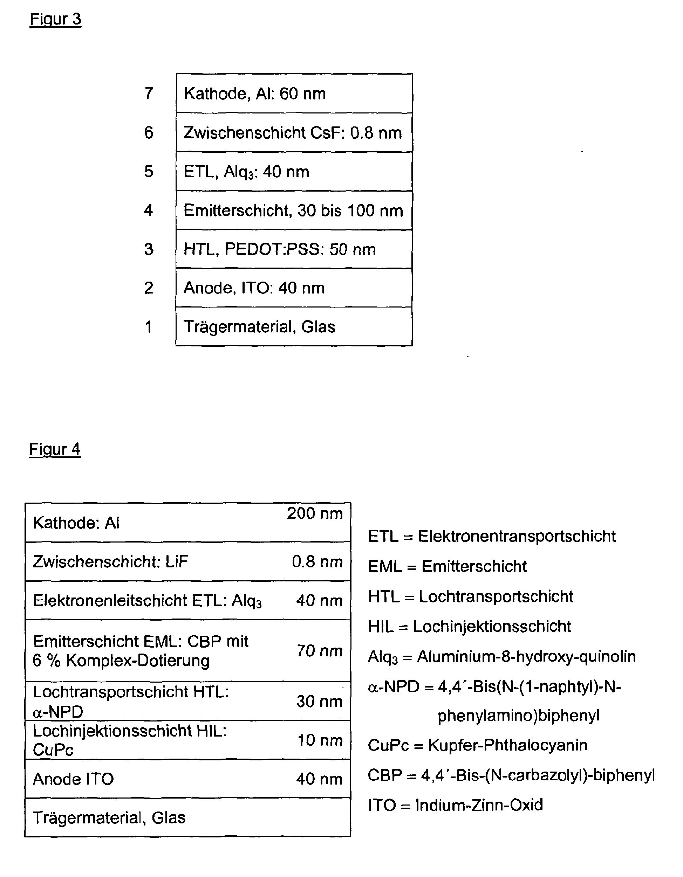

Besonders bevorzugt weist ein OLED-Aufbau für einen löslichen, erfindungsgemäßen Emitter die im Folgenden beschriebene und in Figur 3 dargestellte Struktur auf, umfasst aber wenigstens eine, mehr bevorzugt wenigstens zwei und am meisten bevorzugt alle der nachfolgend genannten Schichten.

Die Vorrichtung wird vorzugsweise auf ein Trägermaterial aufgebracht, insbesondere auf Glas oder ein anderes festes oder flexibles durchsichtiges Material. Auf das Trägermaterial wird eine Anode aufgebracht, beispielsweise eine Indium-Zinn-Oxid-Anode (ITO). Die Schichtdicke der Anode beträgt vorzugsweise 10 nm bis 100 nm, insbesondere 30 bis 50 nm. Auf die Anode und zwischen Anode und Emitterschicht wird eine HTL-Schicht aus einem Lochtransportmaterial aufgebracht, insbesondere aus einem Lochtransportmaterial, welches wasserlöslich ist. Ein solches Lochtransportmaterial sind beispielsweise PEDOT/PSS (Polyethylendioxythiophen/Polystyrolsulfonsäure) oder neue HTL-Materialien (Fa. DuPont) zur Verlängerung der Device-Lebensdauer. Die Schichtdicke der HTL-Schicht beträgt vorzugsweise 10 bis 100 nm, insbesondere 40 bis 60 nm. Als nächstes wird die Emitterschicht (EML) aufgebracht, welche einen erfindungsgemäßen löslichen Emitter enthält. Das Material kann in einem Lösungsmittel, beispielsweise in Aceton, Dichlormethan, Toluol oder Acetonitril, gelöst werden. Dadurch kann ein Auflösen der darunter liegenden PEDOT/PSS-Schicht vermieden werden. Das erfindungsgemäße Emittermaterial kann in geringer Konzentration, z. B. 0,1 bis 30 Gew.-%, aber auch in höherer Konzentration oder als 100 %-Schicht eingesetzt werden. Bevorzugt werden Metallkomplexe in einer Konzentration eingebracht, die eine Triplett-Triplett-Annihilation verhindert oder stark einschränkt, insbesondere in einer Konzentration von insgesamt größer 1 Gew.-% und kleiner 20 Gew.-%. Es ist auch möglich, das Emittermaterial hoch- oder mitteldotiert in einer geeigneten Polymerschicht (z. B. PVK = Poly-(N-vinylcarbazol)) aufzubringen. Für schlecht lösliche, erfindungsgemäße Emittermaterialien kann das Auftragen durch eine kolloidale Suspension in einem Polymer durchgeführt werden. Die Emitterschicht weist vorzugsweise eine Schichtdicke von 10 bis 150 nm, insbesondere von 30 bis 100 nm auf. Auf die Emitterschicht wird vorzugsweise eine Schicht aus Elektronentransportmaterial aufgebracht, insbesondere mit einer Schichtdicke von 10 bis 80 nm, mehr bevorzugt von 30 bis 50 nm. Ein geeignetes Material für die Elektronentransportmaterialschicht (ETL) ist beispielsweise Alq₃, LiQ (ggf. in Kombination mit einem Benzimidazol-Derivat) oder ein Benzimidazolderivat, welches aufdampfbar ist. Als Nächstes wird vorzugsweise eine dünne Zwischenschicht aufgebracht, welche die Elektroneninjektionsbarriere verringert und die ETL-Schicht schützt. Diese Schicht weist vorzugsweise eine Dicke zwischen 0,1 und 2 nm, insbesondere zwischen 0,5 und 1,5 nm auf und besteht vorzugsweise aus CsF oder LiF. Diese Schicht wird in der Regel aufgedampft. Für einen weiter vereinfachten OLED-Aufbau können gegebenenfalls die ETL und/ oder die Zwischenschicht entfallen. Schließlich wird eine leitende Kathodenschicht aufgebracht, insbesondere aufgedampft. Die Kathodenschicht besteht vorzugsweise aus einem Metall, insbesondere aus Al oder Mg/Ag (insbesondere im Verhältnis 10 : 1).

An die Vorrichtung werden vorzugsweise Spannungen von 3 bis 10 V angelegt.

In einer bevorzugten Ausführungsform umfasst ein OLED-Aufbau für einen sublimierbaren erfindungsgemäßen Emitter neben einer Anode, Emitterschicht und Kathode auch noch wenigstens eine, insbesondere mehrere und besonders bevorzugt alle der nachfolgend genannten und in Figur 4 dargestellten Schichten.

Der gesamte Aufbau befindet sich vorzugsweise auf einem Trägermaterial, wobei hierfür insbesondere Glas oder jedes andere feste oder flexible durchsichtige Material eingesetzt werden kann. Auf dem Trägermaterial wird die Anode angeordnet, beispielsweise eine Indium-Zinn-Oxid-Anode (ITO). Auf die Anode und zwischen Emitterschicht und Anode wird eine Lochtransportschicht (HTL, hole transport layer) angeordnet, beispielsweise α-NPD. Die Dicke der Lochtransportschicht beträgt vorzugsweise 10 bis 100 nm, insbesondere 30 bis 50 nm. Zwischen der Anode und der Lochtransportschicht können weitere Schichten angeordnet sein, die die Lochinjektion verbessern, z. B. eine Kupfer-Phthalocyanin (CuPc)-Schicht. Diese Schicht ist bevorzugt 5 bis 50, insbesondere 8 bis 15 nm dick. Auf die Lochtransportschicht und zwischen Lochtransport- und Emitterschicht wird vorzugsweise eine Elektronenblockierschicht aufgetragen, die dafür sorgt, dass der Elektronentransport zur Anode unterbunden wird, da ein solcher Strom Ohm'sche Verluste verursachen würde. Die Dicke dieser Elektronenblockierschicht beträgt vorzugsweise 10 bis 100 nm, insbesondere 20 bis 40 nm. Auf diese zusätzliche Schicht kann insbesondere dann verzichtet werden, wenn die HTL-Schicht bereits intrinsisch ein schlechter Elektronenleiter ist.

Bei der nächsten Schicht handelt es sich um die Emitterschicht, die das erfindungsgemäße Emittermaterial enthält oder aus diesem besteht. In der Ausführungsform unter Verwendung von sublimierbaren Emittern werden die Emittermaterialien bevorzugt durch Sublimation aufgetragen. Die Schichtdicke beträgt vorzugsweise zwischen 10 nm und 150 nm, insbesondere zwischen 30 nm und 100 nm. Das erfindungsgemäße Emittermaterial kann auch gemeinsam mit anderen Materialien, insbesondere mit Matrixmaterialien koverdampft werden. Für im Grünen oder Roten emittierende erfindungsgemäße Emittermaterialien eignen sich gängige Matrixmaterialien wie CBP (4,4'-Bis-(N-carbazolyl)-biphenyl) oder andere Matrixmaterialien, z. B. solche, wie sie oben aufgezählt sind. Es ist aber auch möglich, eine 100 %-Emittermaterial-Schicht aufzubauen. Für im Blauen emittierende erfindungsgemäße Emittermaterialien werden vorzugsweise UHG-Matrixmaterialien eingesetzt (vgl. M.E. Thompson et al., Chem. Mater. 2004, 16, 4743) oder andere Materialien mit ausreichendem S₀-T₁-Energieabstand sowie passender Loch-und Elektronen-Beweglichkeit. Zur Erzeugung von mischfarbigem Licht (z. B. von weißem Licht) bei der Verwendung von erfindungsgemäßen Verbindungen mit verschiedenen Metall-Zentralionen kann ebenfalls eine Koverdampfung angewendet werden.

Grundsätzlich können erfindungsgemäß gängige Matrixmaterialien für OLEDs, aber auch weitgehend inerte Polymere bzw. kleine Matrixmoleküle ohne besonders ausgeprägte Loch- oder Elektronenmobilitäten als Matrixmaterialien eingesetzt werden, wenn für geeignete Dotierungen zur Erzeugung ausreichender Ladungsträgermobilitäten gesorgt wird.

Auf die Emitterschicht wird vorzugsweise eine Lochblockierschicht (HBL) aufgetragen, welche Ohm'sche Verluste reduziert, die durch Lochströme zur Kathode entstehen könnten. Diese Lochblockierschicht ist vorzugsweise 10 bis 50 nm, insbesondere 15 bis 25 nm dick. Ein geeignetes Material hierfür ist beispielsweise BCP (4,7-Diphenyl-2,9-dimethyl-phenanthrolin, auch Bathocuproin genannt). Auf die Lochblockierschicht und zwischen diese Schicht und die Kathode wird vorzugsweise eine ETL aus Elektronentransportmaterial (ETL = electron transport layer) aufgebracht. Vorzugsweise besteht diese Schicht aus aufdampfbarem Alq₃ oder einem anderen gängigen Elektronentransportmaterial, beispielsweise Benzimidazol-Derivate oder LiQ (Lithiumhydroxychinolinat) in Kombination mit Benzimidazol-Derivaten, mit einer Dicke von 10 bis 100 nm, insbesondere von 30 bis 50 nm. Zwischen die ETL und die Kathode wird vorzugsweise eine Zwischenschicht aufgebracht, beispielsweise aus CsF oder LiF. Diese Zwischenschicht verringert die Elektroneninjektionsbarriere und schützt die ETL. Diese Schicht wird in der Regel aufgedampft. Die Zwischenschicht ist vorzugsweise sehr dünn, insbesondere 0,2 bis 5 nm, mehr bevorzugt 0,5 bis 2 nm dick. Schließlich wird noch eine leitende Kathodenschicht aufgedampft, insbesondere mit einer Dicke von 50 bis 500 nm, mehr bevorzugt von 100 bis 250 nm. Die Kathodenschicht besteht vorzugsweise aus Al, Mg/Ag (insbesondere im Verhältnis 10 : 1) oder anderen Metallen. An den beschriebenen OLED-Aufbau für einen sublimierbaren erfindungsgemäßen Emitter werden vorzugsweise Spannungen zwischen 3 und 10 V angelegt.

Die oben beschriebenen bevorzugten Ausführungsformen für lichtemittierende opto-elektronische Vorrichtungen sind hermetisch verkapselt, um das Eindringen von Sauerstoff, Wasserdampf oder anderen Gasen oder Dämpfen zu vermeiden. In einer speziellen, erfindungsgemäßen Ausführungsform, dem Sensor-OLED, wird dagegen die hermetische Abkapselung ersetzt durch übliche, für definierte Gase durchlässige Verpackungen, um die Einflussnahme der entsprechenden Gase auf die Lichtemission (Farbveränderung, Intensitätsveränderung, Veränderung der Emissionsabklingszeit) als Nachweis für das jeweilige Gas zu detektieren.

Erfindungswesentlich ist, dass die organische elektronische Vorrichtungen, insbesondere die lichtemittierende Vorrichtung als Emitter wenigstens einen Komplex umfassend einen Hilfsliganden der Formel (I) enthält.

Erfindungsgemäß wurde nun festgestellt, dass Metall-Komplexe umfassend Hilfsliganden der Formel (I) hervorragend für opto-elektronische Anwendungen und insbesondere als Emitter-Moleküle für lichtemittierende Vorrichtungen und insbesondere für organische Licht emittierende Vorrichtungen (OLEDs) geeignet sind.

Erfindungsgemäß bevorzugt werden als Emitter-Moleküle Komplexe umfassend Hilfsliganden der Formel (I) eingesetzt. Bei diesen Komplexen handelt es sich insbesondere um lumineszierende oder elektrolumineszierende Verbindungen.

Die bevorzugten Komplexe der oben aufgeführten Formel (II), in denen y ungleich 0 ist und die eine direkte Metall-Kohlenstoff-Bindung vom Metall zum Liganden (A∩Aⁿ⁻) aufweisen, sind neu und sind daher ebenfalls ein Gegenstand der vorliegenden Erfindung. Es gelten die oben für die organische elektronische Vorrichtung aufgeführten Bevorzugungen.

Auch die Komplexe der oben aufgeführten Formeln (III), (IV), (V) und (VI) sind neu und sind daher ebenfalls ein Gegenstand der vorliegenden Erfindung. Es gelten auch hier die oben für die organische elektronische Vorrichtung aufgeführten Bevorzugungen.

Die Erfindung wird durch die beigefügten Figuren und die nachfolgenden Beispiele weiter erläutert, ohne sie dadurch einschränken zu wollen.
- **Figur 1**: zeigt eine schematische und vereinfachte Darstellung zur Funktionsweise einer OLEDs.
- **Figur 2**: zeigt die Strukturformel des erfindungsgemäßen Hilfsliganden der Formel (I), (E∩E), nämlich des zweizähnigen Liganden, der ein 7,8-Dicarba-*nido*-undekaboran-Gerüst (nido-Carboran-Gerüst) enthält; E steht für P, As, P=O oder As=O.
- **Figur 3**: zeigt ein Beispiel für eine OLED-Vorrichtung mit erfindungsgemäßen Emittern, die nass-chemisch aufgetragen werden.
- **Figuren 4 und 5**: zeigen Beispiele eines mittels Vakuum-Sublimation gefertigten OLED-Devices.
- **Figur 6**: zeigt die molekulare Struktur von Pt(ppy)(7a) im Kristall. Wasserstoffatome sind nicht dargestellt. In Kristallen von Pt(ppy)**(7a)** beträgt der kürzeste, intermolekulare Pt-Pt-Abstand 8.54 Å, d.h. jegliche Bildung von stapelartigen Agglomeraten (Anordnungen) wird durch den sperrigen Liganden **7a** verhindert.
- **Figur 7**: zeigt die molekulare Struktur von Pt(dfppy)**(7a)** im Kristall. Wasserstoffatome sind nicht dargestellt. In Kristallen von Pt(dFppy)**(7a)** beträgt der kürzeste, intermolekulare Pt-Pt Abstand 6.96 Å. Ähnlich wie im Fall Pt(ppy)**(7a)** und Pt(ppy)**(7b)** wird jegliche Bildung von stapelartigen Agglomeraten (Anordnungen) durch den sperrigen Liganden **7a** verhindert.
- **Figur 8**: zeigt die molekulare Struktur von Pt(ppy)**(7b)** im Kristall. Wasserstoffatome sind nicht dargestellt. In Kristallen von Pt(ppy)**(7b)** beträgt der kürzeste, intermolekulare Pt-Pt Abstand 7.86 Å, d.h. jegliche Bildung von stapelartigen Agglomeraten (Anordnungen) wird durch den sperrigen Liganden **7b** verhindert.
- **Figur 9**: zeigt molekulare Struktur von Cu(dpphen)**(7a)** im Kristall. Wasserstoffatome sind nicht dargestellt.
- **Figur 10**: zeigt die molekulare Struktur von Ir(ppy)₂(**7a**) im Kristall. Wasserstoffatome sind nicht dargestellt.
- **Figur 11**: zeigt die molekulare Struktur von Ir(dFppy)₂(**7a**) im Kristall. Wasserstoffatome sind nicht dargestellt.
- **Figur 12**: zeigt die Phosphoreszenz-Spektren von Pt(ppy)**(7a)** gemessen in 2-Methyltetrahydrofuran (mthf) bei T = 77 K, Polymethylmethacrylat (PMMA) bei 300 K und vom Feststoff (Festkörper) bei T = 300 K.
- **Figur 13**: zeigt die Phosphoreszenz-Spektren von Pt(dfppy)**(7a)** gemessen in 2-Methyltetrahydrofuran (mthf) bei T = 77 K. Polymethylmethacrylat (PMMA) bei 300 K und vom Feststoff (Festkörper) bei T = 300 K.
- **Figur 14**: zeigt die Phosphoreszenz-Spektren von Pt(ppy)**(7b)** gemessen in 2-Methyltetrahydrofuran (mthf) bei T = 77 K, Polymethylmethacrylat (PMMA) bei 300 K und vom Feststoff (Festkörper) bei T = 300 K.
- **Figur 15**: zeigt die Phosphoreszenz-Spektren von Pt(thpy)**(7a)** gemessen in 2-Methyltetrahydrofuran (mthf) bei T = 77 K, Polymethylmethacrylat (PMMA) bei 300 K und vom Feststoff (Festkörper) bei T = 300 K.
- **Figur 16**: zeigt die Phosphoreszenz-Spektren von [Cu(dpphen)**(7a)**] gemessen in Toluol bei T = 77 K und in Polymethylmethacrylat (PMMA) bei T = 300 K.
- **Figur 17**: zeigt die Phosphoreszenz-Spektren von Ir(ppy)₂(**7a**) gemessen in 2-Methyltetrahydrofuran (mthf) bei T = 77 K, Polymethylmethacrylat (PMMA) bei 300 K und vom Feststoff (Festkörper) bei T = 300 K.
- **Figur 18**: zeigt die Phosphoreszenz-Spektren von Ir(dfppy)₂(**7a**) gemessen 2-Methyl-tetrahydrofuran (mthf) bei T = 77 K, Polymethylmethacrylat (PMMA) bei 300 K und vom Feststoff (Festkörper) bei T = 300 K.

### Beispiele

Im Folgenden werden die Synthesen einiger erfindungsgemäßer Metallkomplexe beschrieben. Dabei werden die Iridium- und die Platinkomplexe in etwa 30-40 % Ausbeute und die Kupferkomplexe in 90 % Ausbeute erhalten. Die Reinheit aller Komplexe ist > 99,5 %.

### Beispiel 1 : Synthese von Pt(ppy)(7a)

Der Komplex Pt(ppy)(7a) wird durch Reaktion von Pt(ppy)(ppyH)Cl und 1,2-Bis-(diphenylphosphan)-*closo*-Carboran hergestellt (Gl. 2). Äquimolare Mengen an Pt(ppy)(ppyH)Cl und 1,2-bis(Diphenylphosphan)-*closo-*Carboran werden unter Argon 12 h in Ethanol unter Rückfluss erhitzt. Nach Abkühlen auf Raumtemperatur wird das aus dem Reaktionsgemisch ausgefallene rohe Produkt chromatographisch gereinigt (Al₂O₃, Hexan/ Dichloromethan). Die Reinigung erfolgt durch Kristallisation aus heißem Ethanol.

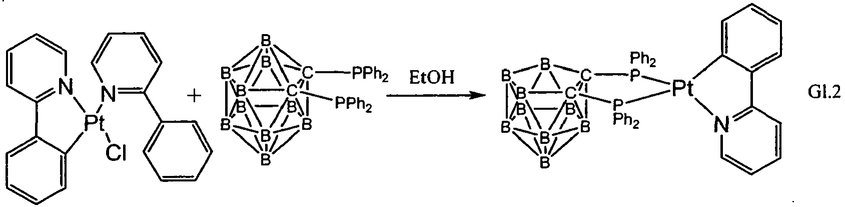

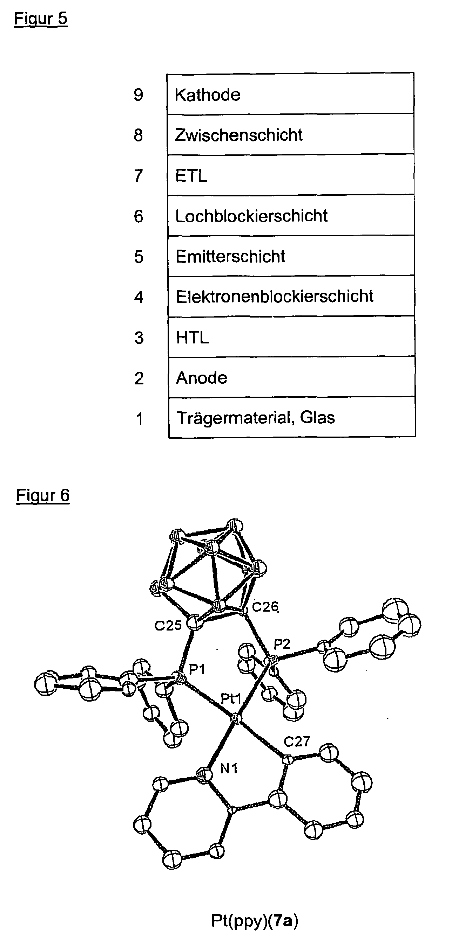

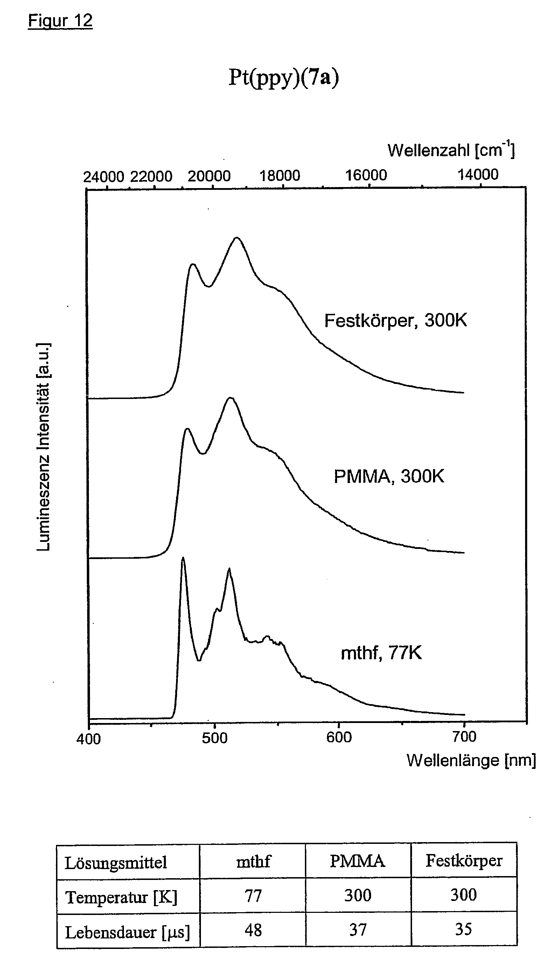

Die molekulare Struktur von Pt(ppy)(7a) im Kristall ist in Figur 6 abgebildet. Die Photolumineszenzspektren von Pt(ppy)**(7a)** sind in Figur 12 abgebildet.

### Beispiel 2: Synthese von Pt(dFppy)(7a)

Der Komplex Pt(dFppy) wird durch Reaktion von Pt(dFppy)(dFppyH)Cl und 1,2-Bis-(diphenylphosphan)-*closo*-Carboran hergestellt (Gl. 3). Eine Lösung aus äquimolaren Mengen von Pt(dFppy)(dFppyH)Cl und 1,2-Bis-(diphenylphosphan)-*closo*-Carboran wird unter Argon 12 h in refluxierendem Ethanol gerührt. Nach Abkühlung wird das aus dem Reaktionsgemisch ausgefallene rohe Produkt chromatographisch gereinigt (Al₂O₃, Hexan/Dichloromethan). Zusätzlich wird das Produkt aus heißem Ethanol umkristallisiert.

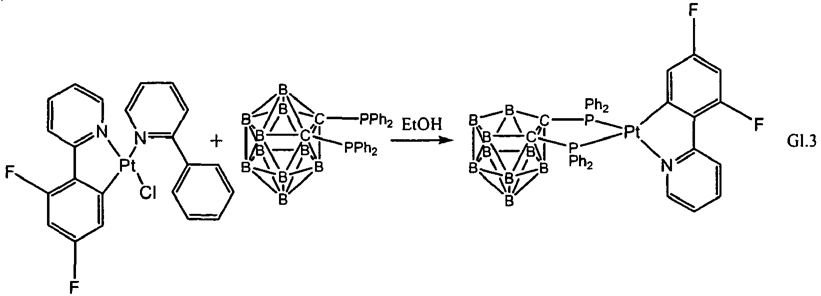

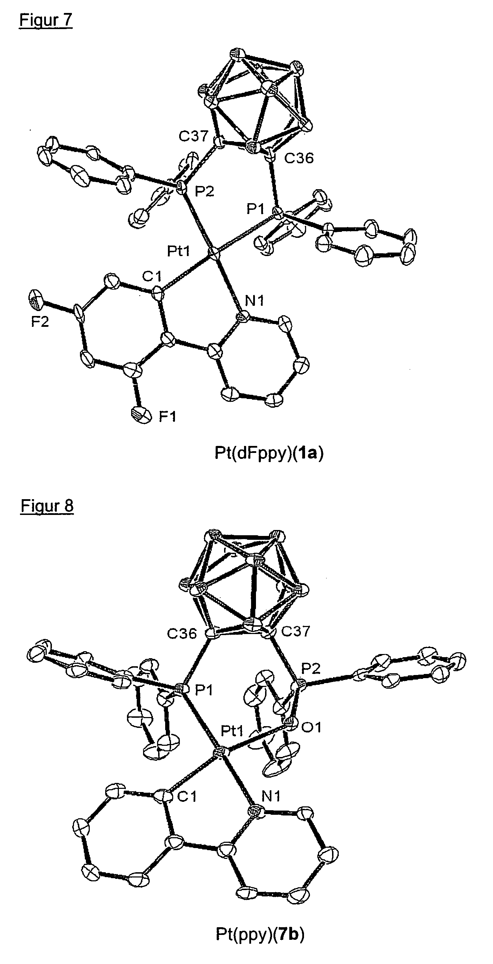

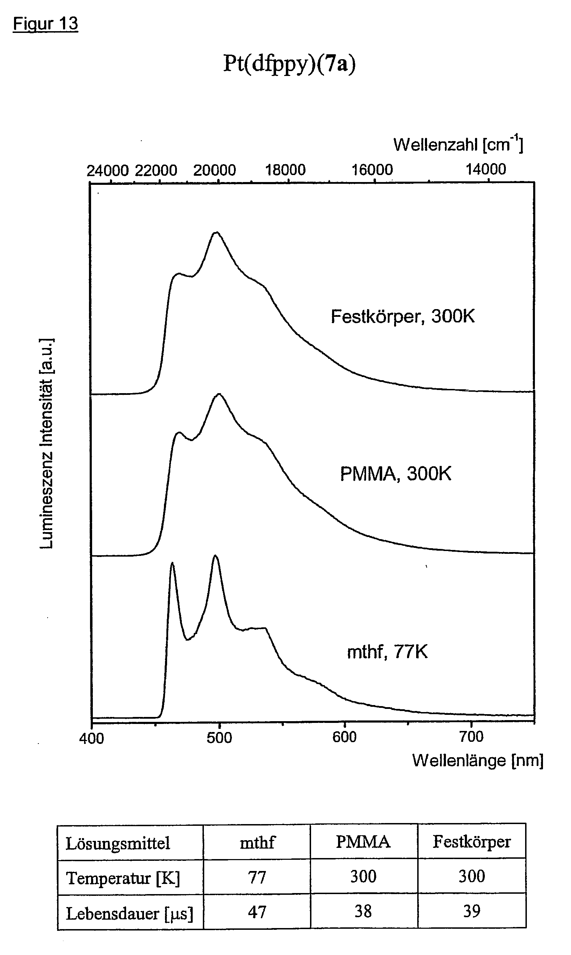

Die molekulare Struktur von Pt(dFppy)**(7a)** im Kristall ist in Figur 7 abgebildet. Die Phosphoreszenzspektren von Pt(dFppy)**(7a)** sind in Figur 13 abgebildet.

### Beispiel 3: Pt(ppy)(7b)

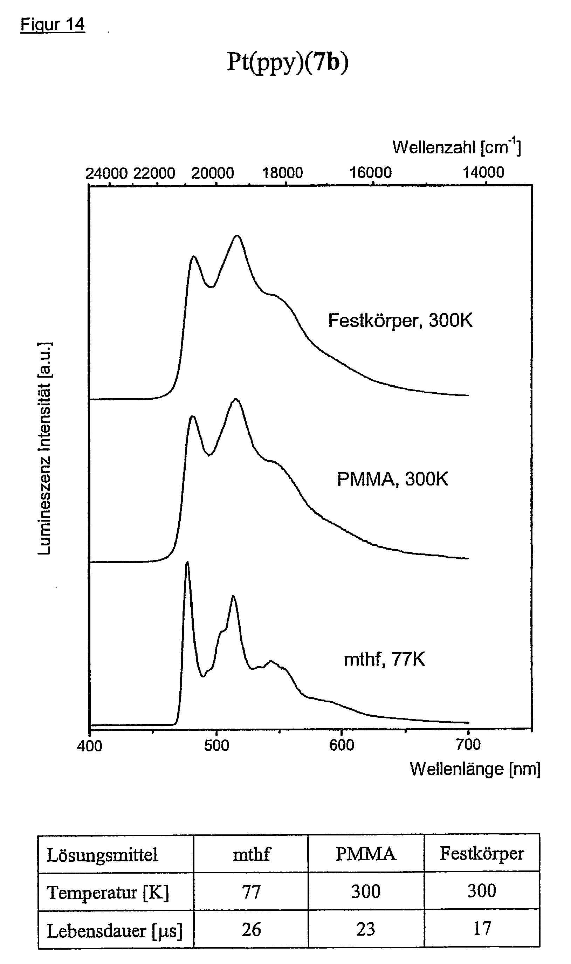

Chromatographische Trennung des Reaktionsgemisch aus Beispiel 1 (Al₂O₃, Hexan/Dichloromethan) ergibt kleine Mengen von Pt(ppy)**(7b).** Diese Substanz ist weniger polar als der Hauptprodukt Pt(ppy)**(7a)**. Die molekulare Struktur von Pt(ppy)**(7b)** ist in Figur 8 abgebildet. Die Phosphoreszenz-Spektren von Pt(ppy)(**7b**) sind in Figur 14 abgebildet.

### Beispiel 4: Synthese von Pt(thpy)(7a)

Der Komplex Pt(thpy)**(7a)** wird aus Pt(thpy)(thpyH)Cl und 1,2-Bis-(diphenylphosphan)-closo-carboran hergestellt (Gl. 4). Eine Lösung aus äquimolaren Mengen von Pt(thpy)(thpyH)Cl und 1,2-Bis-(diphenyl-phosphan)-*closo*-carboran wird unter Argon 12 h in refluxierendem Ethanol gerührt. Nach Abkühlung wird das aus dem Reaktionsgemisch ausgefallene rohe Produkt chromatographisch gereinigt (Al₂O₃, Hexan/Dichloromethan). Zusätzlich wird das Produkt aus heißem Ethanol umkristallisiert.

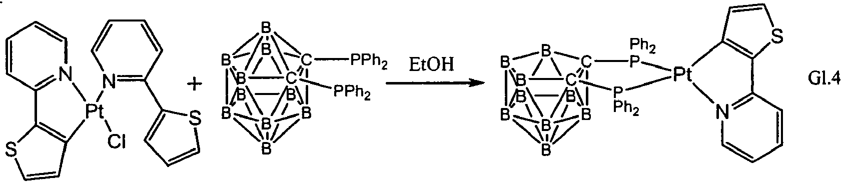

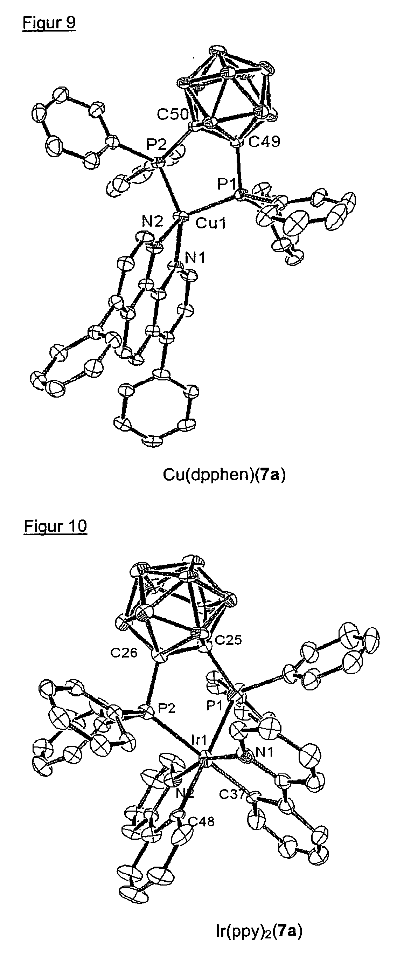

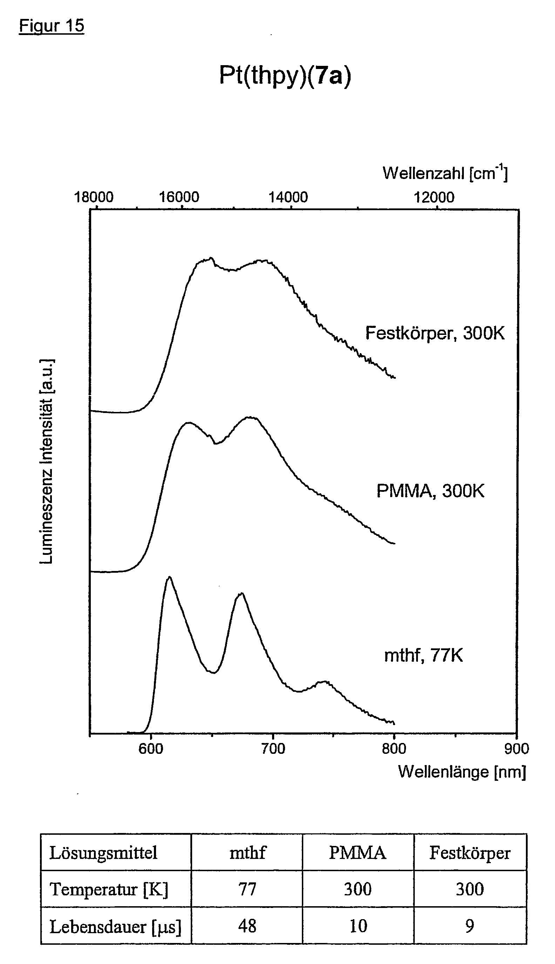

Die molekulare Struktur von Pt(thpy)**(7b)** im Kristall ist in Figur 9 abgebildet. Die Phosphoreszenzspektren von Pt(thpy)**(7b)** sind in Figur 15 abgebildet.

### Beispiel 5: Synthese von Cu(dphen)(7a), (dpphen = 4,7-Diphenyl-phenanthrolin)

Der Komplex Cu(dpphen)**(7a)** wird aus [Cu(CH₃CN)₄]PF₆, **7a** und dpphen hergestellt (Gl. 5). Eine Lösung aus äquimolaren Mengen von [Cu(CH₃CN)₄]PF₆ und Tetrabutylammonium-7,8-Bis-(diphenylphosphino)-7,8-dicarba-*nido*-undecaborat ([NBu₄)(**7a**)) wird unter Argon 2 h in Dichloromethan gerührt. Zu dieser *in situ* hergestellten Lösung von [Cu(CH₃CN)₂(**7a**)] wird eine äquimolare Menge an dpphen zugegeben. Nachdem die Lösung sich intensiv rot gefärbt hat, wird das Reaktionsgemisch chromatographiert (SiO₂, CH₂Cl₂). Die weitere Reinigung erfolgt durch Kristallisation aus Dichloromethan/Hexan.

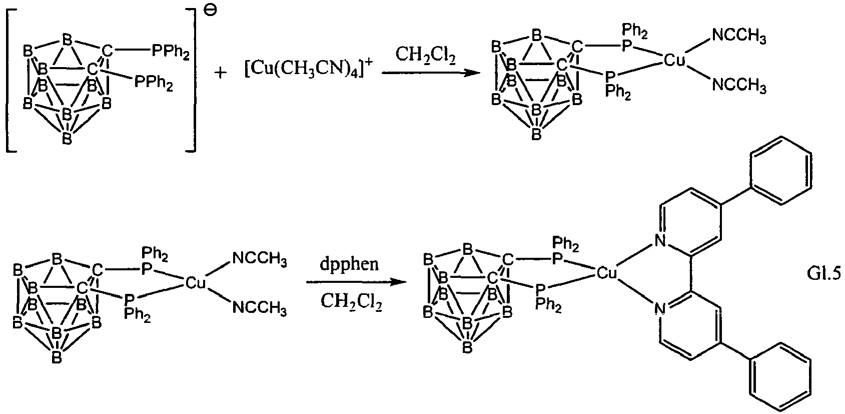

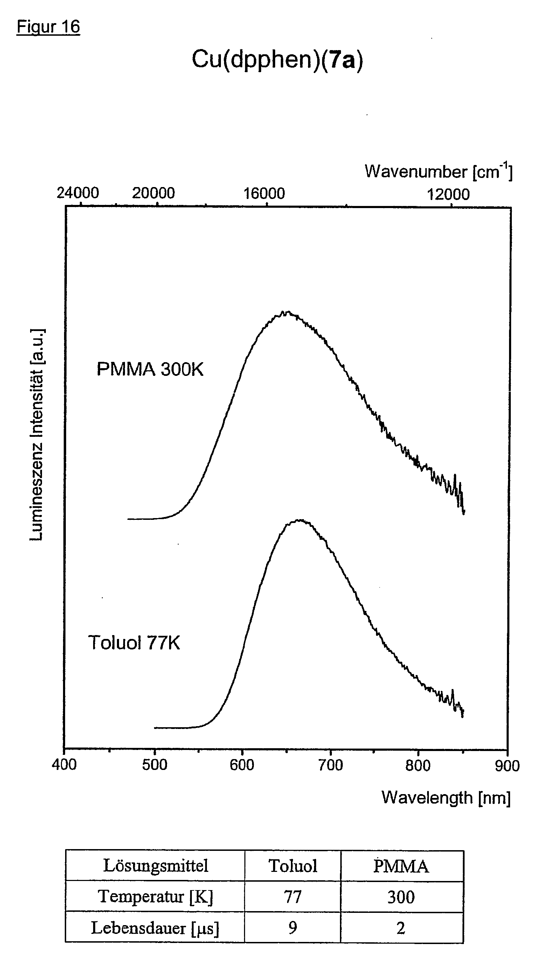

Die molekulare Struktur von Cu(dpphen)(7a) im Kristall ist in Figur 9 abgebildet. Die Photolumineszenzspektren von Cu(dpphen)(7a) sind in Figur 16 abgebildet.

### Beispiel 6: Synthese von Ir(ppy)₂(7a)

Der Komplex Ir(ppy)₂(**7a**) wird durch Reaktion von [Ir(ppy)₂Cl]₂ und 1,2-Bis-(diphenylphosphan)-*closo*-Carboran hergestellt (Gl. 6). Eine Lösung aus von [Ir(ppy)₂Cl]₂ und und der doppelten molaren Menge 1,2-Bis(diphenyl-phosphan)-*closo*-Carboran wird unter Argon 48 h in Ethanol unter Rückfluss gerührt. Nach Abkühlung wird das aus dem Reaktionsgemisch ausgefallene, rohe Produkt chromatographisch gereinigt (Al₂O₃, Diethylether/Dichloromethan). Zusätzlich wird das Produkt aus Dichlormethan/ Diethylether umkristallisiert.

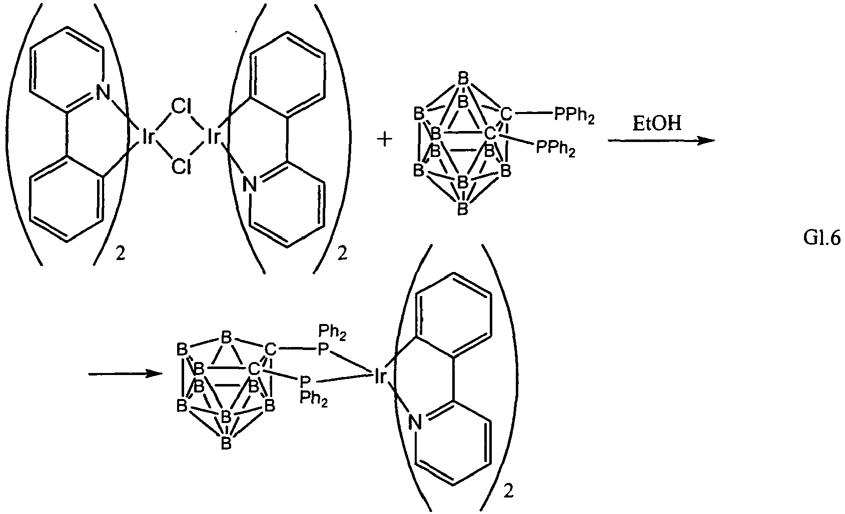

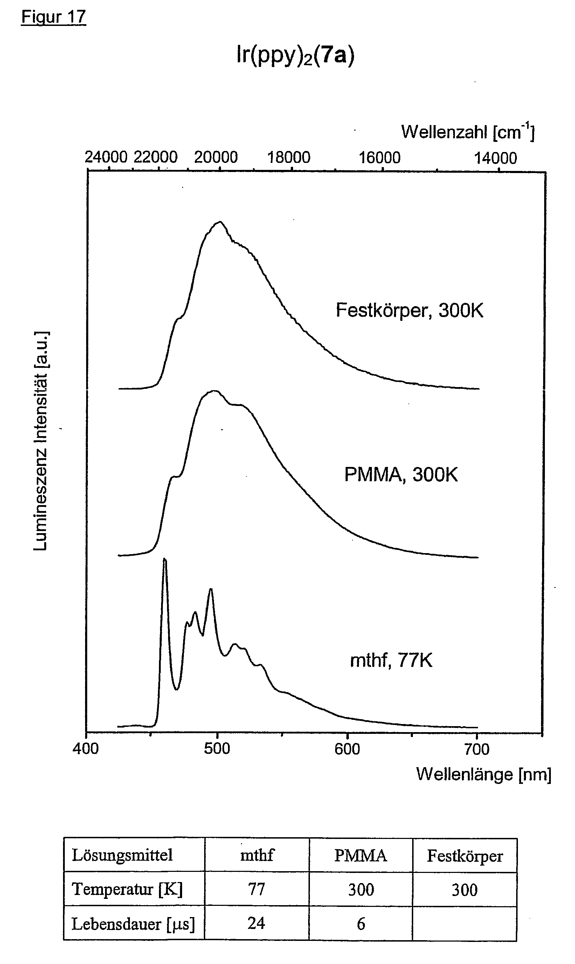

Die molekulare Struktur von Ir(ppy)₂(**7a**) im Kristall ist in Figur 10 abgebildet. Die Phosphoreszenzspektren von Ir(ppy)₂(**7a**) sind in Figur 17 abgebildet.

### Beispiel 7: Synthese von Ir(dFppy)₂(7a)

Der Komplex Ir(dFppy)₂(**7a**) wird durch Reaktion von [Ir(dFppy)₂Cl]₂ und 1,2-Bis-(diphenylphosphan)-*closo*-Carboran hergestellt (Gl. 7). Eine Lösung von [Ir(dFppy)₂Cl]₂ und der doppelten molaren Menge von 1,2-Bis-(diphenylphosphan)-*closo*-Carboran wird unter Argon 48 h in Ethanol unter Rückfluss gerührt. Nach Abkühlung wird das aus dem Reaktionsgemisch ausgefallene, rohe Produkt chromatographisch gereinigt (Al₂O₃, Diethylether/Dichloromethan). Zusätzlich wird das Produkt aus Dichlormethan/ Diethylether umkristallisiert.

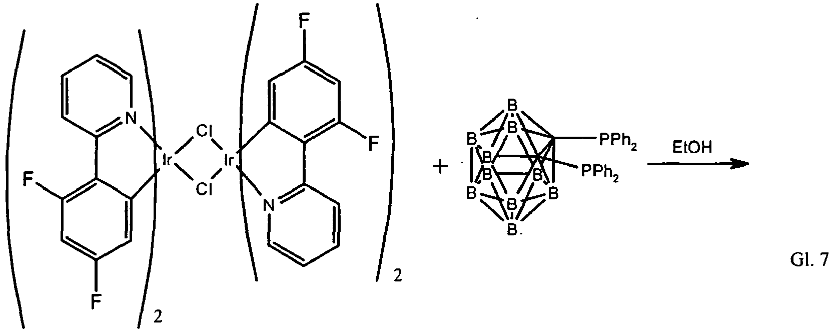

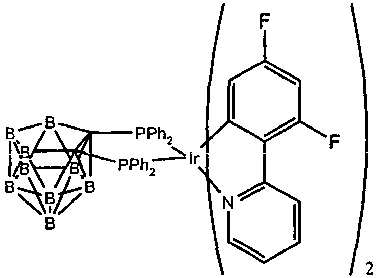

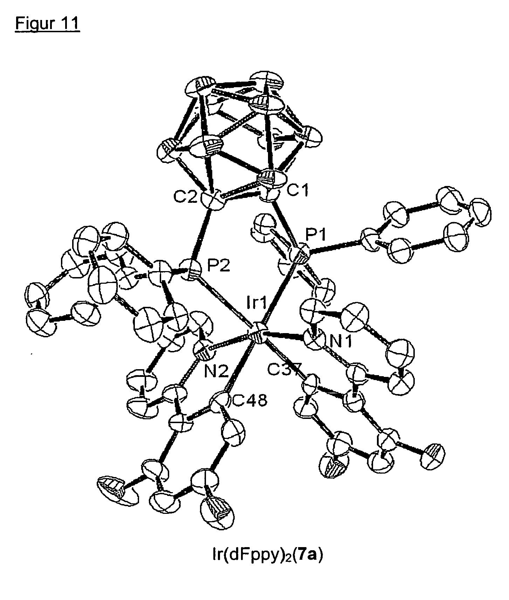

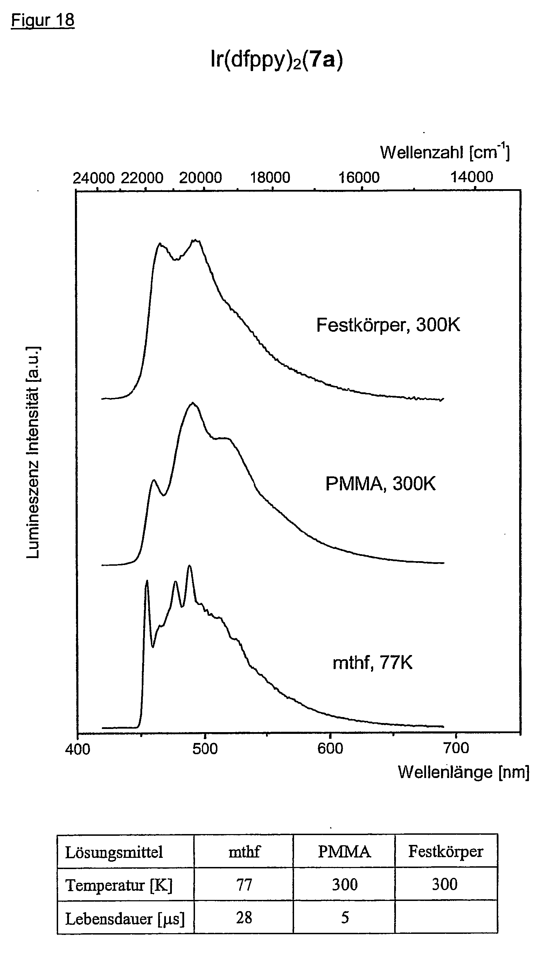

Die molekulare Struktur von Ir(dFppy)₂(**7a**) im Kristall ist in Figur 11 abgebildet. Die Phosphoreszenzspektren von Ir(dFppy)₂(**7a**) sind in Figur 18 abgebildet.

### Beispiel 8: Synthese von Ir(3-piq)₂(7a)

Der Komplex Ir(3-piq)₂(**7a**) (3-piq = 3-Phenylisochinolin) wird durch Reaktion von [Ir(3-piq)₂Cl]₂ und 1,2-Bis(diphenylphosphan)-*closo*-Carboran hergestellt (Gl. 8). Eine Lösung aus von [Ir(3-piq)₂Cl]₂ und der zweifach molaren Menge an 1,2-Bis(diphenylphosphan)-*closo*-Carboran wird unter Argon 48 h in Ethanol unter Rückfluss gerührt. Nach Abkühlung wird das aus dem Reaktionsgemisch ausgefallene rohe Produkt chromatographisch gereinigt (Al₂O₃, Diethylether/Dichloromethan). Zusätzlich wird das Produkt aus Dichlormethan/Diethylether umkristallisiert.

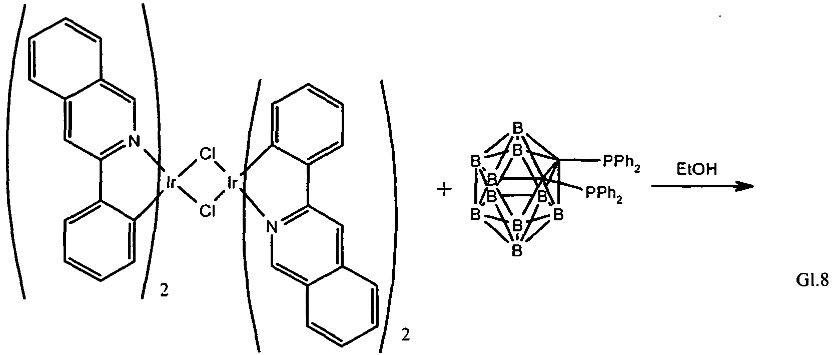

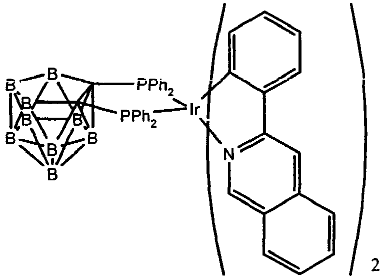

### Beispiel 9: Synthese von Ir(1-piq)₂(7a)

Der Komplex Ir(1-piq)₂(**7a**) (1-piq = 1-Phenylisochinolin) wird durch Reaktion von [Ir(1-piq)₂Cl]₂ und 1,2-Bis(diphenylphosphan)-*closo*-Carboran hergestellt (Gl. 9). Eine Lösung aus von [Ir(1-piq)₂Cl]₂ und der zweifach molaren Menge an 1,2-Bis(diphenylphosphan)-*closo*-Carboran wird unter Argon 48 h in Ethanol unter Rückfluss gerührt. Nach Abkühlung wird das aus dem Reaktionsgemisch ausgefallene rohe Produkt chromatographisch gereinigt (Al₂O₃, Diethylether/Dichloromethan). Zusätzlich wird das Produkt aus Dichlormethan/Diethylether umkristallisiert.

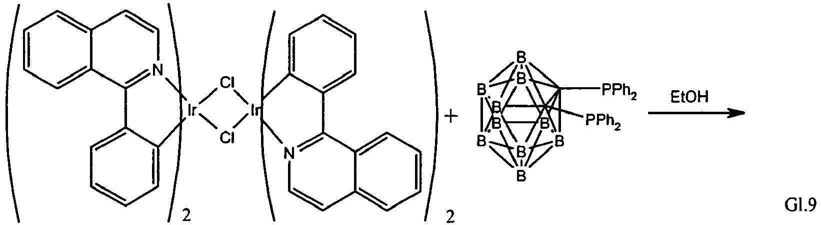

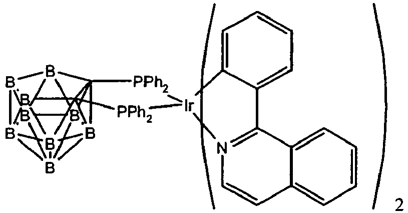

### Herstellung und Charakterisierung von organischen Elektrolumineszenzvorrichtungen:

Die Herstellung von LEDs erfolgt nach dem im Folgenden skizzierten allgemeinen Verfahren. Dieses muss natürlich im Einzelfall auf die jeweiligen Gegebenheiten (z. B. Schichtdickenvariation, um optimale Effizienz bzw. Farbe zu erreichen) angepasst werden.

### Allgemeines Verfahren zur Herstellung der OLEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z. B. Seifenlösung, Millipore-Wasser, Isopropanol). Zur Trocknung werden sie mit einer N₂-Pistole abgepustet und in einem Exsikkator gelagert. Vor der Bedampfung mit den organischen Schichten werden sie mit einem Ozon-Plasma-Gerät für ca. 20 Minuten behandelt. Es kann sich empfehlen, als erste organische Schicht eine polymere Lochinjektionsschicht zu verwenden. Dies ist in der Regel ein konjugiertes, leitfähiges Polymer, wie z. B. ein Polyanilinderivat (PANI) oder eine Polythiophenderivat (z. B. PEDOT, BAYTRON P™ von BAYER). Diese wird dann durch Spin-Coaten (Lackschleudern) aufgebracht. Die organischen Schichten werden der Reihe nach durch Aufdampfen in einer Hochvakuumanlage aufgebracht. Dabei werden die Schichtdicke der jeweiligen Schicht und die Bedampfungsrate über einen Schwingquarz verfolgt bzw. eingestellt. Es können auch einzelne Schichten aus mehr als einer Verbindung bestehen, d. h. in der Regel ein Wirtsmaterial (host) mit einem Gastmaterial (guest) dotiert sein. Dies wird durch Co-Verdampfung aus zwei bzw. mehreren Quellen erzielt. Auf die organischen Schichten wird noch eine Elektrode aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode als Kathode kontaktiert, und es werden die Device-Parameter bestimmt.

Analog dem o. g. allgemeinen Verfahren, werden OLEDs mit folgendem Aufbau 1 erzeugt:

| | |
|---|---|
| PEDOT | 20 nm (aus Wasser aufgeschleudert; PEDOT bezogen von BAYER AG; Poly-[3,4-ethylendioxy-2,5-thiophen]) |
| HIM1 | 20 nm 2,2',7,7'-Tetrakis(di-p-tolylamino)-spiro-9,9'-bifluoren (aufgedampft) |
| NPB | 20 nm 4,4'-Bis(1-naphthyl-phenyl-amino)biphenyl (aufgedampft) |
| mCP | 40 nm 1,3-Bis(N-carbazolyl)benzol (aufgedampft) |
| dotiert mit | 10 % |
| Emitter | erfindungsgemäße Beispiele s. Tabelle 4 |
| BCP | 5 nm 2,9-Dimethyl-4,7-diphenyl-1,10-phenanthrolin (aufgedampft) |
| AlQ₃ | 30 nm Tris(hydroxychinolinat)aluminium(III) (aufgedampft) |
| Li / Al | 5 nm LiF, darauf 150 nm Al als Kathode. |

Diese noch nicht optimierte OLED wird standardmäßig charakterisiert. In Tabelle 4 sind die Effizienz und die Spannung bei 500 cd / m² sowie die Farbe aufgeführt.

**Tabelle 4**

| Bsp. | Emitter | Effizienz [cd/A] bei 500 cd / m² | Spannung [V] bei 500 cd / m² | Farbe CIE x / y |
|---|---|---|---|---|
| 10 | Beispiel 1 | 16,4 | 5,6 | 0,28 / 0,61 |
| 11 | Beispiel 2 | 12,3 | 6,8 | 0,19 / 0,34 |
| 12 | Beispiel 6 | 26,5 | 5,4 | 0,31 / 0,59 |
| 13 | Beispiel 7 | 14,9 | 6,6 | 0,18 / 0,33 |

Analog dem oben genannten allgemeinen Verfahren werden weiterhin OLEDs mit folgendem Aufbau 2 erzeugt:

| | |
|---|---|
| PEDOT | 20 nm (aus Wasser aufgeschleudert; PEDOT bezogen von BAYER AG; Poly-[3,4-ethylendioxy-2,5-thiophen] |
| PVK | 60 nm (aus Chlorbenzol augeschleudert, PVK Mw = 1,100000 bezogen von Aldrich, Lösung enthaltend 5 Gew.% Emitter, s. Tabelle 5), |
| Ba / Ag | 10 nm Ba / 150 nm Ag als Kathode. |

Diese noch nicht optimierte OLED wird standardmäßig charakterisiert. In Tabelle 5 sind die Effizienz und die Spannung bei 500 cd/m² sowie die Farbe aufgeführt.

**Tabelle 5**

| Bsp. | Emitter | Effizienz [cd/A] bei 500 cd / m² | Spannung [V] bei 500 cd / m² | Farbe CIE x / y |
|---|---|---|---|---|
| 14 | Beispiel 4 | 9,6 | 4,8 | 0,64 / 0,35 |
| 15 | Beispiel 5 | 4,3 | 5,2 | 0,63 / 0,36 |
| 16 | Beispiel 8 | 8,1 | 4,6 | 0,67 / 0,32 |
| 17 | Beispiel 9 | 7,3 | 4,6 | 0,69 / 0,31 |

## Patentansprüche

1. Organische elektronische Vorrichtung,
enthaltend Anode, Kathode und mindestens eine Schicht, welche mindestens eine organische Verbindung enthält, ausgewählt aus organischen Elektrolumineszenzvorrichtungen (= organischen Leuchtdioden, OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs), organischen Laserdioden (O-Laser) oder OLED-Sensoren (nicht hermetisch nach außen abgeschirmte Gas- und Dampf-Sensoren)
enthaltend mindestens einen Metallkomplex, **dadurch gekennzeichnet, dass** der Metallkomplex mindestens einen Liganden der Formel (I) umfasst,
**Formel (I):** **[7,8-(ER₂)₂-7,8-C₂B₉(R¹)₁₀]**
worin gilt:
E ist gleich oder verschieden bei jedem Auftreten P, As, Sb, N oder eine Gruppe P=O, P=S, As=O oder As=S;
R ist gleich oder verschieden bei jedem Auftreten H, Deuterium, F, Cl, Br, I, N(R²)₂, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R² substituiert sein kann, wobei eine oder mehrere nicht benachbarte CH₂-Gruppen durch R²C=CR², C=C, Si(R²)₂, Ge(R²)₂, Sn(R²)₂, C=O, C=S, C=Se, C=NR², P(=O)(R²), SO, SO₂, NR², O, S oder CONR² ersetzt sein können und wobei ein oder mehrere H-Atome durch F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;
R¹ ist gleich oder verschieden bei jedem Auftreten H, OH oder eine C₁-C₃₀-Alkoxygruppe;
R² ist bei jedem Auftreten gleich oder verschieden H, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R² auch miteinander ein mono- oder polycyclisches, aliphatisches, aromatisches und/oder benzoannelliertes Ringsystem bilden.

2. Organische elektronische Vorrichtung nach Anspruch 1, **dadurch gekennzeichnet, dass** der Ligand gemäß Formel (I) ausgewählt ist aus den folgenden drei Ligandengruppen:
Gruppe 1: Liganden, in denen beide Symbole E für P, As, Sb oder N stehen:
**Formel (Ia):** [7,8-(PR₂)₂-7,8-C₂B₉H₁₀]^{□}
**Formel (Ia')** [7,8-(AsR₂)₂-7,8-C₂B₉H₁₀]
**Formel (la")** [7,8-(SbR₂)₂-7,8-C₂B₉H₁₀]
**Formel (Ia"')** [7,8-(NR₂)₂-7,8-C₂B₉H₁₀]
und entsprechende Liganden, in denen die beiden Symbole E unterschiedlich sind und ausgewählt sind aus P, As, Sb und N.
Gruppe 2: Liganden, in denen ein Symbol E für eine Gruppe P=O, P=S, As=O oder As=S steht und das andere Symbol E ausgewählt ist aus P, As, Sb oder N:
**Formel (Ib):** [7-(O=PR₂)-8-(ER₂)-7,8-C₂B₉H₁₀]
**Formel (Ib'):** [7-(S=PR₂)-8-(ER₂)-7,8-C₂B₉H₁₀]
und
**Formel (Ib"):** [7-(O=AsR₂)-8-(ER₂)-7,8-C₂B₉H₁₀]
**Formel (Ib"'):** [7-(S=AsR₂)-8-(ER₂)-7,8-C₂B₉H₁₀]
Gruppe 3: Liganden, in denen beide Symbole E für eine Gruppe P=O, P=S, As=O oder As=S stehen:
**Formel (Ic):** [7,8-(O=PR₂)₂-7,8-C₂B₉H₁₀]
**Formel (Ic'):** [7,8-(S=PR₂)₂-7,8-C₂B₉H₁₀]
**Formel (Ic"):** [7,8-(O=AsR₂)₂-7,8-C₂B₉H₁₀]
**Formel (Ic"'):** [7,8-(S=AsR₂)₂-7,8-C₂B₉H₁₀]
und entsprechende Liganden, in denen die beiden Symbole E unterschiedlich sind und ausgewählt sind aus P=O, P=S und As=O.

3. Organische elektronische Vorrichtung nach Anspruch 1 oder 2, **dadurch gekennzeichnet, dass** der Metallkomplex ein Komplex der Formel (II) ist,
**Formel (II):** **M(E∩E)ₓ(A∩Aⁿ⁻)_{y}(L)_{z}**
worin gilt:
M ist ein Metall, bevorzugt ein Übergangsmetall, insbesondere ausgewählt aus W, Re, Os, Ir, Pt, Ru, Rh oder Cu, oder ein Lanthanid,
(E∩E) ist eine Verbindung der Formel (I) und ist definiert wie in Anspruch 1 oder 3,
(A∩Aⁿ⁻) ist ein zwei- oder mehrzähniger Ligand,
L ist ein ein- oder mehrzähniger Ligand,
x ist 1, 2 oder 3,
y ist 0, 1, 2 oder 3, insbesondere 1, 2 oder 3, und besonders bevorzugt 1 oder 2,
z ist 0, 1, 2 oder 3,
n ist 0, 1 oder 2.

4. Organische elektronische Vorrichtung nach Anspruch 3, **dadurch gekennzeichnet, dass** die Liganden L ausgewählt sind aus Kohlenmonoxid, Stickstoffmonoxid, Isonitrilen, Nitrilen, Aminen, Iminen, Phosphinen, Phosphiten, Arsinen, Stibinen, Thioethern, stickstoffhaltigen Heterocyclen, Hydrid, Deuterid, den Halogeniden F, Cl, Br und I, Alkylacetyliden, Arylacetyliden, Cyanid, Cyanat, Isocyanat, Thiocyanat, Isothiocyanat, Nitrat, Nitrit, aliphatischen oder aromatischen Alkoholaten, aliphatischen oder aromatischen Thioalkoholaten, Amiden, Carboxylaten, Alkylgruppen, Arylgruppen, O²⁻, S²⁻, Nitrene, welche zu einer Koordination der Form R-N=M führen, N³⁻, Diaminen, Diminen, Heterocyclen enthaltend zwei Stickstoffatome, Diphosphinen, 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, Dialkoholaten abgeleitet von Dialkoholen, Dithiolaten und Boraten stickstoffhaltiger Heterocyclen.

5. Organische elektronische Vorrichtung nach Anspruch 3 oder 4, **dadurch gekennzeichnet, dass** die Bindung von (A∩Aⁿ⁻) an das Metall im Komplex durch mindestens ein Kohlenstoffatom und/oder durch mindestens ein Stickstoffatom erfolgt, wobei das Kohlenstoffatom auch ein Carben sein kann.

6. Organische elektronische Vorrichtung nach einem oder mehreren der Ansprüche 3 bis 5, **dadurch gekennzeichnet, dass** der Ligand (A∩Aⁿ⁻) aromatische bzw. heteroaromatische Gruppierungen umfasst, die an das Metall koordinieren, wobei diese aromatischen bzw. heteroaromatischen Gruppen Aryl- oder Heteroarylgruppen mit 5 bis 40 aromatischen Ringatomen sind, welche gleich oder verschieden bei jedem Auftreten sein können welche durch einen oder mehrere Reste R substituiert sein können und/oder welche auch ein exocyclisches Donoratom aufweisen können, bevorzugt ausgewählt aus Benzol, 2-Phenol, 2-Thiophenol, Napthalin, Anthracen, Phenanthren, Pyridin, Chinolin, Isochinolin, Pyrazin, Chinoxalin, Pyrimidin, Pyridazin, Triazin, Pyrrol, Indol, Imidazol, Furan, Benzofuran, Benzimidazol, Pyrazol, Triazol, Oxazol, Thiazol, Thiophen, Benzothiophen, Benzoxazol oder Benzthiazol, welche jeweils durch einen oder mehrere Reste R substituiert sein kann.

7. Organische elektronische Vorrichtung nach einem oder mehreren der Ansprüche 3 bis 6, **dadurch gekennzeichnet, dass** die aromatischen bzw. heteroaromatischen koordinierenden Gruppen im Liganden (A∩Aⁿ⁻) ausgewählt sind aus den folgenden Formeln, indem zwei dieser Gruppen jeweils an der durch # gekennzeichneten Position aneinander binden; in diesen Formeln ist jeweils durch * die Position angedeutet, in der der Ligand an das Metall bindet: 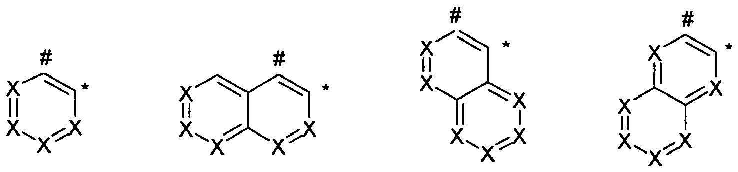 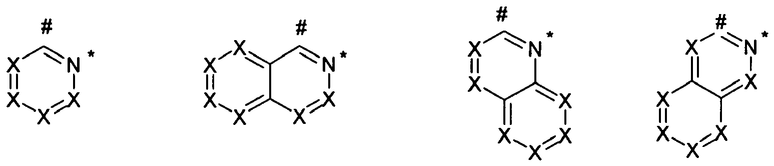 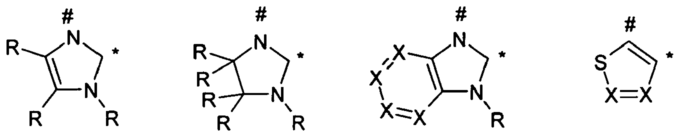 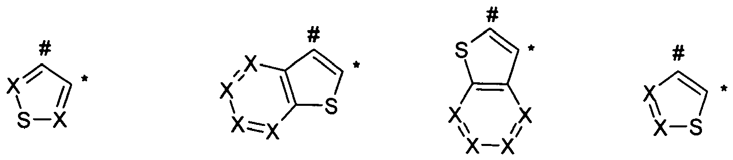 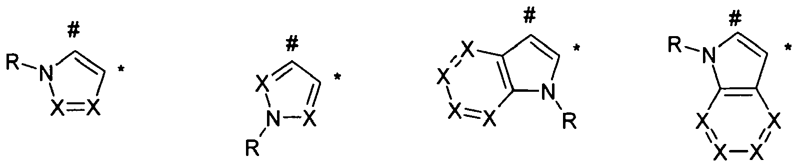 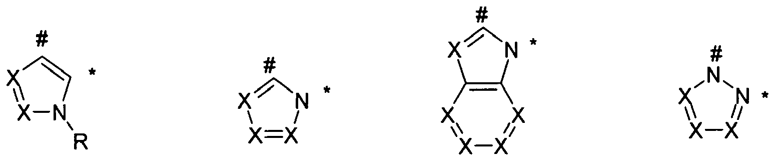 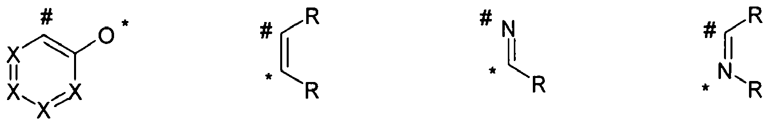 dabei steht X gleich oder verschieden bei jedem Auftreten für CR, wobei R die in Anspruch 1 genannte Bedeutung hat, oder für N mit der Maßgabe, dass maximal drei Symbole X in jeder Gruppe für N stehen.

8. Organische elektronische Vorrichtung nach einem oder mehreren der Ansprüche 1 bis 7, **dadurch gekennzeichnet, dass** die Komplexe der Formel (II) ausgewählt sind aus M(E∩E)(A∩Aⁿ⁻)₂, M(E∩E)₂(A∩Aⁿ⁻) oder M(E∩E)(A∩Aⁿ⁻)(L)₂, wobei M vorzugsweise Os(II), Ir(III), Ru(II), Re(I), Pt(IV) oder W(0) ist, insbesondere Ir(III); bevorzugt sind die Komplexe der Formel (II) ausgewählt aus Pt^{II}(E∩E)(A∩A⁻), Ir^{III}(E∩E)₂(A∩A⁻), Ir^{III}(E∩E)(A∩A⁻)2, Rh^{III}(E∩E)ₙ(A∩A⁻), Rh^{III}(E∩E)(A∩A⁻)2, Os^{II}(E∩E)(A∩A⁻)L₂ und Ru^{II}(E∩E)(A∩A⁻)L₂, wobei (E∩E) definiert ist wie in Anspruch 3 und (A∩A⁻) wie in den Ansprüchen 3 und 5 bis 7 definiert ist.

9. Organische elektronische Vorrichtung nach Anspruch 3 oder 4, **dadurch gekennzeichnet, dass** der Komplex ausgewählt ist aus Komplexen der Formeln (III), (IV), (V) und (VI),
**Formel (III):** **M(III)(E**∩**E)₃**
F**ormel (IV):** **M(III)(E**∩**E)₃(L)_{z}**
**Formel (V):** **M(II)(E**∩**E)₂(L)_{z}**
**Formel (VI):** **M(III)(E**∩**E)₃(N**∩**N)(L)_{z}**
worin gilt:
(N∩N) ist ein bidentater Ligand, der über zwei Stickstoffatome an das Metall koordiniert;
M(III) ist ein dreiwertiges Lanthanoid-Kation, z. B. Ce(III), Pr(III), Nd(III), Pm(III), Sm(III), Eu(III), Gd(III), Tb(III), Dy(III), Ho(III), Er(III), Tm(III), Yb(III), Lu(III),
M(II) ist ein zweiwertiges Lanthanoid-Kation, z. B. Sm(II), Eu(II), Tm(II) oder Yb(II),
(E∩E) ist ein Ligand der Formel (I), insbesondere der Formel (Ic),
L ist ein ein- oder mehrzähniger Ligand.

10. Organische elektronische Vorrichtung nach Anspruch 9, **dadurch gekennzeichnet, dass** der Ligand (N∩N) für einen Liganden der folgenden Struktur steht: 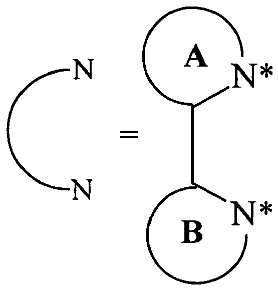 worin die Gruppierungen A und B fünf- oder sechsatomige Ringe darstellen oder offenkettig sind; dabei sind die Gruppen A und B bevorzugt gewählt aus den im Folgenden abgebildeten Gruppen: 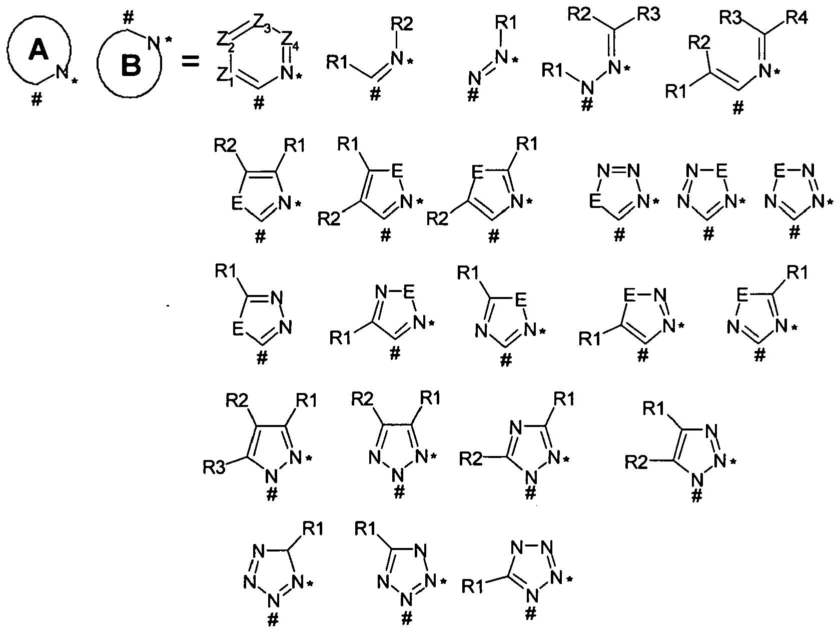 worin R die in Anspruch 1 genannte Bedeutung hat, R1 bis R4 dieselbe Bedeutung haben wie R, E für O, S oder NR steht und Z₁ bis Z₄ gleich oder verschieden bei jedem Auftreten für CR oder N stehen; * bezeichnet das Atom, das die Komplexbindung eingeht, und # bezeichnet das Atom, das mit der zweiten Einheit verbunden ist.

11. Organische Elektrolumineszenzvorrichtung nach einem oder mehreren der Ansprüche 1 bis 10, enthaltend Kathode, Anode und mindestens eine emittierende Schicht und außerdem gegebenenfalls enthaltend weitere Schichten, ausgewählt aus einer oder mehreren Lochinjektionsschichten, Lochtransportschichten, Lochblockierschichten, Elektronentransportschichten, Elektroneninjektionsschichten, Excitonenblockierschichten, Ladungserzeugungsschichten und/oder organischen oder anorganischen p/n-Übergängen.

12. Organische Elektrolumineszenzvorrichtung nach einem oder mehreren der Ansprüche 1 bis 11, **dadurch gekennzeichnet, dass** der Metallkomplex mit einem Liganden der Formel (I) bzw. der Metallkomplex der Formel (II) als emittierende Verbindung in einer emittierenden Schicht eingesetzt wird, entweder als Reinstoff oder in Kombination mit einem Matrixmaterial.

13. Organische Elektrolumineszenzvorrichtung nach Anspruch 12, **dadurch gekennzeichnet, dass** das Matrixmaterial ausgewählt ist aus CBP (N,N-Biscarbazolylbiphenyl), Carbazolderivaten, PVK (Polyvinylcarbazol), Azacarbazolen, Ketonen, Phosphinoxiden, Sulfoxiden, Sulfonen, Oligophenylenen, aromatischen Aminen, bipolaren Matrixmaterialien, Silanen, Azaborolen oder Boronestern.

14. Metallkomplex der Formel (II)
**Formel (II):** **M(E**∩**E)ₓ(A**∩**Aⁿ⁻)_{y}(L)_{z}**
worin gilt:
M ist ein Metall, bevorzugt ein Übergangsmetall, insbesondere ausgewählt aus W, Re, Os, Ir, Pt, Ru, Rh oder Cu, oder ein Lanthanid,
(E∩E) ist eine Verbindung der Formel (I) und ist definiert wie in Anspruch 1 oder 2,
(A∩Aⁿ⁻) ist ein zwei- oder mehrzähniger Ligand, der bevorzugt mindestens eine Metall-Kohlenstoffbindung mit dem Metall aufweist,
L ist ein ein- oder mehrzähniger Ligand,
x ist 1, 2 oder 3, bevorzugt 1 oder 2,
y ist 1, 2 oder 3, bevorzugt 1 oder 2,
z ist 0, 1, 2 oder 3,
n ist 0, 1 oder 2.

15. Metallkomplex der Formeln (III), (IV), (V) und (VI),
**Formel (III):** **M(III)(E**∩**E)₃**
**Formel (IV):** **M(III)(E**∩**E)₃(L)_{z}**
**Formel (V):** **M(II)(E**∩**E)₂(L)_{z}**
**Formel (VI):** **M(III)(E**∩**E)₃(N**∩**N)(L)_{z}**
worin gilt:
(N∩N) ist ein bidentater Ligand, der über zwei Stickstoffatome an das Metall koordiniert;
M(III) ist ein dreiwertiges Lanthanoid-Kation, z. B. Ce(III), Pr(III), Nd(III), Pm(III), Sm(III), Eu(III), Gd(III), Tb(III), Dy(III), Ho(III), Er(III), Tm(III), Yb(III), Lu(III),
M(II) ist ein zweiwertiges Lanthanoid-Kation, z. B. Sm(II), Eu(II), Tm(II) oder Yb(II),
(E∩E) ist ein Ligand der Formel (I), insbesondere der Formel (Ic), nach Anspruch 1 oder 2,
L ist ein ein- oder mehrzähniger Ligand
z ist 0, 1, 2, oder 3.

## Claims

1. Organic electronic device
comprising anode, cathode and at least one layer which comprises at least one organic compound selected from organic electroluminescent devices (= organic light-emitting diodes, OLEDs, PLEDs), organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs), light-emitting electrochemical cells (LECs), organic laser diodes (O-lasers) or OLED sensors (gas and vapour sensors which are not hermetically screened from the outside)
comprising at least one metal complex, **characterised in that** the metal complex contains at least one ligand of the formula (I),
**formula (I):** **[7,8-(ER₂)₂-7,8-C₂B₉(R¹)₁₀]**
in which:
E is, identically or differently on each occurrence, P, As, Sb, N or a P=O, P=S, As=O or As=S group;
R is, identically or differently on each occurrence, H, deuterium, F, Cl, Br, I, N(R²)₂, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals R², where one or more non-adjacent CH₂ groups may be replaced by R²C=CR², C=C, Si(R²)₂, Ge(R²)₂, Sn(R²)₂, C=O, C=S, C=Se, C=NR², P(=O)(R²), SO, SO₂, NR², O, S or CONR² and where one or more H atoms may be replaced by F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², or a combination of these systems; two or more of these substituents R here may also form a mono- or polycyclic, aliphatic, aromatic and/or benzo-fused ring system with one another;
R¹ is, identically or differently on each occurrence, H, OH or a C₁-C₃₀-alkoxy group;
R² is on each occurrence, identically or differently, H, F or an aliphatic, aromatic and/or heteroaromatic hydrocarbon radical having 1 to 20 C atoms, in which, in addition, one or more H atoms may be replaced by F; two or more substituents R² here may also form a mono- or polycyclic, aliphatic, aromatic and/or benzo-fused ring system with one another.

2. Organic electronic device according to Claim 1, **characterised in that** the ligand of the formula (I) is selected from the following three ligand groups:
Group 1: Ligands in which both symbols E stand for P, As, Sb or N:
**formula (Ia):** [7,8-(PR₂)₂-7,8-C₂B₉H₁₀]
**formula (Ia'):** [7,8-(AsR₂)₂-7,8-C₂B₉H₁₀]
**formula (Ia"):** [7,8-(SbR₂)₂-7,8-C₂B₉H₁₀]
**formula (Ia"'):** [7,8-(NR₂)₂-7,8-C₂B₉H₁₀]
and corresponding ligands in which the two symbols E are different and are selected from P, As, Sb and N
Group 2: Ligands in which one symbol E stands for a P=O, P=S, As=O or As=S group and the other symbol E is selected from P, As, Sb or N:
**formula (Ib):** [7-(O=PR₂)-8-(ER₂)-7,8-C₂B₉H₁₀]
**formula (Ib'):** [7-(S=PR₂)-8-(ER₂)-7,8-C₂B₉H₁₀]
and
**formula (Ib"):** [7-(O=AsR₂)-8-(ER₂)-7,8-C₂B₉H₁₀]
**formula (Ib"'):** [7-(S=AsR₂)-8-(ER₂)-7,8-C₂B₉H₁₀]
Group 3: Ligands in which both symbols E stand for a P=O, P=S, As=O or As=S group:
**formula (Ic):** [7,8-(O=PR₂)₂-7,8-C₂B₉H₁₀]
**formula (Ic'):** [7,8-(S=PR₂)₂-7,8-C₂B₉H₁₀]
**formula (Ic"):** [7,8-(O=AsR₂)₂-7,8-C₂B₉H₁₀]
**formula (Ic"'):** [7,8-(S=AsR₂)₂-7,8-C₂B₉H₁₀]
and corresponding ligands in which the two symbols E are different and are selected from P=O, P=S and As=O.

3. Organic electronic device according to Claim 1 or 2, **characterised in that** the metal complex is a complex of the formula (II),
**formula (II):** **M(E∩E)ₓ(A∩Aⁿ⁻)_{y}(L)_{z}**
in which:
M is a metal, preferably a transition metal, in particular selected from W, Re, Os, Ir, Pt, Ru, Rh or Cu, or a lanthanide,
(E∩E) is a compound of the formula (I) and is as defined in Claim 1 or 2,
(A∩Aⁿ⁻) is a bi- or polydentate ligand,
L is a mono- or polydentate ligand,
x is 1, 2 or 3,
y is 0, 1, 2 or 3, in particular 1, 2 or 3, and particularly preferably 1 or 2,
z is 0, 1, 2 or 3,
n is 0, 1 or 2.

4. Organic electronic device according to Claim 3, **characterised in that** the ligands L are selected from carbon monoxide, nitrogen monoxide, isonitriles, nitriles, amines, imines, phosphines, phosphites, arsines, stibines, thioethers, nitrogen-containing heterocycles, hydride, deuteride, the halides F, Cl, Br and I, alkylacetylides, arylacetylides, cyanide, cyanate, isocyanate, thiocyanate, isothiocyanate, nitrate, nitrite, aliphatic or aromatic alcoholates, aliphatic or aromatic thioalcoholates, amides, carboxylates, alkyl groups, aryl groups, O²⁻, S²⁻, nitrenes, which result in coordination in the form R-N=M, N³⁻, diamines, diimines, heterocycles containing two nitrogen atoms, diphosphines, 1,3-diketonates derived from 1,3-diketones, 3-ketonates derived from 3-ketoesters, carboxylates derived from aminocarboxylic acids, salicyliminates derived from salicylimines, dialcoholates derived from dialcohols, dithiolates and borates of nitrogen-containing heterocycles.

5. Organic electronic device according to Claim 3 or 4, **characterised in that** (AⁿAⁿ⁻) is bonded to the metal in the complex via at least one carbon atom and/or via at least one nitrogen atom, where the carbon atom may also be a carbene.

6. Organic electronic device according to one or more of Claims 3 to 5, **characterised in that** the ligand (A∩Aⁿ⁻) contains aromatic or heteroaromatic groups which coordinate to the metal, where these aromatic or heteroaromatic groups are aryl or heteroaryl groups having 5 to 40 aromatic ring atoms, which may be identical or different on each occurrence, which may be substituted by one or more radicals R and/or which may also contain an exocyclic donor atom, preferably selected from benzene, 2-phenol, 2-thiophenol, naphthalene, anthracene, phenanthrene, pyridine, quinoline, isoquinoline, pyrazine, quinoxaline, pyrimidine, pyridazine, triazine, pyrrole, indole, imidazole, furan, benzofuran, benzimidazole, pyrazole, triazole, oxazole, thiazole, thiophene, benzothiophene, benzoxazole or benzothiazole, each of which may be substituted by one or more radicals R.

7. Organic electronic device according to one or more of Claims 3 to 6, **characterised in that** the aromatic or heteroaromatic coordinating groups in the ligand (A∩Aⁿ⁻) are selected from the following formulae, where two of these groups are bonded to one another, in each case at the position denoted by #; in these formulae, * in each case indicates the position in which the ligand is bonded to the metal: 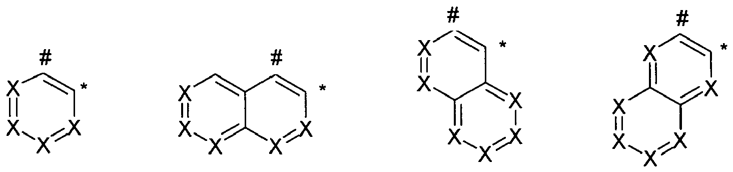 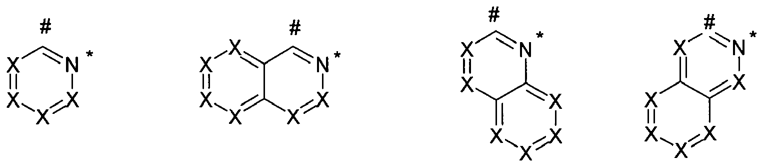 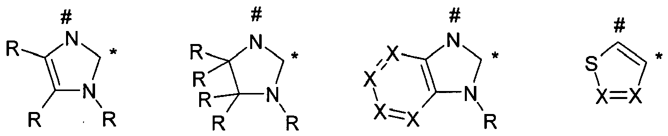 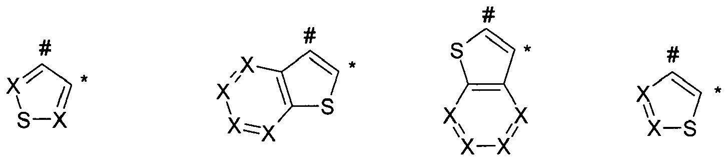 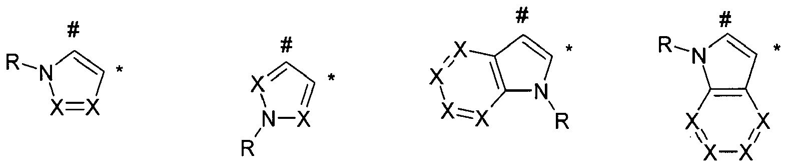 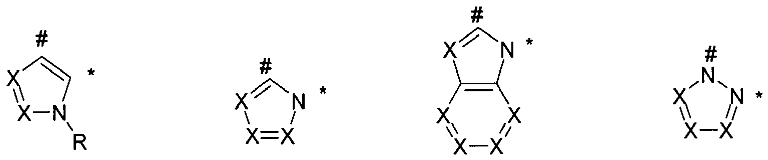 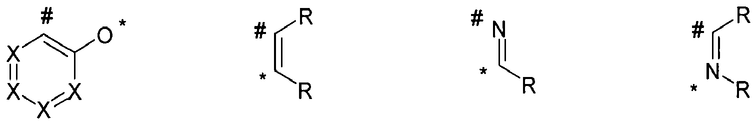 X here stands, identically or differently on each occurrence, for CR, where R has the meaning given in Claim 1, or for N, with the proviso that a maximum of three symbols X in each group stand for N.

8. Organic electronic device according to one or more of Claims 1 to 7, **characterised in that** the complexes of the formula (II) are selected from M(E∩E)(A∩Aⁿ⁻)₂, M(E∩E)₂(A∩Aⁿ⁻) or M(E∩E)(A∩Aⁿ⁻)(L)₂, where M is preferably Os(II), Ir(III), Ru(II), Re(I), Pt(IV) or W(0), in particular Ir(III); the complexes of the formula (II) are preferably selected from Pt^{II}(E∩E)(A∩A⁻), Ir^{III}(E∩E)₂(A∩A⁻), Ir^{III}(E∩E)(A∩A⁻)₂, Rh^{III}(E∩E)ₙ(A∩A⁻), Rh^{III}(E∩E)(A∩A⁻)₂, Os^{II}(E∩E)(A∩A⁻)L₂ and Ru^{II}(E∩E)(A∩A⁻)L₂, where (E∩E) is as defined in Claim 3 and (A∩A⁻) is as defined in Claims 3 and 5 to 7.

9. Organic electronic device according to Claim 3 or 4, **characterised in that** the complex is selected from complexes of the formulae (III), (IV), (V) and (VI),
**formula (III):** **M(III)(E**∩**E)₃**
**formula (IV):** **M(III)(E**∩**E)₃(L)_{z}**
**formula (V):** **M(II)(E**∩**E)₂(L)_{z}**
**formula (VI):** **M(III)(E**∩**E)₃(N**∩**N)(L)_{z}**
in which:
(N∩N) is a bidentate ligand which coordinates to the metal via two nitrogen atoms;
M(III) is a trivalent lanthanoid cation, for example Ce(III), Pr(III), Nd(III), Pm(III), Sm(III), Eu(III), Gd(III), Tb(III), Dy(III), Ho(III), Er(III), Tm(III), Yb(III), Lu(III),
M(II) is a divalent lanthanoid cation, for example Sm(II), Eu(II), Tm(II) or Yb(II),
(E∩E) is a ligand of the formula (I), in particular of the formula (Ic),
L is a mono- or polydentate ligand.

10. Organic electronic device according to Claim 9, **characterised in that** the ligand (N∩N) stands for a ligand of the following structure: 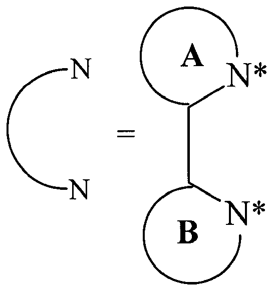 in which the groups A and B represent five- or six-atom rings or are open-chain; the groups A and B here are preferably selected from the groups depicted below: 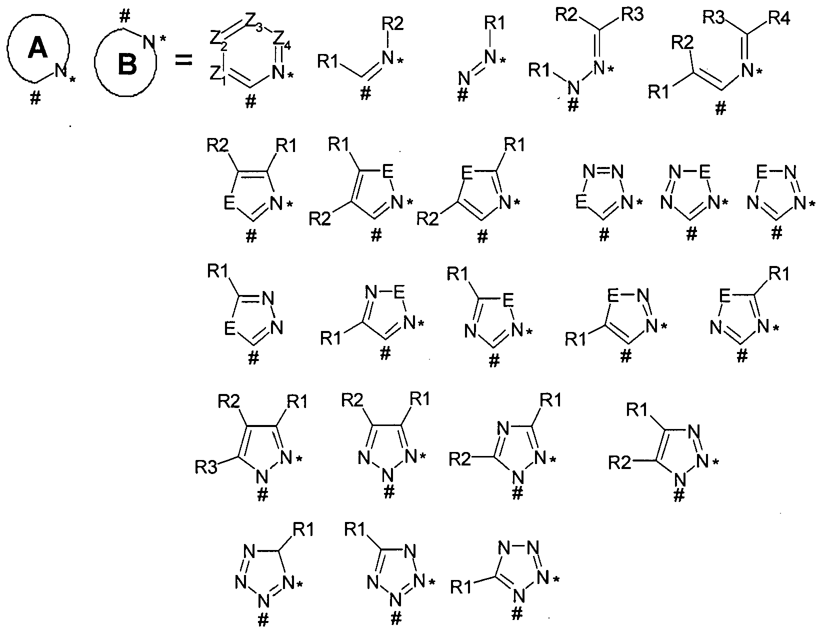 in which R has the meaning given in Claim 1, R1 to R4 have the same meaning as R, E stands for O, S or NR, and Z₁ to Z₄ stand, identically or differently on each occurrence, for CR or N; * denotes the atom which bonds to the complex, and # denotes the atom which bonds to the second unit.

11. Organic electroluminescent device according to one or more of Claims 1 to 10, comprising cathode, anode and at least one emitting layer and in addition optionally comprising further layers selected from one or more hole-injection layers, hole-transport layers, hole-blocking layers, electron-transport layers, electron-injection layers, exciton-blocking layers, charge-generation layers and/or organic or inorganic p/n junctions.

12. Organic electroluminescent device according to one or more of Claims 1 to 11, **characterised in that** the metal complex containing a ligand of the formula (I) or the metal complex of the formula (II) is employed as emitting compound in an emitting layer, either as the pure substance or in combination with a matrix material.

13. Organic electroluminescent device according to Claim 12, **characterised in that** the matrix material is selected from CBP (N,N-biscarba-zolylbiphenyl), carbazole derivatives, PVK (polyvinylcarbazole), azacarbazoles, ketones, phosphine oxides, sulfoxides, sulfones, oligophenylenes, aromatic amines, bipolar matrix materials, silanes, azaboroles or boronic esters.

14. Metal complex of the formula (II)
**formula (II):** **M(E∩E)ₓ(A∩Aⁿ⁻)_{y}(L)_{z}**
in which:
M is a metal, preferably a transition metal, in particular selected from W, Re, Os, Ir, Pt, Ru, Rh or Cu, or a lanthanide,
(E∩E) is a compound of the formula (I) and is as defined in Claim 1 or 2,
(A∩Aⁿ⁻) is a bi- or polydentate ligand, which preferably has at least one metal-carbon bond to the metal,
L is a mono- or polydentate ligand,
x is 1, 2 or 3, preferably 1 or 2,
y is 1, 2 or 3, preferably 1 or 2,
z is 0, 1, 2 or 3,
n is 0, 1 or 2.

15. Metal complex of the formula (III), (IV), (V) or (VI),
**formula (III):** **M(III)(E∩E)₃**
**formula (IV):** **M(III)(E∩E)₃(L)_{z}**
**formula (V):** **M(II)(E∩E)₂(L)_{z}**
**formula (VI):** **M(III)(E∩E)₃(N∩N)(L)_{z}**
in which:
(N∩N) is a bidentate ligand which coordinates to the metal via two nitrogen atoms;
M(III) is a trivalent lanthanoid cation, for example Ce(III), Pr(III), Nd(III), Pm(III), Sm(III), Eu(III), Gd(III), Tb(III), Dy(III), Ho(III), Er(III), Tm(III), Yb(III), Lu(III),
M(II) is a divalent lanthanoid cation, for example Sm(II), Eu(II), Tm(II) or Yb(II),
(E∩E) is a ligand of the formula (I), in particular of the formula (Ic), according to Claim 1 or 2,
L is a mono- or polydentate ligand,
z is 0, 1, 2 or 3.

## Revendications

1. Dispositif électronique organique
comprenant une anode, une cathode et au moins une couche, laquelle comprend au moins un composé organique choisi parmi des dispositifs électroluminescents organiques (= diodes émettrices de lumière organiques, OLED, PLED), des circuits intégrés organiques (O-IC), des transistors à effet de champ organiques (O-FET), des transistors à film mince organiques (O-TFT), des transistors à émission de lumière organiques (O-LET), des cellules solaires organiques (O-SC), des détecteurs optiques organiques, des photorécepteurs organiques, des dispositifs à extinction de champ organiques (O-FQD), des cellules électrochimiques à émission de lumière (LEC), des diodes laser organiques (O-laser) ou des capteurs OLED (des capteurs à gaz et à vapeur qui ne sont pas hermétiquement scellés vis-à-vis de l'extérieur)
comprenant au moins un complexe métallique, **caractérisé en ce que** le complexe métallique contient au moins un ligand de la formule (I),
**formule (1):** **[7,8-(ER₂)₂-7,8-C₂B₉(R¹)₁₀]**
dans laquelle :
E est, de manière identique ou différente pour chaque occurrence, P, As, Sb, N ou un groupe P=O, P=S, As=O ou As=S ;
R est, de manière identique ou différente pour chaque occurrence, H, deutérium, F, CI, Br, I, N(R²)₂, un groupe alkyle, alcoxy ou thioalcoxy en chaîne droite comportant de 1 à 40 atomes de C ou un groupe alkyle, alcoxy ou thioalcoxy ramifié ou cyclique comportant de 3 à 40 atomes de C, dont chacun peut être substitué par un ou plusieurs radicaux R², où un ou plusieurs groupes CH₂ non adjacents peut/peuvent être remplacé(s) par R²C=CR², C=C, Si(R²)₂, Ge(R²)₂, Sn(R²)₂, C=O, C=S, C=Se, C=NR², P(=O)(R²), SO, SO₂, NR², O, S ou CONR² et où un ou plusieurs atomes de H peut/peuvent être remplacé(s) par F, CI, Br, I, CN ou NO₂, ou un système de cycle aromatique ou hétéroaromatique comportant de 5 à 60 atomes de cycle aromatique, lesquels peuvent dans chaque cas être substitués par un ou plusieurs radicaux R², ou un groupe aryloxy ou hétéro-aryloxy comportant de 5 à 60 atomes de cycle aromatique, lesquels peuvent être substitués par un ou plusieurs radicaux R², ou une combinaison de ces systèmes ; deux de ces substituants R ou plus peuvent ici également former un système de cycle aliphatique, aromatique et/ou benzo-fusionné mono- ou polycyclique, les uns avec les autres ;
R¹ est, de manière identique ou différente pour chaque occurrence, H, OH ou un groupe C₁-C₃₀-alcoxy ;
R² est, pour chaque occurrence, de manière identique ou différente, H, F ou un radial hydrocarbone aliphatique, aromatique et/ou hétéroaromatique comportant de 1 à 20 atomes de C, où, en outre, un ou plusieurs atomes de H peut/peuvent être remplacé(s) par F ; deux substituants R² ou plus peuvent ici également former un système de cycle aliphatique, aromatique et/ou benzo-fusionné mono- ou polycyclique, les uns avec les autres.

2. Dispositif électronique organique selon la revendication 1, **caractérisé en ce que** le ligand de la formule (I) est choisi parmi les trois groupes de ligands qui suivent:
Groupe 1 : des ligands pour lesquels les deux symboles E représentent P, As, Sb ou N :
**formule (Ia):** [7,8-(PR₂)₂-7,8-C₂B₉H₁₀]
**formule (Ia'):** [7,8-(AsR₂)₂-7,8-C₂B₉H₁₀]
**formule (Ia"):** [7,8-(SbR₂)₂-7,8-C₂B₉H₁₀]
**formule (Ia"'):** [7,8-(NR₂)₂-7,8-C₂B₉H₁₀]
et des ligands correspondants pour lesquels les deux symboles E sont différents et sont choisis parmi P, As, Sb et N
Groupe 2 : des ligands pour lesquels un symbole E représente un groupe P=O, P=S, As=O ou As=S et l'autre symbole E est choisi parmi P, As, Sb ou N :
**formule (Ib) :** [7-(O=PR₂)-8-(ER₂)-7,8-C₂B₉H₁₀]
**formule (Ib') :** [7-(S=PR₂)-8-(ER₂)-7,8-C₂B₉H₁₀]
et
**formule (Ib") :** [7-(O=AsR₂)-8-(ER₂)-7,8-C₂B₉H₁₀]
**formule (Ib"') :** [7-(S=AsR₂)-8-(ER₂)-7,8-C₂B₉H₁₀]
Groupe 3 : des ligands pour lesquels les deux symboles E représentent un groupe P=O, P=S, As=O ou As=S :
**formule (Ic) :** [7,8-(O=PR₂)₂-7,8-C₂B₉H₁₀]
**formule (Ic') :** [7,8-(S=PR₂)₂-7,8-C₂B₉H₁₀]
**formule (Ic") :** [7,8-(O=AsR₂)₂-7,8-C₂B₉H₁₀]
**formule (Ic"') :** [7,8-(S=AsR₂)₂-7,8-C₂B₉H₁₀]
et des ligands correspondants pour lesquels les deux symboles E sont différents et sont choisis parmi P=O, P=S et As=O.

3. Dispositif électronique organique selon la revendication 1 ou 2, **caractérisé en ce que** le complexe métallique est un complexe de la formule (II),
**formule (II) :** **M(E∩E)ₓ(A∩Aⁿ⁻)_{y}(L)_{z}**
dans laquelle :
M est un métal, de préférence un métal de transition, en particulier choisi parmi W, Re, Os, Ir, Pt, Ru, Rh ou Cu, ou un lanthanide,
(E∩E) est un composé de la formule (I) et est comme défini selon la revendication 1 ou 2,
(A∩Aⁿ⁻) est un ligand bi- ou polydenté,
L est un ligand mono- ou polydenté,
x est 1, 2 ou 3,
y est 0, 1, 2 ou 3, en particulier 1, 2 ou 3, et de façon particulièrement préférable, 1 ou 2,
z est 0, 1, 2 ou 3,
n est 0, 1 ou 2.

4. Dispositif électronique organique selon la revendication 3, **caractérisé en ce que** les ligands L sont choisis parmi le monoxyde de carbone, le monoxyde d'azote, les isonitriles, les nitriles, les amines, les imines, les phosphines, les phosphites, les arsines, les stibines, les thioéthers, les hétérocyles contenant de l'azote, l'hydrure, le deutéride, les halogénures F, CI, Br et I, les alkylacétylures, les arylacétylures, le cyanure, le cyanate, l'isocyanate, le thiocyanate, l'isothiocyanate, le nitrate, le nitrite, les alcoolates aliphatiques ou aromatiques, les thioalcoholates aliphatiques ou aromatiques, les amides, les carboxylates, les groupes alkyle, les groupes aryle, O²⁻, S²⁻, les nitrènes, lesquels conduisent à une coordination sous la forme R-N=M, N³⁻, les diamines, les diimines, les hétérocycles contenant deux atomes d'azote, les diphosphines, les 1,3-dicétonates dérivés de 1,3-dicétones, les 3-cétonates dérivés de 3-cétoesters, les carboxylates dérivés d'acides aminocarboxyliques, les salicyliminates dérivés de salicylimines, les dialcoolates dérivés de dialcools, les dithiolates et les borates d'hétérocycles contenant de l'azote.

5. Dispositif électronique organique selon la revendication 3 ou 4, **caractérisé en ce que** (A∩Aⁿ⁻) est lié au métal dans le complexe via au moins un atome de carbone et/ou via au moins un atome d'azote, où l'atome de carbone peut également être un carbène.

6. Dispositif électronique organique selon une ou plusieurs des revendications 3 à 5, **caractérisé en ce que** le ligand (A∩Aⁿ⁻) contient des groupes aromatiques ou hétéroaromatiques qui se coordonnent au métal, où ces groupes aromatiques ou hétéroaromatiques sont des groupes aryle ou hétéroaryle comportant de 5 à 40 atomes de cycle aromatique, lesquels sont identiques ou différents pour chaque occurrence, lesquels peuvent être substitués par un ou plusieurs radicaux R et/ou lesquels peuvent également contenir un atome de donneur exocyclique, de préférence choisi parmi benzène, 2-phénol, 2-thiophénol, naphtalène, anthracène, phénanthrène, pyridine, quinoline, isoquinoline, pyrazine, quinoxaline, pyrimidine, pyridazine, triazine, pyrrole, indole, imidazole, furane, benzofurane, benzimidazole, pyrazole, triazole, oxazole, thiazole, thiophène, benzothiophène, benzoxazole ou benzothiazole, dont chacun peut être substitué par un ou plusieurs radicaux R.

7. Dispositif électronique organique selon une ou plusieurs des revendications 3 à 6, **caractérisé en ce que** les groupes de coordination aromatiques ou hétéroaromatiques dans le ligand (A∩Aⁿ⁻) sont choisis parmi les formules qui suivent, où deux de ces groupes sont liés l'un à l'autre, dans chaque cas à la position représentée par #; dans ces formules, * dans chaque cas représente la position au niveau de laquelle le ligand est lié au métal : 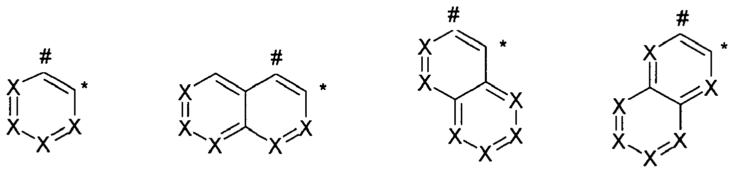 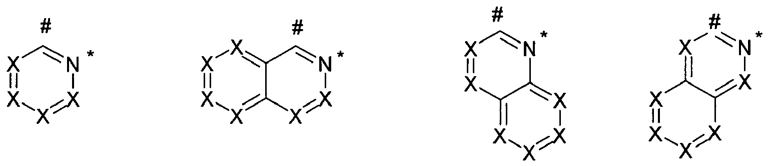 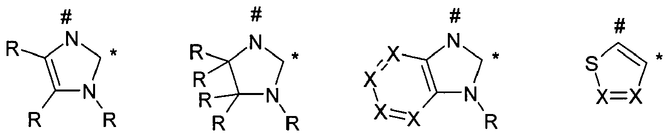 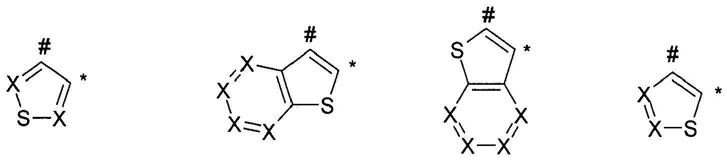 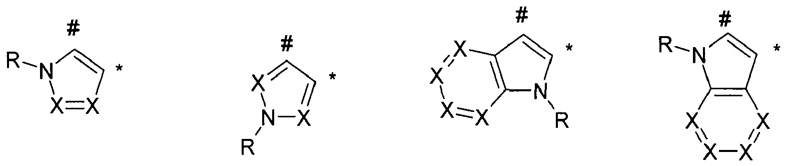 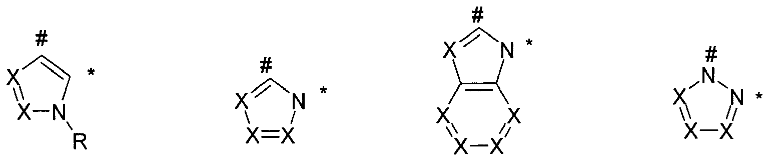 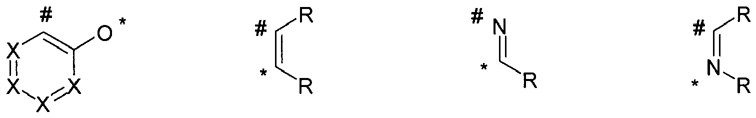 X représente ici, de manière identique ou différente pour chaque occurrence, CR, où R présente la signification donnée selon la revendication 1, ou N, étant entendu qu'un maximum de trois symboles X dans chaque groupe représentent N.

8. Dispositif électronique organique selon une ou plusieurs des revendications 3 à 7, **caractérisé en ce que** les complexes de la formule (II) sont choisis parmi M(E∩E)(A∩Aⁿ⁻)₂, M(E∩E)₂(A∩Aⁿ⁻) ou M(E∩E)(A∩Aⁿ⁻)(L)₂, où M est de préférence Os(II), Ir(III), Ru(II), Re(I), Pt(IV) ou W(0), en particulier Ir(III) ; les complexes de la formule (II) sont de préférence choisis parmi Pt^{II}(E∩E)(A∩A⁻), Ir^{III}(E∩E)₂(A∩A⁻), Ir^{III}(E∩E)(A∩A⁻)₂, Rh^{III}(E∩E)ₙ(A∩A⁻), Rh^{III}(E∩E)(A∩A⁻)₂, Os^{II}(E∩E)(A∩A⁻)L₂ et Ru^{II}(E∩E)(A∩A⁻)L2, où (E∩E) est comme défini selon la revendication 3 et (A∩A⁻) est comme défini selon les revendications 3 et 5 à 7.

9. Dispositif électronique organique selon la revendication 3 ou 4, **caractérisé en ce que** le complexe est choisi parmi des complexes des formules (III), (IV), (V) et (VI),
**formule (III) :** **M(III)(E∩E)₃**
**formule (IV) :** **M(III)(E∩E)₃(L)_{z}**
**formule (V) :** **M(II)(E∩E)₂(L)_{z}**
**formule (VI) :** **M(III)(E∩E)₃(N∩N)(L)_{z}**
dans lesquelles :
(N∩N) est un ligand bidenté qui se coordonne au métal via deux atomes d'azote ;
M(III) est un cation de lanthanoïde trivalent, par exemple Ce(III), Pr(III), Nd(III), Pm(III), Sm(III), Eu(III), Gd(III), Tb(III), Dy(III), Ho(III), Er(III), Tm(III), Yb(III), Lu(III),
M(II) est un cation de lanthanoïde divalent, par exemple Sm(II), Eu(II), Tm(II) ou Yb(II),
(E∩E) est un ligand de la formule (I), en particulier de la formule (Ic),
L est un ligand mono- ou polydenté.

10. Dispositif électronique organique selon la revendication 9, **caractérisé en ce que** le ligand (N∩N) représente un ligand de la structure qui suit : 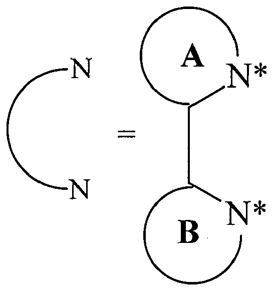 dans laquelle les groupes A et B représentent des cycles à cinq ou six atomes ou sont à chaîne ouverte ; les groupes A et B sont ici de préférence choisis parmi les groupes représentés ci après : 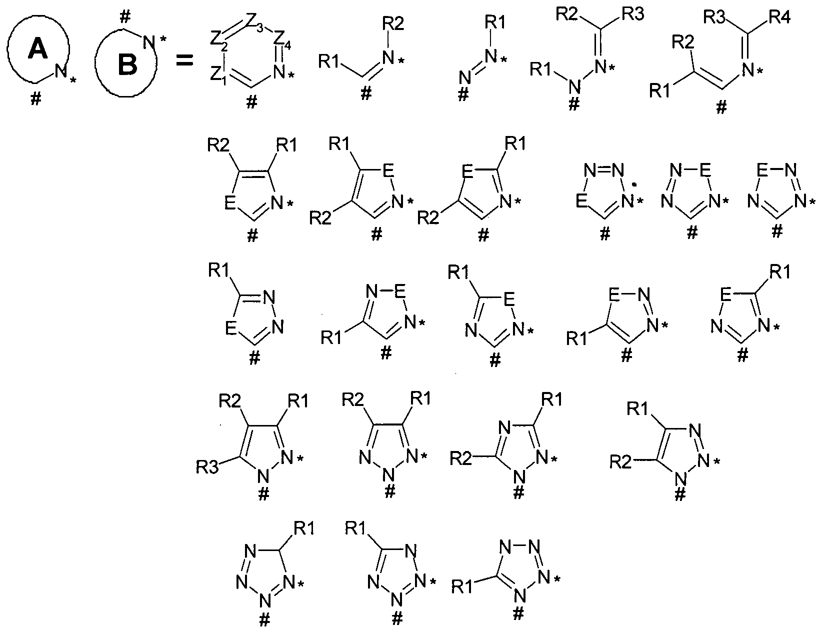 dans lesquels R présente la signification donnée selon la revendication 1, R1 à R4 présentent la même signification que R, E représente O, S ou NR, et Z₁ à Z₄ représentent, de manière identique ou différente pour chaque occurrence, CR ou N ; * représente l'atome qui se lie au complexe, et # représente l'atome qui se lie à la seconde unité.

11. Dispositif électroluminescent organique selon une ou plusieurs des revendications 1 à 10, comprenant une cathode, une anode et au moins une couche d'émission et en outre, en option, comprenant d'autres couches choisies parmi une ou plusieurs couches d'injection de trous, une ou plusieurs couches de transport de trous, une ou plusieurs couches de blocage de trous, une ou plusieurs couches de transport d'électrons, une ou plusieurs couches d'injection d'électrons, une ou plusieurs couches de blocage d'excitons, une ou plusieurs couches de génération de charges et/ou une ou plusieurs jonctions p/n organiques ou inorganiques.

12. Dispositif électroluminescent organique selon une ou plusieurs revendications 1 à 11, **caractérisé en ce que** le complexe métallique contenant un ligand de la formule (I) ou le complexe métallique de la formule (II) est utilisé en tant que composé d'émission dans une couche d'émission, soit en tant que substance pure, soit en combinaison avec un matériau de matrice.

13. Dispositif électroluminescent organique selon la revendication 12, **caractérisé en ce que** le matériau de matrice est choisi parmi CBP (N,N-biscarbazolylbiphényl), des dérivés de carbazole, PVK (polyvinylcarbazole), des azacarbazoles, des cétones, des oxydes de phosphine, des sulfoxydes, des sulfones, des oligophénylènes, des amines aromatiques, des matériaux de matrice bipolaires, des silanes, des azaboroles ou des esters boroniques.

14. Complexe métallique de la formule (II)
**formule (II) :** **M(E∩E)ₓ(A∩Aⁿ⁻)_{y}(L)_{z}**
dans laquelle :
M est un métal, de préférence un métal de transition, en particulier choisi parmi W, Re, Os, Ir, Pt, Ru, Rh ou Cu, ou un lanthanide,
(E∩E) est un composé de la formule (I) et est comme défini selon la revendication 1 ou 2,
(A∩Aⁿ⁻) est un ligand bi- ou polydenté, lequel comporte de façon préférable au moins une liaison métal-carbone sur le métal,
L est un ligand mono- ou polydenté,
x est 1, 2 ou 3, de façon préférable 1 ou 2,
y est 1, 2 ou 3, de façon préférable 1 ou 2,
z est 0, 1, 2 ou 3,
n est 0, 1 ou 2.

15. Complexe métallique de la formule (III), (IV), (V) ou (VI),
**formule (III):** **M(III)(E∩E)₃**
**formule (IV):** **M(III)(E∩E)₃(L)_{z}**
**formule (V) :** **M(II)(E∩E)₂(L)_{z}**
**formule (VI):** **M(III)(E∩E)₃(N∩N)(L)_{z}**
dans lesquelles :
(N∩N) est un ligand bidenté qui se coordonne au métal via deux atomes d'azote ;
M(III) est un cation de lanthanoïde trivalent, par exemple Ce(III), Pr(III), Nd(III), Pm(III), Sm(III), Eu(III), Gd(III), Tb(III), Dy(III), Ho(III), Er(III), Tm(III), Yb(III), Lu(III),
M(II) est un cation de lanthanoïde divalent, par exemple Sm(II), Eu(II), Tm(II) ou Yb(II),
(E∩E) est un ligand de la formule (I), en particulier de la formule (Ic), selon la revendication 1 ou 2,
L est un ligand mono- ou polydenté,
z est 0, 1, 2 ou 3.
